(19) Europäisches Patentamt
European Patent Office
Office européen des brevets

(11) EP 2 750 148 B1

(12) EUROPEAN PATENT SPECIFICATION

(45) Date of publication and mention of the grant of the patent:
**03.06.2020 Bulletin 2020/23**

(21) Application number: **12828321.5**

(22) Date of filing: **24.08.2012**

(51) Int Cl.:
***H01F 17/00*** *(2006.01)* ***H01F 5/00*** *(2006.01)*
***H01F 17/04*** *(2006.01)* ***H05K 1/05*** *(2006.01)*

(86) International application number:
**PCT/JP2012/071427**

(87) International publication number:
**WO 2013/031680 (07.03.2013 Gazette 2013/10)**

(54) **MAGNETIC METAL SUBSTRATE AND INDUCTANCE ELEMENT**

MAGNETISCHES METALLSUBSTRAT UND INDUKTIVITÄTSELEMENT

SUBSTRAT MÉTALLIQUE MAGNÉTIQUE ET ÉLÉMENT D'INDUCTANCE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.08.2011 JP 2011184238**
**02.08.2012 JP 2012171877**

(43) Date of publication of application:
**02.07.2014 Bulletin 2014/27**

(73) Proprietor: **Rohm Co., Ltd.**
**Kyoto-shi, Kyoto 615-8585 (JP)**

(72) Inventors:
- **TSURUMI, Naoaki**
**Kyoto-shi, Kyoto 615-8585 (JP)**
- **FUKAE, Keisuke**
**Kyoto-shi, Kyoto 615-8585 (JP)**

(74) Representative: **Isarpatent**
**Patent- und Rechtsanwälte Behnisch Barth Charles**
**Hassa Peckmann & Partner mbB**
**Friedrichstrasse 31**
**80801 München (DE)**

(56) References cited:

| | |
|---|---|
| **EP-A1- 0 310 396** | **EP-A1- 1 816 658** |
| **EP-A1- 1 942 574** | **DE-A1- 19 857 849** |
| **JP-A- H0 935 937** | **JP-A- 2004 014 837** |
| **JP-A- 2005 150 168** | **JP-A- 2008 205 353** |
| **JP-A- 2009 049 335** | **JP-A- 2009 049 335** |
| **JP-A- 2010 114 302** | **US-A1- 2003 076 211** |

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

## TECHNICAL FIELD

The present invention relates to a magnetic metal substrate and an inductance device, and relates to in particular a magnetic metal substrate having wiring structure inside thereof, and an inductance device to which such a magnetic metal substrate is applied.

## BACKGROUND ART

Thickness reduction, weight saving, energy saving, and long-life batteries have been required for mobile devices in recent years. For the purpose, thickness reduction, weight saving, energy saving, and long-life batteries are required for in particular power supply circuits. Inductance devices have the largest size among components composing power supply circuits.

There are wire-wound type, laminated type, and thin film type wiring structures among wiring structures used for conventional inductance devices. The wire-wound type wiring structure is a wiring structure in which a copper wire is wound around a ferromagnetic material core, and there are toroidal, solenoid, etc. depending on the shape thereof (e.g., refer to Patent Literature 1.). The laminated type wiring structure is a wiring structure in which sheeted ferrimagnetic oxides (e.g. ferrite etc.) are integrated by printing, laminating, and then sintering pastes of Ag etc. (e.g., refer to Patent Literature 2.). The laminated type wiring structure has coiled wiring inside a sintered body. The thin film type wiring structure is formed by utilizing technologies, e.g. sputtering, plating, and photolithography. The thin film type wiring structure is a wiring structure formed of a ferromagnetic thin film, spiral copper wiring, etc. (e.g., refer to Patent Literatures 3 and 4.).

**Patent Literature 1:** Japanese Patent Application Laying-Open Publication No. 2004-172396

**Patent Literature 2:** Japanese Patent Application Laying-Open Publication No. 2007-214424

**Patent Literature 3:** Japanese Patent Application Laying-Open Publication No. H09-139313

**Patent Literature 4:** Japanese Patent Application Laying-Open Publication No. H08-88119

Patent Literature 5: JP 2009 049335 A

Patent Literature 6: DE 198 57 849 A1

Patent Literature 7: EP 1 816 658 A1

Patent Literature 8: EP 1 942 574 A1

Patent Literature 9: US 2003/076211 A1

Patent Literature 10: EP 0 310 396 A1

Patent Literature 11: JP 2008 205353 A

Patent Literature 12: JP 2005 150168 A

## SUMMARY OF INVENTION

### Technical Problem

Although the wire-wound inductance device can obtain larger inductance values thereby achieving large current use, it is difficult to achieve miniaturization and thickness reduction since the size of the inductance device becomes larger.

The laminated inductance device is advantageous in respect of various characteristics, e.g. size of the inductance device, inductance values, large current use, and high frequency characteristics. However, cracks easily occur in ceramics since the laminated inductance device is formed of ceramics, and therefore there is a limit to the thickness reduction.

The thin-film inductance device can be formed extremely thinly, thereby on-chip structure can be applied on Large Scale Integration (LSI) circuits, and it is excellent also in high frequency characteristics. However, it is difficult to achieve the large current use since the inductance value is smaller, and mounting area becomes relatively larger.

Although, in the conventional ceramics-based inductance device, wirings for inductances can be disposed therein, the wirings for inductances are mainly formed not in the magnetic material but on the magnetic material when using metal-based ferromagnetic material.

It is desired to form the inductance devices more thinly to reduce the size of mounting area. It is desired ideally to develop small and thin power inductance devices adaptable to on chip or one-chip structure to be built in LSI, and adaptable to large L values and large current.

The object of the present invention is to provide a thin magnetic metal substrate adaptable to the large current use and advantageous in the high frequency characteristics; and an inductance device to which such a magnetic metal substrate are applied, wherein the inductance device is adaptable to smaller mounting area, larger inductance values, and large current use and advantageous in high frequency characteristics.

## Solution to Problem

According to one aspect of the present invention, there is provided a magnetic metal substrate comprising: a metallic substrate having first permeability; a first insulating layer disposed in the metallic substrate; and a first metallic wiring layer having second permeability, the first metallic wiring layer disposed on the first insulating layer.

According to another aspect of the present invention, there is provided an inductance device comprising: a magnetic metal substrate comprising a metallic substrate having first permeability, a first insulating layer disposed in the metallic substrate, and a first metallic wiring layer having second permeability, the first metallic wiring layer disposed on the first insulating layer; a first gap layer having third permeability, the first gap layer disposed on the magnetic metal substrate; and a magnetic flux generation layer having fourth permeability, the magnetic flux generation layer disposed on the first gap layer.

## Advantageous Effects of Invention

According to the present invention, there can be provided a thin magnetic metal substrate adaptable to the large current use and advantageous in the high frequency characteristics; and an inductance device to which such a magnetic metal substrate are applied, wherein the inductance device is adaptable to smaller mounting area, larger inductance values, and large current use and advantageous in high frequency characteristics.

## BRIEF DESCRIPTION OF THE DRAWINGS

[Fig. 1] (a) A schematic planar pattern configuration diagram of a magnetic metal substrate according to a first embodiment; (b) a schematic cross-sectional structure diagram taken in the line I-I of Fig. 1(a); and *(c)* another schematic cross-sectional structure diagram taken in the line I-I of Fig. 1(a).

[Fig. 2] (a) a schematic planar pattern configuration diagram of a magnetic metal substrate according to a modified example of the first embodiment; and (b) a schematic cross-sectional structure diagram taken in the line II-II of Fig. 2(a).

[Fig. 3] (a) A schematic planar pattern configuration diagram of a metallic wiring layer disposed on a trench formed on a metallic substrate, in an inductance device to which the magnetic metal substrate according to the first embodiment is applied; (b) a schematic planar pattern configuration diagram of a gap layer 24 disposed on the metallic substrate 10 and the metallic wiring layers 22, 23; and (c) a schematic planar pattern configuration diagram which a magnetic flux generation layer disposed on the gap layer shown in Fig. 3(b).

[Fig. 4] (a) A schematic cross-sectional structure diagram taken in the line III-III of Fig. 3(c); (b) a schematic cross-sectional structure diagram for illustrating an aspect that a back surface electrode is formed on a second metallic wiring layer; and (c) another schematic cross-sectional structure diagram for illustrating an aspect that the back surface electrode is formed on the second metallic wiring layer.

[Fig. 5] (a) A schematic bird's-eye view structure diagram for illustrating operation of an inductance device according to a comparative example; and (b) a schematic bird's-eye view structure diagram for illustrating operation of the inductance device to which the magnetic metal substrate according to the first embodiment is applied.

[Fig. 6] (a) A schematic cross-sectional structure diagram for illustrating an aspect that a magnetic field H is generated around the metallic wiring layer due to a current which conducts through the metallic wiring layer, in the inductance device to which the magnetic metal substrate according to the first embodiment is applied; and (b) a schematic cross-sectional structure diagram for illustrating an aspect that a magnetic flux density B is generated in a magnetic flux generation layer due to an effect of the gap layer and the magnetic flux generation layer, in the inductance device to which the magnetic metal substrate according to the first embodiment is applied.

[Fig. 7] A schematic planar pattern configuration diagram illustrating an aspect that a plurality of the inductance devices to which the magnetic metal substrate according to the first embodiment is applied are formed on a wafer composed of the metallic substrate.

[Fig. 8] An example of frequency characteristics of the inductance device to which the magnetic metal substrate according to the first embodiment is applied.

[Fig. 9] (a) An example of magnetization characteristics of a magnetic flux generation layer in the inductance device to which the magnetic metal substrate according to the first embodiment is applied; (b) an example of frequency characteristics of relative permeability $\mu_r$ of a soft magnetic film applied to the magnetic metal substrate according to the first embodiment; and (c) an example of a cross-sectional SEM photograph of the magnetic flux generation layer in the inductance device to which the magnetic metal substrate according to the first embodiment is applied.

[Fig. 10] (a) A schematic bird's-eye view structure diagram showing an aspect that a trench is formed in the metallic substrate, in the inductance device to which the magnetic metal substrate according to the first embodiment is applied; and (b) a schematic bird's-eye view structure diagram showing an aspect that the metallic wiring layer is formed in the trench.

[Fig. 11] (a) A schematic bird's-eye view structure diagram showing an aspect that a gap layer is formed on the metallic substrate and the metallic wiring layer, in the inductance device to which the magnetic metal substrate according to the first embodiment is applied; and (b) a schematic bird's-eye view structure diagram showing an aspect that a metallic wiring layer 23 is formed on a back side surface of the metallic substrate; and (c) a schematic bird's-eye view structure diagram showing an aspect that a back surface electrode 23a is formed on the back side surface of the metallic substrate.

[Fig. 12] (a) A schematic planar pattern configuration diagram of a circular-shaped trench formed on the metallic substrate, in another inductance device to which the magnetic metal substrate according to the first embodiment is applied; (b) a schematic planar pattern configuration diagram of the metallic wiring layer disposed on the circular-shaped trench shown in Fig. 12(a); (c) a schematic planar pattern configuration diagram of the metallic wiring layer disposed on an octagon-shaped trench formed on the metallic substrate, in still another inductance device to which the magnetic metal substrate according to the first embodiment is applied; and (d) a schematic planar pattern configuration diagram of the metallic wiring layer disposed on two triangular-shaped trenches opposing to each other formed on the metallic substrate, in still another inductance device to which the magnetic metal substrate according to the first embodiment is applied.

[Fig. 13] A constructional example of a power supply circuit which applies as a component the inductance device to which the magnetic metal substrate according to the first embodiment is applied.

[Fig. 14] (a) An example of forming a rectangular-shaped trench; (b) an example of forming a trapezoidal-shaped trench; and (c) an example of forming a triangular-shaped trench, in a schematic cross-sectional structure for illustrating one processing step of a fabrication method of the inductance device to which the magnetic metal substrate according to the first embodiment is applied.

[Fig. 15] A schematic cross-sectional structure diagram for illustrating one processing step of the fabrication method of the inductance device to which the magnetic metal substrate according to the first embodiment is applied (Part 1).

[Fig. 16] A schematic cross-sectional structure diagram for illustrating one processing step of the fabrication method of the inductance device to which the magnetic metal substrate according to the first embodiment is applied (Part 2).

[Fig. 17] A schematic cross-sectional structure diagram for illustrating one processing step of the fabrication method of the inductance device to which the magnetic metal substrate according to the first embodiment is applied (Part 3).

[Fig. 18] (a) A schematic cross-sectional structure diagram for illustrating one processing step of the fabrication method of the inductance device to which the magnetic metal substrate according to the first embodiment is applied (Part 4); and (b) an enlarged drawing of the portion A shown in Fig. 18(a).

[Fig. 19] A schematic cross-sectional structure diagram for illustrating one processing step of the fabrication method of the inductance device to which the magnetic metal substrate according to the first embodiment is applied (Part 5).

[Fig. 20] (a) A schematic cross-sectional structure diagram for illustrating one processing step of the fabrication method of the inductance device to which the magnetic metal substrate according to the first embodiment is applied (Part 6); and (b) a schematic cross-sectional structure diagram for illustrating one processing step of a modified example of the fabrication method of the inductance device to which the magnetic metal substrate according to the first embodiment is applied.

[Fig. 21] A schematic cross-sectional structure diagram for illustrating one processing step of the fabrication method of the inductance device to which the magnetic metal substrate according to the first embodiment is applied (Part 7).

[Fig. 22] A schematic cross-sectional structure diagram for illustrating one processing step of the fabrication method of the inductance device to which the magnetic metal substrate according to the first embodiment is applied (Part 8).
[Fig. 23] A schematic cross-sectional structure diagram for illustrating one processing step of the fabrication method of the inductance device to which the magnetic metal substrate according to the first embodiment is applied (Part 9).
[Fig. 24] A partially enlarged structure diagram of the inductance device formed of the fabrication method of the inductance device to which the magnetic metal substrate according to the first embodiment is applied.
[Fig. 25] (a) A schematic planar pattern configuration diagram of a magnetic metal substrate according to a second embodiment; (b) a schematic cross-sectional structure diagram taken in the line IV-IV of Fig. 25(a); and (c) another schematic cross-sectional structure diagram taken in the line IV-IV of Fig. 25(a).
[Fig. 26] (a) A schematic planar pattern configuration diagram of a magnetic metal substrate according to a modified example of the second embodiment; and (b) a schematic cross-sectional structure diagram taken in the line V-V of Fig. 26(a).
[Fig. 27] A schematic planar pattern configuration diagram showing that slits are formed on the metallic substrate 10 to be filled up with an insulating layer, and the magnetic flux generation layers separated from each other are disposed on the gap layer, in the inductance device to which the magnetic metal substrate according to the second embodiment is applied.
[Fig. 28] (a) A schematic cross-sectional structure diagram taken in the line VI-VI of Fig. 27; and (b) a schematic cross-sectional structure diagram taken in the line VII-VII of Fig. 27.
[Fig. 29] (a) A schematic bird's-eye view structure diagram for illustrating operation of the inductance device to which the magnetic metal substrate according to the second embodiment is applied; and (b) an expanded schematic planar pattern configuration diagram showing an aspect that slits are formed on the metallic substrate 10 and are filled up with the insulating layer.
[Fig. 30] (a) A schematic cross-sectional structure diagram for illustrating an aspect that a magnetic field H is generated around the metallic wiring layer due to a current which conducts through the metallic wiring layer, in the inductance device to which the magnetic metal substrate according to the second embodiment is applied; and (b) a schematic cross-sectional structure diagram for illustrating an aspect that a magnetic flux density B is generated in a magnetic flux generation layer due to an effect of the gap layer and the magnetic flux generation layer, in the inductance device to which the magnetic metal substrate according to the second embodiment is applied.
[Fig. 31] (a) A schematic bird's-eye view for illustrating an aspect that an eddy current is generated on the metallic substrate 10; and (b) a schematic bird's-eye view for illustrating an aspect that the eddy current is generated on the metallic substrate 10 on which the slits are formed.
[Fig. 32] A schematic bird's-eye view configuration diagram of the metallic wiring layer disposed on the trench formed on the metallic substrate on which the slits are formed, in the inductance device to which the magnetic metal substrate according to the second embodiment is applied.
[Fig. 33] (a) A schematic cross-sectional structure diagram taken in the line VIII-VIII of Fig. 32; and (b) a schematic cross-sectional structure diagram taken in the line IX-IX of Fig. 32.
[Fig. 34] (a) A bird's-eye view configuration diagram showing an aspect that the slits are formed on the metallic substrate in a cross shape; (b) a bird's-eye view configuration diagram showing an aspect that the slits are formed on the metallic substrate in a lattice-like shape; (c) a bird's-eye view configuration diagram showing an aspect that the slits are formed on the metallic substrate in a cross shape and a lattice-like shape; and (d) a bird's-eye view configuration diagram showing an aspect that the slits are formed on the metallic substrate in a fine lattice-like shape, in the inductance device to which the magnetic metal substrate according to the second embodiment is applied.
[Fig. 35] A diagram showing a relationship between the number of the slit SL, and an inductance and a value of Q, in the inductance device to which the magnetic metal substrate according to the second embodiment is applied.
[Fig. 36] (a) A simulation result showing a leakage state of the magnetic flux in the case where the number of the slit SL is one; and (b) a simulation result showing a leakage state of the magnetic flux in the case where the number of the slit SL is four.
[Fig. 37](a) A schematic bird's-eye view showing an aspect of an eddy current loop; and (b) a schematic cross-sectional structure diagram taken in the line X-X of Fig. 37(a), in the inductance device to which the magnetic metal substrate according to the first embodiment is applied.
[Fig. 38](a) A schematic bird's-eye view showing an aspect of an eddy current loop; and (b) a schematic cross-sectional structure diagram taken in the line XI-XI of Fig. 38(a), in the inductance device to which the magnetic metal substrate according to the second embodiment is applied.
[Fig. 38](a) A schematic bird's-eye view showing an aspect of an eddy current loop; and (b) a schematic cross-sectional structure diagram taken in the line XII-XII of Fig. 39(a), in the inductance device to which a magnetic metal substrate according to a modified example 2 of the second embodiment is applied.
[Fig. 40]A schematic cross-sectional structure diagram taken in the line XII-XII of structure corresponding to Fig. 39(a), in the inductance device to which a magnetic metal substrate according to a modified example 3 of the second embodiment is applied.

[Fig. 41] A detailed schematic cross-sectional structure diagram of Fig. 40.

[Fig. 42](a) A planar pattern diagram showing a density of current flowing through the metallic substrate; and (b) A schematic bird's-eye view showing an aspect of the current flowing through the metallic substrate corresponding to Fig. 42(a), in a simulation result showing an aspect of the eddy current in the inductance device to which the magnetic metal substrate according to the first embodiment is applied.

[Fig. 43](a) A planar pattern diagram showing a density of current flowing through the metallic substrate; and (b) a schematic bird's-eye view showing an aspect of the current flowing through the metallic substrate corresponding to Fig. 43(a), in a simulation result showing an aspect of the eddy current in the inductance device to which the magnetic metal substrate according to a modified example 3 of the second embodiment is applied.

[Fig. 44] A diagram showing a relationship between the skin depth d and the frequency, in which materials of the metallic substrate are adapted as a parameter.

[Fig. 45] (a) A schematic bird's-eye view in a side of a front side surface; (b) a schematic bird's-eye view in a side of a back side surface; and (c) a schematic cross-sectional structure diagram taken in the line XIII-XIII of Fig. 45(a), in a process of a fabrication method of the inductance device to which the magnetic metal substrate according to the modified example 3 of the second embodiment is applied (Part 1).

[Fig. 46] (a) A schematic bird's-eye view in a side of a front side surface; (b) a schematic bird's-eye view in a side of a back side surface; and (c) a schematic cross-sectional structure diagram taken in the line XIV-XIV of Fig. 46(a), in a process of a fabrication method of the inductance device to which the magnetic metal substrate according to the modified example 3 of the second embodiment is applied (Part 2).

[Fig. 47] (a) A schematic bird's-eye view in a side of a front side surface; (b) a schematic bird's-eye view in a side of a back side surface; and (c) a schematic cross-sectional structure diagram taken in the line XV-XV of Fig. 47(a), in a process of a fabrication method of the inductance device to which the magnetic metal substrate according to the modified example 3 of the second embodiment is applied (Part 3).

[Fig. 48] (a) A schematic bird's-eye view in a side of a front side surface; (b) a schematic bird's-eye view in a side of a back side surface; and (c) a schematic cross-sectional structure diagram taken in the line XVI-XVI of Fig. 48(a), in a process of a fabrication method of the inductance device to which the magnetic metal substrate according to the modified example 3 of the second embodiment is applied (Part 4).

[Fig. 49] (a) A schematic bird's-eye view in a side of a front side surface; (b) a schematic bird's-eye view in a side of a back side surface; and (c) a schematic cross-sectional structure diagram taken in the line XVII-XVII of Fig. 49(a), in a process of a fabrication method of the inductance device to which the magnetic metal substrate according to the modified example 3 of the second embodiment is applied (Part 5).

[Fig. 50] (a) A schematic bird's-eye view in a side of a front side surface; (b) a schematic bird's-eye view in a side of a back side surface; and (c) a schematic cross-sectional structure diagram taken in the line XVIII-XVIII of Fig. 50(a), in a process of a fabrication method of the inductance device to which the magnetic metal substrate according to the modified example 3 of the second embodiment is applied (Part 6).

[Fig. 51] (a) A schematic bird's-eye view in a side of a front side surface; (b) a schematic bird's-eye view in a side of a back side surface; and (c) a schematic cross-sectional structure diagram taken in the line XIX-XIX of Fig. 51(a), in a process of a fabrication method of the inductance device to which the magnetic metal substrate according to the modified example 3 of the second embodiment is applied (Part 7).

[Fig. 52] (a) A schematic bird's-eye view in a side of a front side surface; (b) a schematic bird's-eye view in a side of a back side surface; and (c) a schematic cross-sectional structure diagram taken in the line XX-XX of Fig. 52(a), in a process of a fabrication method of the inductance device to which the magnetic metal substrate according to the modified example 3 of the second embodiment is applied (Part 8).

[Fig. 53] (a) A schematic bird's-eye view in a side of a front side surface; (b) a schematic bird's-eye view in a side of a back side surface; and (c) a schematic cross-sectional structure diagram taken in the line XXI-XXI of Fig. 53(a), in a process of a fabrication method of the inductance device to which the magnetic metal substrate according to the modified example 3 of the second embodiment is applied (Part 9).

## DESCRIPTION OF EMBODIMENTS

There will be described embodiments of the present invention, with reference to the drawings. In the description of the following drawings, the identical or similar reference numeral is attached to the identical or similar part. However, it should be known about that the drawings are schematic and the relation between thickness and the plane size and the ratio of the thickness of each layer differs from an actual thing. Therefore, detailed thickness and size should be determined in consideration of the following explanation. Of course, the part from which the relation and ratio of a mutual size differ also in mutually drawings is included.

Moreover, the embodiments shown hereinafter exemplify the apparatus and method for materializing the technical idea of the present invention; and the embodiments of the present invention does not specify the material, shape, structure, placement, etc. of component parts as the following. The embodiments of the present invention may be changed without departing from the scope of the claims.

## [First Embodiment]

### (Magnetic Metal Substrate)

Fig. 1(a) shows a schematic planar pattern configuration of a magnetic metal substrate according to a first embodiment, Fig. 1(b) shows a schematic cross-sectional structure taken in the I-I of Fig. 1(a), and Fig. 1(c) shows another schematic cross-sectional structure taken in the line I-I of Fig. 1(a).

As shown in Fig. 1, the magnetic metal substrate 2 according to the first embodiment includes: a metallic substrate 10 having first permeability; a first insulating layer 16a disposed on the metallic substrate 10; and a first metallic wiring layer 22 having second permeability and disposed on the first insulating layer 16a.

Moreover, in the magnetic metal substrate 2 according to the first embodiment, the first permeability of the metallic substrate 10 is larger than the second permeability of the first metallic wiring layer 22.

Moreover, the metallic substrate 10 may be formed of magnetic material.

Moreover, as shown in Fig. 1(b), the first metallic wiring layer 22 may be disposed via a first insulating layer 16a in the rectangular-shaped trench formed on a front side surface of the metallic substrate 10.

Moreover, as shown in Fig. 1(c), the first metallic wiring layer 22 may be disposed via the first insulating layer 16a in the U-shaped trench formed on the front side surface of the metallic substrate 10.

Moreover, Fig. 2(a) shows a schematic planar pattern configuration of a magnetic metal substrate according to a modified example of the first embodiment, and Fig. 2(b) shows a schematic cross-sectional structure taken in the II-II of Fig. 2(a).

As shown in Fig. 2, the magnetic metal substrate 2 according to the modified example of the first embodiment further includes: a second insulating layer 16b disposed in a through hole passing through the metallic substrate 10; and a second metallic wiring layer 23 disposed on the second insulating layer 16b and filling up the through hole.

The trench can be formed by wet etching, laser processing, or press processing of the metallic substrate 10.

The through hole can be formed by wet etching, laser processing, or press processing of the metallic substrate 10.

The first metallic wiring layer 22 may be formed into a predetermined thickness on a seed layer 18 (refer to Fig. 18 described below) with an electrolytic plating method formed on the first insulating layer 16a in the trench with a sputtering technique, a vacuum evaporation method, or an electroless plating method.

The second metallic wiring layer 23 may be formed into a predetermined thickness to fill up the through hole with an electrolytic plating method on the seed layer 18 (refer to Fig. 18 described below) formed on the second insulating layer 16b in the through hole with a sputtering technique, a vacuum evaporation method, or an electroless plating method.

The first metallic wiring layer 22 can be formed of Cu, Ag, etc., for example. Similarly, the second metallic wiring layer 23 can also be formed of Cu, Ag, etc., for example.

Fig. 1 shows a configuration of the minimum unit of the magnetic metal substrate 2 according to the first embodiment.

Fig. 1(b) shows a structure in which the first metallic wiring layer 22 is disposed on the first insulating layer 16a, after forming the first insulating layer 16a in the trench formed in a square shape.

Fig. 1(c) shows a structure in which the first metallic wiring layer 22 is disposed on the first insulating layer 16a, after forming the first insulating layer 16a in the trench formed in a U-shape. The cross-sectional structure of the trench may be a trapezoid shape, a triangle shape, or other arbitrary shape.

In the magnetic metal substrate 2 according to the first embodiment and its modified example, the trench/through hole are formed on the metallic substrate which is magnetic material, and then the first metallic wiring layer 22/the second metallic wiring layer 23 are disposed therein.

### (Fabrication Method of Magnetic Metal Substrate)

An example of a fabrication method of the magnetic metal substrate is as follows.

(a) Firstly, a magnetic metal film used as the metallic substrate 10 is washed and then chemically polished. In the present embodiment, PC permalloy (NiFeMoCu) is applicable to such a magnetic metal film, for example. The thickness of the magnetic metal film chemically polished is approximately 80 μm to approximately 100 μm, for example.

(b) Next, the trench/through hole is formed on the metallic substrate 10. The trench/through hole can be formed with wet etching, laser processing, or press processing after resist patterning, for example.

(c) Next, an insulating film is formed on the entire surface of the metallic substrate 10. The silicon oxide film is formed so as to have a thickness of equal to or greater than approximately 1 μm, for example, using the Plasma Chemical Vapor Deposition (PCVD) technology.
(d) Next, the seed layer is formed on the entire surface of the metallic substrate 10. The seed layer can be formed using the Cu sputtering technology, for example.
(e) Next, the entire surface of the metallic substrate 10 on which the seed layer is formed is subjected to pre-plating patterning process with a photoresist.
(f) Next, electrolytic plating is performed on the seed layer of the entire surface of the metallic substrate 10 on which the pre-plating patterning process is applied, in order to form the metallic wiring layers 22, 23 composed of Cu.
(g) Next, the photoresist is removed and the seed layer is removed by etching from the surface from which the photoresist is removed. The wet etching technology or dry etching technology is applicable to the etching for the seed layer, for example. Consequently, the unnecessary Cu is removable.

The magnetic metal substrate 2 according to the first embodiment and its modified example is completed through the above-mentioned processing steps.
According to the magnetic metal substrate according to the first embodiment and its modified example, the thickness of the device can be thinly formed by forming the wiring structure in the metallic substrate which is magnetic material.
According to the magnetic metal substrate according to the first embodiment and its modified example, a relatively large inductance value can be obtained with respect to the arrangement area since the wiring structure in the metallic substrate composed of ferromagnetic metal or alloy.
According to the first embodiment and its modified example, there can be provided the thin magnetic metal substrate adaptable to the large current use and advantageous in the high frequency characteristics.

**(Inductance Device)**

In the inductance device 4 to which the magnetic metal substrate 2 according to the first embodiment is applied, Fig. 3 shows a schematic planar pattern configuration of the metallic wiring layers 22, 23 disposed on the trench formed on the metallic substrate 10, Fig. 3(b) shows a schematic planar pattern configuration of the gap layer 24 disposed on the metallic substrate 10 and the metallic wiring layers 22, 23, and Fig. 3(c) shows a schematic planar pattern configuration of the magnetic flux generation layer 26 disposed on the gap layer 24 shown in Fig. 3(b).
Moreover, Fig. 4(a) shows a schematic cross-sectional structure taken in the line III-III of Fig. 3 (c), Fig. 4(b) shows a schematic cross-sectional structure for illustrating an aspect that a back surface electrode 23a is formed on the second metallic wiring layer 23, and Fig. 4(c) shows another schematic cross-sectional structure for illustrating an aspect that a back surface electrode 23a is formed on the second metallic wiring layer 23.
As shown in Figs. 3 and 4, the inductance device 4 to which the magnetic metal substrate 2 according to the first embodiment is applied includes: the magnetic metal substrate 2 including a metallic substrate 10 having first permeability, a first insulating layer 16a disposed in the metallic substrate 10, and a first metallic wiring layer 22 having second permeability and disposed on the first insulating layer 16a;
a gap layer 24 having third permeability and disposed on the magnetic metal substrate 2; and a magnetic flux generation layer 26 having fourth permeability and disposed on the gap layer 24.
The first permeability of the metallic substrate 10 is larger than the second permeability of the first metallic wiring layer 22 and the third permeability of the gap layer 24. The fourth permeability of the magnetic flux generation layer 26 is larger than the third permeability of the gap layer 24.
Moreover, the metallic substrate 10 and the magnetic flux generation layer 26 may be formed of ferromagnetic material, and the gap layer 24 may be formed of paramagnetic material or diamagnetic material.
Moreover, the metallic substrate 10 and the magnetic flux generation layer 26 may be formed of materials different from each other. For example, a soft magnetic material film advantageous in high frequency characteristics is applied to the magnetic flux generation layer 26, and a magnetic metal film suitable for large current driving is applied to the metallic substrate 10 which operates as a magnetic field generating layer, and thereby roles of both can be shared.
Moreover, the first metallic wiring layer 22 may have a coil shape. In the present embodiment, the coil shape may be a planar pattern of any one of a rectangle shape shown in Fig. 3, or a circular shape, an octagonal shape, or a triangular shape shown in Fig. 12 described below. Furthermore, the coil shape may be a polygonal shape or arbitrary patterns.
Moreover, the metallic substrate 10 may be composed of soft magnetic material having high saturation magnetic flux densities, and the magnetic flux generation layer 26 may be formed of soft magnetic material having high frequency characteristics.
Moreover, the first metallic wiring layer 22 may be disposed via the first insulating layer 16a in the trench formed on the front side surface of the metallic substrate 10, as shown in Figs. 4(a) to 4(c).

Moreover, as shown in Figs. 4(a) to 4(c), the inductance device 4 to which the magnetic metal substrate 2 according to the first embodiment is applied may further include: a second insulating layer 16b disposed in the through hole passing through the metallic substrate 10; and a second metallic wiring layer 23 disposed on the second insulating layer 16b and filling up the through hole. Moreover, as shown in Figs. 4(b) and 4(c), an insulating layer 16 is formed on the back side surface of the metallic substrate 10. The insulating layer 16 can be formed in the same processing step as that of the first insulating layer 16a and the second insulating layer 16b.

Moreover, as shown in Fig. 3, an end of the coil shape of the first metallic wiring layer 22 may be connected to the second metallic wiring layer 23 on the front side surface of the metallic substrate 10.

As shown in Figs. 4(b) and 4(c), the second metallic wiring layer 23 may be terminated with the back surface electrode 23a disposed on the back side surface of the metallic substrate 10. As shown in Fig. 4(b), the back surface electrode 23a may be connected to the second metallic wiring layer 23 on the back side surface of the metallic substrate 10. Alternatively, as shown in Fig. 4(c), the back surface electrode 23a may be connected to the second metallic wiring layer 23 on a surface recessed in a through hole side rather than the back side surface of the metallic substrate 10.

Moreover, the trench 12 can be formed by wet etching, laser processing, or press processing of the metallic substrate 10.

Similarly, the through hole can be formed by wet etching, laser processing, or press processing of the metallic substrate 10.

Moreover, the first metallic wiring layer 22 may be formed into a predetermined thickness on a seed layer 18 (refer to Fig. 18 described below) with an electrolytic plating method formed on the first insulating layer 16a in the trench with a sputtering technique, a vacuum evaporation method, or an electroless plating method.

Moreover, the second metallic wiring layer 23 may be formed into a predetermined thickness to fill up the through hole with an electrolytic plating method, on the seed layer 18 (refer to Fig. 18 described below) formed on the second insulating layer 16b in the through hole with a sputtering technique, a vacuum evaporation method, or an electroless plating method.

In the inductance device 4 to which the magnetic metal substrate according to the first embodiment is applied, the gap layer 24 is formed between the magnetic metal substrate 2 which operate as a magnetic field generating layer and the magnetic flux generation layer 26. The trenches are formed on the metallic substrate 10 and the metallic wiring layers 22, 23 are disposed in the trenches.

In the present embodiment, the principal role of the magnetic flux generation layer 26 is to generate the magnetic flux $\Phi$. The magnetic flux generation layer 26 can be formed of ferromagnetic material. The characteristic of such materials is a point of the soft magnetic material advantageous in high frequency characteristics.

The principal role of the gap layer 24 is a point that the magnetic field H generated on the magnetic metal substrate 2 is concentrated. The gap layer 24 can be formed of paramagnetic material or diamagnetic material. The characteristic of such materials is a point of having thinly thickness equal to or lower than approximately 20 $\mu$m, preferably equal to or lower than 5 $\mu$m, for example.

The principal role of the magnetic metal substrate 2 is to generate the magnetic field H. The metallic substrate 10 is formed of ferromagnetic material. The characteristic of such materials is a point of having larger permeability and larger saturation magnetic flux density.

In the inductance device 4 to which the magnetic metal substrate 2 according to the first embodiment is applied, the larger magnetic field H can be generated for the same current value since the metallic substrate 10 has larger permeability. Accordingly, the inductance value can be increased.

Moreover, the generated magnetic field H is concentrated on the gap layer 24. Accordingly, the effect of noise on the surroundings can be reduced.

Moreover, the magnetic flux generation layer 26 is advantageous in high frequency characteristics, and thereby the inductance device 4 can be operated at high frequency.

Moreover, since the metallic substrate 10 can be formed of materials having large saturation magnetic flux densities, the inductance device 4 can be operated also in the large current.

The inductance device 4 to which the magnetic metal substrate 2 according to the first embodiment is applied is provided with the efficient internal structure using the trench, thereby achieving thickness reduction to be equal to or lower than 500 $\mu$m, preferably to be equal to or lower than 200 $\mu$m, for example.

According to the inductance device 4 to which the magnetic metal substrate 2 according to the first embodiment is applied, there can be achieved the compact and thin inductance adaptable to the large current use and advantageous in the high frequency characteristics.

According to the inductance device 4 to which the magnetic metal substrate 2 according to the first embodiment is applied, there can be achieved the inductance device in which the device area is 2 mm squares, the thickness is equal to or lower than 150 $\mu$m, the current carrying capacity is approximately 300 mA to approximately 600 mA, the operational frequency is several tens of MHz, and the inductance value is approximately 0.2 $\mu$H to approximately 0.4 $\mu$H, for example.

**(Operation of Inductance Device)**

Fig. 5(a) shows a schematic bird's-eye view structure for illustrating operation of the inductance device according to a comparative example, and Fig. 5(b) shows a schematic bird's-eye view structure for illustrating operation of the inductance device to which the magnetic metal substrate according to the first embodiment is applied. Note that although the magnetic flux generation layer 26 is disposed on the gap layer 24, its illustration is omitted in Fig. 5(b) in order to simplify the drawing.

The inductance device according to the comparative example corresponds to the case where the inductance device is an air core, and a vector of the generated magnetic field H and a vector of the magnetic flux density B are in the same direction as shown in Fig. 5(a). On the other hand, according to the inductance device to which the magnetic metal substrate according to the first embodiment is applied, the vector of the generated magnetic field H and the vector of the magnetic flux density B are in different directions due to the effect of the gap layer 24 and the magnetic flux generation layer 26, as shown in Fig. 5(b). The magnetic field H mainly is generated in the Z axial direction, and is concentrated in particular on the gap layer 24. Moreover, the magnetic flux density B is generated in the X-Y direction, and is concentrated in particular on the magnetic flux generation layer 26.

In the inductance device 4 to which the magnetic metal substrate 2 according to the first embodiment is applied, Fig. 6(a) shows a schematic cross-sectional structure illustrating an aspect that the magnetic field H is generated around the metallic wiring layers 22, 23 due to a current which conducts through the metallic wiring layers 22, 23, Fig. 6(b) shows a schematic cross-sectional structure illustrating an aspect that the magnetic flux density B is generated in the magnetic flux generation layer 26 due to the effect of the gap layer 24 and the magnetic flux generation layer 26.

Hereinafter, there will now be an explanation of a reason that the directions of the vectors of the magnetic field H and the magnetic flux density B differs from each other, in the inductance device 4 to which the magnetic metal substrate according to the first embodiment is applied.

The magnetic field H is generated by flowing the current through the metallic wiring layers 22, 23. Such a magnetic field H is an eddy field occurring around the free electric current J. If the magnetic field H is explained with an equation, it is a magnetic field H occurring so that the equation $\nabla \times H = J$ is satisfied. The magnetic flux density B is an area density per unit area of magnetic flux $\Phi$.

On the other hand, if the magnetic field H is applied to magnetic material, magnetization M will be generated. It is necessary to take the magnetic flux density B for the amount of the magnetization M generated in the magnetic material into consideration. Accordingly, the magnetic flux density B is expressed with the equation, the magnetic flux density $B=\mu_0(H+M)$, and practically the magnetic flux density $\mu_0 M$ of the magnetized materials is added to the magnetic flux density $B=\mu_0 H$ in cases where no material exist. In this case, $\mu_0$ is absolute permeability of vacuum.

Generally, the magnetization M is not necessarily in agreement with the direction of the external magnetic field H, and therefore the direction of the magnetic flux density B is determined as a result of the vector synthesis.

In the case of the air-core coil shown in Fig. 5(a), the direction of the magnetic field H and the direction of the magnetic flux density B become the same since the magnetization M does not exist.

On the other hand, according to the inductance device 4 to which the magnetic metal substrate 2 according to the first embodiment is applied, the ferromagnetic material, i.e., the metallic substrate 10 and the magnetic flux generation layer 26, are disposed above and below of the coil composed of the metallic wiring layers 22, 23 from the viewpoint of the configuration. The ferromagnetic material has spontaneous magnetization, and is divided into a magnetic domain, and the whole magnetization M has usually become 0. In the present embodiment, the magnetic domains are divided to each other with an easily movable magnetic domain wall having energy higher than that of the inside of the magnetic domain. If the magnetic field H is applied thereon from the outside at this time, the magnetization M will be generated so as to reduce the potential energy. Due to the amount of contribution by this magnetization M, the direction of the magnetic flux density B is different from the direction of the magnetic field H.

The direction of vector can be examined by solving the primitive equations in the magnetic field analysis introduced from the Maxwell equations. Actually, it can be examined using calculation results, e.g. the finite element method.

The reason that the magnetic field H is concentrated on the gap layer 24 sandwiched with the magnetic metal substrate 2 and the magnetic flux generation layer 26 in the Z-axial direction is as follows.

The magnetic field H is generated by flowing the current through the coil composed of the metallic wiring layers 22, 23. The magnetic field H forms a loop which rotates around the copper wire. In the structure of the inductance device 4 to which the magnetic metal substrate 2 according to the first embodiment is applied, since the ferromagnetic material composed of the metallic substrate 10 and the magnetic flux generation layer 26 is disposed above and below of the gap layer 24, the magnetic resistance of the aforementioned portion becomes extremely lower. On the other hand, although the gap layer 24 portion is composed of the paramagnetic material, the distance therebetween is extremely small, and it is in a state of being connected as the magnetic circuit. At this time, it is an important that the permeability of the gap layer 24 sandwiched with the metallic substrate 10 and the magnetic flux generation layer 26 is remarkably smaller than the permeability of the metallic substrate 10 and the magnetic flux generation layer 26, from the viewpoint of the structure of the inductance device 4 to which the magnetic metal substrate 2 according to the first embodiment is applied.

Since the portion of the gap layer 24 is composed of the paramagnetic material, it can be considered that the equation $B=\mu_r H$ is satisfied. More specifically, it is expressed with the equation of the magnetic field $H=B/\mu_r$, where $\mu_r$ is the permeability of the paramagnetic material composing the gap layer 24.

The magnetic field $H=\Phi/(S\bullet\mu_r)$ is satisfied since it is expressed with the magnetic flux density $B=\Phi/S$, where S is cross-sectional area in the magnetic circuit, and $\Phi$ is the magnetic flux. In this case, since it is supposed that the magnetic flux $\Phi$ is constant and in continuously in the magnetic circuit, and the cross-sectional area is constant in the micro region, the magnetic field H becomes larger in the gap layer 24 having small permeability $\mu_r$.

The reason that the magnetic flux density B is generated in the XY direction, and is concentrated on the magnetic flux generation layer 26 is as follows.

If the magnetic field H acts on the magnetic material, the magnetic charge will be virtually generated on the surface of the magnetic material. Although there is polarity in the magnetic charge and a loop-shaped magnetic field is formed outside, the magnetic field in the opposite direction called a demagnetizing field is formed in the magnetic material. The value of the effective magnetic field in the magnetic material is decreased under the effect of the demagnetizing field.

In the structure of the inductance device 4 to which the magnetic metal substrate 2 according to the first embodiment is applied, the ferromagnetic material having high permeability is adopted as the metallic substrate 10 in which the metallic wiring layers 22, 23 are formed. When viewed from the metallic wiring layers 22, 23, the ferromagnetic material (for example, permalloy) with high permeability is disposed at the lateral side or the lower side of the metallic substrate 10. However, any ferromagnetic material having high permeability does not exist at the upper side thereof. If the current is flowed through the metallic wiring layers 22, 23 in such structure, the magnetic field H will be formed in loop shape at the upper space, as shown in Fig. 6(a), but the magnetic field H is remarkably reduced under the effect of the demagnetizing field in the metallic substrate 10.

At this time, if the magnetic flux generation layer 26 is disposed at the upper part via the gap layer 24, the larger magnetic flux density B will be generated with the magnetic field H in the magnetic material of the magnetic flux generation layer 26 of which the magnetic resistance is lower.

As the permeability of the magnetic flux generation layer 26 becomes higher, the generated magnetic flux becomes also larger, thereby obtaining a large inductance value. More exactly, the magnetic flux density B in the direction same as that of the magnetic field H is generated, and the magnetic flux density B is generated also on the lower metallic substrate 10. However, since contribution of the component of the magnetic flux density B generated on the upper magnetic flux generation layer 26 is larger under the effect of the eddy current, etc., the magnetic flux density B is concentrated on the upper magnetic flux generation layer 26.

**(A Plurality of Inductance Devices Formed on Wafer)**

Fig. 7 shows a schematic planar pattern configuration for illustrating an aspect that a plurality of the inductance devices 4 to which the magnetic metal substrate according to the first embodiment is applied are formed on a wafer composed of the metallic substrate 10. The wafer composed of the metallic substrate 10 can be formed by cutting a magnetic metal film into a wafer form. A semiconductor process and a fabrication process of passive components are applicable to the magnetic metal film cut into the wafer form. For example, in Fig. 7, the size D1×D2 of the inductance device 4 is approximately 1.5 mm × approximately 1.5 mm.

**(Example of Frequency Characteristics)**

Fig. 8 shows an example of frequency characteristics of the inductance value in the inductance device 4 to which the magnetic metal substrate 2 according to the first embodiment is applied. Reduction of the inductance value is controlled also in the high-frequency band of several tens of MHz band, thereby achieving high-frequency operation. Although the illustration is omitted, an example of the inductance value changing rate characteristics for the DC bias current is equal to or lower than 0.5% within the range of 0 to 600 mA in the measurement frequency of 6 MHz, for example.

**(Example of Magnetization Characteristics)**

Fig. 9(a) shows an example of magnetization characteristics of the magnetic flux generation layer 26 in the inductance device 4 to which the magnetic metal substrate 2 according to the first embodiment is applied.

Moreover, Fig. 9(b) shows an example of frequency characteristics of the relative permeability $\mu_r$ in the soft magnetic film applied to the magnetic metal substrate according to the first embodiment.

Moreover, Fig. 9(c) shows an example of a cross-sectional SEM photograph of the magnetic flux generation layer 26 to which the magnetic metal substrate 2 according to the first embodiment is applied. In the present embodiment, the magnetic flux generation layer 26 is disposed via $SiO_2$ film 28 on a silicon (Si) substrate 30, as shown in Fig. 9(c).

The magnetic flux density B in the magnetic flux generation layer 26 indicates hysteresis characteristics with respect to change of the external magnetic field H (A/m), as clearly from Fig. 9(a). CoTaZr is formed in the magnetic flux generation layer 26 as an amorphous based soft magnetic film having excellent frequency characteristics. In the present embodiment, the atomic composition ratios are Co: 92.5%, Ta: 4.6%, and Zr: 2.9%, for example. An amorphous based soft magnetic film having excellent frequency characteristics can be formed in the magnetic flux generation layer 26 by optimizing forming conditions using the sputtering technology.

Regarding the soft magnetic film, the value of the relative permeability $\mu_r$ is equal to or greater than 30 (preferable equal to or greater than 100), and is preferable constant up to high frequency. For example, in consideration of use of a DC-DC converter, the size of the inductance itself and the size of peripheral part products (e.g., capacitor etc.) are easy to become large in low frequency. On the other hand, the switching power loss easy to become large in high frequency. Therefore, for example, it is preferable that the value of relative permeability $\mu_r$ is constant in a frequency range of approximately 1 MHz to approximately 30 MHz.

As shown in Fig. 9(b), an example of the frequency characteristics of relative permeability $\mu_r$ in the soft magnetic film applied to the magnetic metal substrate according to the first embodiment covers a wide frequency range from approximately 100 kHz to approximately 100 MHz, and indicates a high value of approximately 500.

In the inductance device 4 to which the magnetic metal substrate 2 according to the first embodiment is applied, Fig. 10(a) shows a schematic bird's-eye view structure showing an aspect that the trench 12 is formed on the metallic substrate 10, and Fig. 10(b) shows a schematic bird's-eye view structure showing an aspect that the metallic wiring layers 22, 23 are formed in the trench 12.

Furthermore, in the inductance device 4 to which the magnetic metal substrate 2 according to the first embodiment is applied, Fig. 11(a) shows a schematic bird's-eye view structure showing an aspect that the gap layer 24 is formed on the metallic substrate 10 and the metallic wiring layer 22, Fig. 11(b) shows a schematic bird's-eye view structure showing an aspect that the metallic wiring layer 23 is formed on the back side surface of the metallic substrate 10, and Fig. 11(c) shows a schematic bird's-eye view structure showing an aspect that the back surface electrode 23a is formed on the back side surface of the metallic substrate 10. As shown in Figs. 4 (b) and 4(c), the insulating layer 16 is formed on the back side surface of the metallic substrate 10, thereby insulating between the back surface electrode 23a and the metallic substrate 10. The back surface electrode 23a is disposed on the center portion and four corners of the metallic substrate 10, as clearly from Fig. 11(c). Only two back surface electrodes 23a corresponding to the metallic wiring layer 23 shown in Fig. 11(b) among the five back surface electrodes 23a are electrically connected with the metallic wiring layer 23. The remaining three back surface electrodes 23a are disposed on the insulating layer 16, and therefore no electric contact is formed. For example, as shown in Fig. 11(b), electrode extraction from the metallic wiring layers 22, 23 can be achieved from the back surface electrode 23a disposed on the center portion and four corners as shown in Fig. 11(b). Although the illustration of bird's-eye view structure is omitted, the magnetic flux generation layer 26 is formed on the gap layer 24 in the same manner as shown in Figs. 3(c), and 4(a) to 4(c). Moreover, the arrangement pattern of the back surface electrode 23a is not limited to the pattern of the center portion and four corners of the metallic substrate 10, and is appropriately selectable according to the planar arrangement pattern of the metallic wiring layers 22, 23. Moreover, the electrode extraction from the metallic wiring layers 22, 23 is not limited to the extraction from the back side surface of the metallic substrate 10, and can be extracted also from the front side surface of the metallic substrate 10 by forming a pad electrode for electrode extraction on the front side surface of the metallic substrate 10.

Furthermore, in another inductance device 4 to which the magnetic metal substrate according to the first embodiment is applied, Fig. 12(a) shows a schematic planar pattern configuration of a circular-shaped trench 12 formed on the metallic substrate 10, and Fig. 12(b) shows a schematic planar pattern configuration of an aspect that the metallic wiring layers 22, 23 are disposed in the circular-shaped trench 12 shown in Fig. 12(a).

Furthermore, in another inductance device 4 to which the magnetic metal substrate according to the first embodiment is applied, Fig. 12(a) shows a schematic planar pattern configuration of a circular-shaped trench 12 formed on the metallic substrate 10, and Fig. 12(b) shows a schematic planar pattern configuration of an aspect that the metallic wiring layers 22, 23 are disposed in the circular-shaped trench 12 shown in Fig. 12(a). Moreover, Fig. 12(c) shows a schematic planar pattern configuration of the metallic wiring layers 22, 23 disposed in an octagon-shaped trench 12 formed on the metallic substrate 10, in still another inductance device 4 to which the magnetic metal substrate according to the first embodiment is applied. Fig. 12(d) shows a schematic planar pattern configuration of the metallic wiring layers 22, 23 disposed in two triangular-shaped trenches 12 opposing to each other formed on the metallic substrate 10, in still another inductance device 4 to which the magnetic metal substrate according to the first embodiment is applied.

In the inductance device 4 to which the magnetic metal substrate 2 according to the first embodiment is applied, the first metallic wiring layer 22 may have a coil shape in this way, and the coil shape may be any one of a rectangle planar pattern, a circular planar pattern, an octagonal planar pattern, or triangular planar pattern. Furthermore, the coil shape may be a polygonal shape or arbitrary patterns.

**(Application Example to Power Supply Circuit)**

Fig. 13 shows a constructional example of a power supply circuit which applies as a component the inductance device 4 to which the magnetic metal substrate according to the first embodiment is applied. Fig. 13 illustrates an example of a DC-DC step-down (buck) converter.

The DC-DC step-down (buck) converter which applies the inductance device 4 to which the magnetic metal substrate 2 according to the first embodiment is applied includes: a DC input voltage $V_I$; an MOSFET Q; a diode D; a capacitor C; and an inductor L. The inductance device 4 to which the magnetic metal substrate 2 according to the first embodiment is applied is applied to the inductor L. In the DC-DC step-down (buck) converter shown in Fig. 13, an energy accumulated in the inductor L from the DC input voltage $V_I$ can be switched by switching the MOSFET Q, and then DC output voltage $V_O$ stepped down from the DC input voltage $V_I$ can be obtained from both ends of the capacitor C. The application examples of the inductance device 4 to which the magnetic metal substrate 2 according to the first embodiment is applied are not limited to the above-mentioned DC-DC step-down (buck) converter, and can be applied to a DC-DC step-up (boost) converter, a choke coil used for noise reduction, etc.

**(Fabrication Method of Inductance Device)**

In a schematic cross-sectional structure for illustrating one processing step of the fabrication method of the inductance device to which the magnetic metal substrate according to the first embodiment is applied,
examples of forming a rectangular-shaped trench 12, a trapezoidal-shaped trench 12, and a triangular-shaped trench 12 are respectively expressed as shown in Figs. 14(a), 14(b), and 14(c).

Moreover, Figs. 15-24 show schematic cross-sectional structures for illustrating one processing step of the fabrication method of the inductance device to which the magnetic metal substrate according to the first embodiment is applied.

(a) Firstly, a magnetic metal film used as the metallic substrate 10 is washed and then chemically polished. In the present embodiment, PC permalloy (NiFeMoCu) is applicable to such a magnetic metal film, for example. The thickness of the magnetic metal film chemically polished is approximately 80 μm to approximately 100 μm, for example.

(b) Next, as shown in Fig. 15, the trenches 12 having U-shaped structure are formed on the front side surface of the metallic substrate 10. The trenches 12 can be formed with wet etching (using an etchant including phosphoric acid), laser processing, or press processing, after resist patterning, for example.

(c) Next, as shown in Fig. 16, the trench (trench) 14 having U-shaped structure is formed on the back side surface of the metallic substrate 10, and thereby a through hole composed of the trenches 12, 14 is formed. The trench 14 can be formed with wet etching (using an etchant including phosphoric acid), laser processing, or press processing, after resist patterning of the back side surface of the metallic substrate 10, for example.

(d) Next, as shown in Fig. 17, the insulating layer 16 is formed on the entire surface of the metallic substrate 10. The silicon oxide film is formed so as to have a thickness of ranging from approximately 1 to 2 μm, for example, using the PCVD technology.

(e) Next, as shown in Fig. 18, the seed layer 18 is formed on the entire surface of the metallic substrate 10. The Cu sputtering technology is used for forming the seed layer (both surfaces) 18, for example. The seed layer 18 has a layered structure of a Ti barrier layer 17 and a Cu layer 19 in details. The thickness of the Cu layer 19 is approximately 3000 A, for example, and the thickness of the Ti barrier layer 17 is equal to or lower than approximately 500 A, for example.

(f) Next, as shown in Fig. 19, the entire surface of the metallic substrate 10 on which the seed layer is formed is subjected to pre-plating patterning process with a photoresist 20. The width of the trench 12 is from approximately 60 μm to 80 μm, for example, and the depth of the trench 12 is approximately 30 μm, for example. Moreover, the pitch between the trenches 12 is approximately 90 μm, for example.

(g) Next, as shown in Fig. 20(a), electrolytic plating is performed on the seed layer 18 of the entire surface of the metallic substrate 10 on which the pre-plating patterning process is applied, in order to form the metallic wiring layers 22, 23 composed of Cu. The thickness of the metallic wiring layer 22 is approximately 30 μm, for example.

Fig. 20(b) shows schematic cross-sectional structures for illustrating one processing step of a modified example of the fabrication method of the inductance device 4 to which the magnetic metal substrate 2 according to the first embodiment is applied. Fig. 20(b) illustrates an example of cross-sectional structure which applies a thick film resist 21 instead of the photoresist 20 shown in Fig. 19. Other processing steps are the same as that of the above-mentioned fabrication method.

(h) Next, as shown in Fig. 21, the photoresist 20 on the entire surface of the metallic substrate 10 is removed.

(i) Next, as shown in Fig. 22, the seed layer 18 is removed by etching from the front side surface of the metallic substrate 10 from which the photoresist is removed. The dry etching technology is applicable to the etching of the seed layer 18, for example. Consequently, the unnecessary Cu layer 19 and unnecessary Ti barrier layer 17 are removable.

(j) Next, as shown in Fig. 22, the seed layer 18 is removed by etching from the back side surface thereof from which the photoresist is removed. The wet etching technology is applicable to the etching on the back side surface of the seed layer 18, for example. Consequently, the unnecessary Cu layer 19 and the unnecessary Ti barrier layer 17 on the back side surface thereof are removable.

(k) Next, as shown in Fig. 23, the gap layer 24 is formed on the front side surface of the metallic substrate 10. The gap layer 24 can be formed of a silicon nitride film and a silicon oxide film deposited by PCVD technology, or can be formed of a laminated film of a silicon nitride film/silicon oxide film deposited one after another, for example. The thickness of the gap layer 24 is approximately 1 μm, for example.

(1) Next, as shown in Fig. 23, the magnetic flux generation layer 26 is formed on the gap layer 24. The magnetic flux generation layer 26 can be formed of a CoTaZr amorphous film, for example, using the sputtering technology. The thickness of the magnetic flux generation layer 26 is approximately 6 μm, for example.

(m) Next, although the illustration is omitted, a passivation film is formed, and then a pad electrode is formed by the Lift-off process method. A silicon oxide film deposited by the PCVD technology can be used, for example, as the passivation film. An Ag/Ni/Ti laminated metal layer can be used for the pad electrode, for example.

The inductance device 4 to which the magnetic metal substrate 2 according to the first embodiment is applied is completed through the above-mentioned processing steps.

Fig. 24 shows an example of partially enlarged structure of the inductance device. The example shown in Fig. 24 corresponds to the inductance device 4 having the rectangular-shaped trench 12 shown in Fig. 14(a). In Fig. 24, the insulating layer 16, the seed layer 18 composed of the Ti barrier layer 17 and the Cu layer 19, the metallic wiring layer 22, the gap layer 24, and the magnetic flux generation layer 26 are formed one after another, in accordance with the rectangular shape of the trench 12. The fabricating process is the same as that of above-mentioned fabricating method. Moreover, the inductance device 4 having the trapezoidal-shaped or triangular-shaped trench 12 shown in Figs. 14(b) and 14(c) can be similarly formed.

In the structure shown in Figs. 23 and 24, although the height of the front side surface of the metallic wiring layer 22 disposed in the trench 12 is formed at a position higher than the height of the front side surface of the metallic substrate 10, it is not limited to the aforementioned structure. The height of the front side surface of the metallic wiring layer 22 may be approximately the same degree as the height of the front side surface of the metallic substrate 10, may be fully in agreement therewith, or may be formed at a position lower than the height of the front side surface of the metallic substrate 10.

According to the inductance device to which the magnetic metal substrate according to the first embodiment is applied, the larger magnetic field H can be generated for the same current value since the metallic substrate 10 has larger permeability, and thereby the inductance value can be increased.

According to the inductance device to which the magnetic metal substrate according to the first embodiment is applied, the generated magnetic field H is concentrated on the gap layer, thereby reducing the effect of the noise on surroundings.

Moreover, according to the inductance device to which the magnetic metal substrate according to the first embodiment is applied, the magnetic flux generation layer is advantageous in high frequency characteristics, and thereby the inductance device can be operated at high frequency.

Moreover, according to the inductance device to which the magnetic metal substrate according to the first embodiment is applied, since the metallic substrate can be formed of materials having large saturation magnetic flux densities, the inductance device can be operated also in the large current.

According to the inductance device to which the magnetic metal substrate according to the first embodiment is applied, the thickness of the inductance device can be thinly formed by forming wiring structure in the metallic substrate which is a magnetic material.

According to the inductance device to which the magnetic metal substrate according to the first embodiment is applied, the relatively large inductance value can be obtained with respect to the planar arrangement pattern area since the wiring structure in the metallic substrate composed of ferromagnetic metal or alloy.

According to the inductance device to which the magnetic metal substrate according to the first embodiment is applied, since the semiconductor manufacturing process of LSI and the fabrication process of the passive component are applicable on the wafer-shaped metallic substrate, a plurality of the inductance devices can be simultaneously mass-produced, thereby reducing the manufacturing cost.

**[Second Embodiment]**

**(Magnetic Metal Substrate)**

Fig. 25(a) shows a schematic planar pattern configuration of a magnetic metal substrate 2 according to a second embodiment, Fig. 25(b) shows a schematic cross-sectional structure taken in the IV-IV of Fig. 25(a), and Fig. 25(c) shows another schematic cross-sectional structure taken in the line IV-IV of Fig. 25(a).

As shown in Fig. 25, the magnetic metal substrate 2 according to the second embodiment includes: a metallic substrate 10 having first permeability; a first insulating layer 16a disposed in the metallic substrate 10, and a first metallic wiring layer 22 having second permeability and disposed on the first insulating layer 16a.

Moreover, in the magnetic metal substrate 2 according to the second embodiment, the first permeability of the metallic substrate 10 is larger than the second permeability of the first metallic wiring layer 22.

Moreover, the metallic substrate 10 may be formed with magnetic materials.

Moreover, as shown in Fig. 25(b), the first metallic wiring layer 22 may be disposed via a first insulating layer 16a in the rectangular-shaped trench formed on a front side surface of the metallic substrate 10.

Moreover, as shown in Fig. 25(c), the first metallic wiring layer 22 may be disposed via the first insulating layer 16a in the U-shaped trench formed on the front side surface of the metallic substrate 10.

In the magnetic metal substrate 2 according to the second embodiment, as shown in Figs. 25(a) to 25(c), the metallic substrate 10 is thin-layered, thereby reducing the eddy current generated in the metallic substrate 10.

In the magnetic metal substrate 2 according to the second embodiment, as shown in Figs. 25(a) to 25(c), the distance between the back side surface of the metallic substrate 10 and the bottom of the trench is preferable equal to or lower than the skin depth d. The examples shown in Figs. 25(b) and 25(c) show the case where the distance between the back side surface of the metallic substrate 10 and the bottom of the trench is equal to the skin depth d.

The skin depth d is expressed with the following equation (1), where $\rho$ is the electric conductivity, $\mu$ is the permeability, and f is the operational frequency of the metallic substrate 10.

$$d = (\rho/\pi f \mu)^{1/2} \tag{1}$$

The relationship between the skin depth d and the frequency f is shown in Fig. 44 described below with respect to the examples of Cu, CoTaZr, and PC permalloy. For example, at the frequency f=1 MHz, the skin depth d is approximately 3.7 $\mu$m in the example of PC permalloy.

In the magnetic metal substrate 2 according to the second embodiment, as shown in Figs. 25(a) to 25(c), the metallic substrate 10 may be divided into a plurality of regions in order to reduce the eddy current generated in the metallic substrate 10.

As shown in Figs. 25(a) to 25(c), between the metallic substrate 10 divided into the plurality of the regions may be filled up with the insulating separation layer 32. In the present embodiment, the insulating separation layer 32 can be formed of $SiO_2$, SiN, or an $Al_2O_3$, for example.

The duplicated descriptions are omitted since other configurations are the same as that of the magnetic metal substrate 2 according to the first embodiment.

**(Modified Example)**

Fig. 26(a) shows a schematic planar pattern configuration of a magnetic metal substrate 2 according to an modified example of the second embodiment, and Fig. 26(b) shows a schematic cross-sectional structure taken in the V-V of Fig. 25(a).

As shown in Fig. 26, the magnetic metal substrate 2 according to the modified example of the second embodiment further includes: a second insulating layer 16b disposed in a through hole passing through the metallic substrate 10; and a second metallic wiring layer 23 disposed on the second insulating layer 16b and filling up the through hole.

The trench can be formed by wet etching, laser processing, or press processing of the metallic substrate 10.

The through hole can be formed by wet etching, laser processing, or press processing of the metallic substrate 10.

The first metallic wiring layer 22 may be formed into a predetermined thickness with an electrolytic plating method, on the seed layer 18 (refer to Fig. 18 below) formed on the first insulating layer 16a in the trench with a sputtering technique, a vacuum evaporation method, or an electroless plating method.

The second metallic wiring layer 23 may be formed into a predetermined thickness to fill up the through hole with an electrolytic plating method, on the seed layer 18 (refer to Fig. 18 below) formed on the second insulating layer 16b in the through hole with a sputtering technique, a vacuum evaporation method, or an electroless plating method.

The first metallic wiring layer 22 can be formed of Cu, Ag, etc., for example. Similarly, the second metallic wiring layer 23 can also be formed of Cu, Ag, etc., for example.

In the magnetic metal substrate 2 according to the second embodiment, as shown in Figs. 26(a) to 26(c), the metallic substrate 10 is thin-layered, thereby reducing the eddy current generated in the metallic substrate 10.

In the magnetic metal substrate 2 according to the second embodiment, the distance between the back side surface of the metallic substrate 10 and the bottom of the trench is preferable equal to or lower than the skin depth d. The examples shown in Figs. 25(b) and 25(c) show the case where the distance between the back side surface of the metallic substrate 10 and the bottom of the trench is equal to the skin depth d.

In the magnetic metal substrate 2 according to the modified example of the second embodiment, as shown in Figs. 26(a) and 26(b), the metallic substrate 10 may be divided into a plurality of regions in order to reduce the eddy current generated in the metallic substrate 10.

As shown in Figs. 26(a) and 26(b), between the metallic substrate 10 divided into the plurality of the regions may be filled up with the insulating separation layer 32. In the present embodiment, the insulating separation layer 32 can be formed of $SiO_2$, SiN, or an $Al_2O_3$, for example.

The duplicated descriptions are omitted since other configurations are the same as that of the magnetic metal substrate 2 according to the first embodiment.

The duplicated descriptions are omitted since the similar method as the first embodiment can also be applied to the example of the fabrication method of the magnetic metal substrate in the second embodiment.

In the magnetic metal substrate according to the second embodiment, the metallic substrate is thin-layered, thereby reducing the eddy current.

In the magnetic metal substrate according to the second embodiment, the metallic substrate is divided into the plurality of the regions, thereby reducing the eddy current.

According to the magnetic metal substrate according to the second embodiment and its modified example, the thickness of the device can be thinly formed by forming the wiring structure in the metallic substrate which is magnetic materials.

According to the magnetic metal substrate according to the second embodiment and its modified example, a relatively large inductance value can be obtained with respect to the arrangement area since the wiring structure in the metallic substrate composed of ferromagnetic metal or alloy.

According to the second embodiment and its modified example, there can be provided the thin magnetic metal substrate adaptable to the large current use and advantageous in the high frequency characteristics.

**(Inductance Device)**

In the inductance device 4 to which the magnetic metal substrate 2 according to the second embodiment is applied, Fig. 27 shows a schematic planar pattern configuration showing that slits are formed on the metallic substrate 10 to be filled up with first magnetic flux generation layers $26_1$, $26_2$, $26_3$, $26_4$, and the first magnetic flux generation layers $26_1$, $26_2$, $26_3$, $26_4$ separated from each other are disposed on the gap layer 24.

Moreover, Fig. 28(a) shows a schematic cross-sectional structure taken in the line VI-VI of Fig. 27, and Fig. 28(b) shows a schematic cross-sectional structure taken in the VII-VII of Fig. 27.

As shown in Fig. 27 and Fig. 28, the inductance device 4 to which the magnetic metal substrate 2 according to the second embodiment is applied includes: a metallic substrate 10 having first permeability; a first insulating layer 16a disposed in the metallic substrate 10; a first metallic wiring layer 22 having second permeability and disposed on the first insulating layer 16a; a gap layer 24 having third permeability and disposed on the magnetic metal substrate 2; and a magnetic flux generation layer 26 having fourth permeability and disposed on the gap layer 24.

The first permeability of the metallic substrate 10 is larger than the second permeability of the first metallic wiring layer 22 and the third permeability of the gap layer 24. The fourth permeability of the magnetic flux generation layer 26 is larger than the third permeability of the gap layer 24.

Moreover, the metallic substrate 10 and the magnetic flux generation layer 26 may be formed of ferromagnetic materials, and the gap layer 24 may be formed of paramagnetic materials or diamagnetic materials.

Moreover, the metallic substrate 10 and the magnetic flux generation layer 26 may be formed of materials different from each other. For example, a soft magnetic material film advantageous in high frequency characteristics is applied to the magnetic flux generation layer 26, and a magnetic metal film suitable for large current driving is applied to the metallic substrate 10 which operates as a magnetic field generating layer, and thereby roles of both can be shared.

Moreover, the first metallic wiring layer 22 may have a coil shape. In the present embodiment, the coil shape may be a planar pattern of any one of a rectangle shape shown in Fig. 27, or a circular shape, octagonal shape, or triangular shape shown in Fig. 12. Furthermore, the coil shape may be a polygonal shape or arbitrary patterns.

Moreover, the metallic substrate 10 may be composed of soft magnetic materials having high saturation magnetic flux densities, and the magnetic flux generation layer 26 may be formed of soft magnetic materials having high frequency characteristics.

Moreover, the first metallic wiring layer 22 may be disposed via the first insulating layer 16a in the trench formed on the front side surface of the metallic substrate 10, as shown in Figs. 28(a) and 28(b).

As shown in Figs. 28(a) and 28(b), the inductance device 4 to which the magnetic metal substrate 2 according to the second embodiment is applied may further include: a second insulating layer 16b disposed in the through hole passing through the metallic substrate 10; and a second metallic wiring layer 23 disposed on the second insulating layer 16b and filling up the through hole. Moreover, as shown in Figs. 28(a) and 28(b), an insulating layer 16 is formed on the back side surface of the metallic substrate 10. The insulating layer 16 can be formed in the same processing step as that of the first insulating layer 16a and the second insulating layer 16b.

Moreover, the trench 12 can be formed by wet etching, laser processing, or press processing of the metallic substrate 10.

Similarly, the through hole can be formed by wet etching, laser processing, or press processing of the metallic substrate 10.

Moreover, the first metallic wiring layer 22 may be formed into a predetermined thickness on the seed layer 18 (refer to Fig. 18) with the electrolytic plating method formed on the first insulating layer 16a in the trench with the sputtering technique, the vacuum evaporation method, or the electroless plating method.

Moreover, the second metallic wiring layer 23 may be formed into a predetermined thickness to fill up the through hole with an electrolytic plating method, on the seed layer 18 (refer to Fig. 18) formed on the second insulating layer 16b in the through hole with the sputtering technique, the vacuum evaporation method, or the electroless plating method.

**(Eddy Current)**

Impedance Z of a coil having the inductance value L is expressed with the following equation (2), where R is the resistance component, and $X_L$ is the inductive reactance component.

$$Z = R + jX_L \qquad (2)$$

Moreover, the Q factor of the coil having the inductance value L is expressed with the following equation (3).

$$Q = X_L/R \qquad (3)$$

Moreover, the inductive reactance component $X_L$ is expressed with the following equation (4), where $\omega$ is the angular frequency.

$$XL = \omega L = 2\pi fL \qquad (4)$$

Moreover, the resistance component R of the coil having the inductance value L is expressed with the following equation (5).

$$R = R_{DC} + R_{AC} + R_{loop} + R_{eddy} \qquad (5)$$

In this case, $R_{DC}$ expresses the DC resistance component of coil, $R_{AC}$ expresses the AC power resistance component generated by the skin effect and the proximity effect, and the resistance component in coil wiring is expressed with $R_{DC}+R_{AC}$. Moreover, $R_{loop}$ expresses the hysteresis loss of a magnetic material, and $R_{eddy}$ expresses the resistance component due to the eddy current. The resistance component in the core material is expressed with $R_{loop}+R_{eddy}$.

The eddy current is a phenomenon in which a voltage induced by a flux change generates a current.For example, the eddy current is large in the metal since the current is easy to flow therethrough, but the eddy current is small in the ceramics since the resistance value is high.

As clearly from the equation (3), the Q factor can be increased by reducing the resistance component R. In particular, in the inductance device 4 to which the magnetic metal substrate 2 according to the second embodiment is applied, the resistance component $R_{eddy}$ due to the eddy current is reduced, thereby achieving the increase in the Q factor.

In the inductance device 4 to which the magnetic metal substrate 2 according to the second embodiment is applied, as shown in Figs. 28(a) and 28(b), the metallic substrate 10 is thin-layered, thereby reducing the eddy current generated in the metallic substrate 10.

In the inductance device 4 to which the magnetic metal substrate 2 according to the second embodiment is applied, the distance between the back side surface of the metallic substrate 10 and the bottom of the trench is preferable equal to or lower than the skin depth d. The examples shown in Figs. 28(a) and 28(b) show the case where the distance between the back side surface of the metallic substrate 10 and the bottom of the trench is equal to approximately zero.

In the inductance device 4 to which the magnetic metal substrate 2 according to the second embodiment is applied, as shown in Figs. 28(a) and 28(b), the metallic substrate 10 may be divided into a plurality of regions in order to reduce the eddy current generated in the metallic substrate 10.

As shown in Figs. 28(a) and 28(b), between the metallic substrate 10 divided into the plurality of the regions may be filled up with the insulating separation layer 32. In the present embodiment, the insulating separation layer 32 can be formed of $SiO_2$, SiN, or an $Al_2O_3$, for example.

In the inductance device 4 to which the magnetic metal substrate 2 according to the second embodiment is applied, as shown in Figs. 27, 28(a) and 28(b), the first magnetic flux generation layers $26_1$, $26_2$, $26_3$, $26_4$ may be divided into a plurality of regions. The first magnetic flux generation layers $26_1$, $26_2$, $26_3$, $26_4$ are divided into the plurality of the regions, thereby reducing the eddy current generated in the first magnetic flux generation layers 26.

The duplicated descriptions are omitted since other configurations are the same as that of the inductance device 4 to which the magnetic metal substrate 2 according to the second embodiment is applied.

**(Operation of Inductance Device)**

Fig. 29(a) shows a schematic bird's-eye view structure for illustrating operation of the inductance device 4 to which the magnetic metal substrate 2 according to the second embodiment is applied. Fig. 29(b) shows an expanded schematic planar pattern configuration showing an aspect that slits SL1, SL2 are formed on the metallic substrate 10, and are filled up with the insulating separation layer 32. Note that although the first magnetic flux generation layer 26 is disposed on the gap layer 24, its illustration is omitted in Fig. 29(b) in order to simplify the drawing. Moreover, the first magnetic flux generation layer 26 may be formed in one layer, and may be divided into a plurality of regions.

Also in the inductance device 4 to which the magnetic metal substrate 2 according to the second embodiment is applied, as shown in Fig. 29(a), the vector of the generated magnetic field H and the vector of the magnetic flux density B are in different directions due to the effect of the gap layer 24 and the first magnetic flux generation layer 26. The magnetic field H mainly is generated in the Z axial direction, and concentrates in particular on the gap layer 24. Moreover, the magnetic flux density B is generated in the X-Y direction, and is concentrated in particular on the magnetic flux generation layer 26. In the inductance device 4 to which the magnetic metal substrate 2 according to the second embodiment is applied, the first magnetic flux generation layer 26 is divided into the plurality of the regions, thereby reducing the eddy current generated in the first magnetic flux generation layer 26.

In the inductance device 4 to which the magnetic metal substrate 2 according to the second embodiment is applied, Fig. 30(a) shows a schematic cross-sectional structure illustrating an aspect that the magnetic field H is generated around the metallic wiring layer 22 due to the current which conducts through the metallic wiring layers 22, 23, and Fig. 30(b) shows a schematic cross-sectional structure illustrating an aspect that the magnetic flux density B is generated in the magnetic flux generation layer 26 due to the effect of the gap layer 24 and the magnetic flux generation layer 26.

More specifically, in the inductance device 4 to which the magnetic metal substrate 2 according to the second embodiment is applied, since the magnetic metal substrate 2 is thin-layered as shown in Fig. 30(a), the magnetic field H generated above and below of the thin-layered magnetic metal substrate 2 due to the current which conducts through the metallic wiring layers 22, 23. Accordingly, since the gap layers 24 and the magnetic flux generation layers 26 are respectively disposed above and below of the thin-layered magnetic metal substrate 2 as shown in Fig. 30(b), the magnetic flux density B can be confined in the magnetic flux generation layers 26 disposed above and below of the thin-layered magnetic metal substrate 2, and thereby the magnetic flux can be efficiently used.

In the inductance device 4 to which the magnetic metal substrate 2 according to the second embodiment is applied, the metallic substrate 10 is thin-layered, thereby reducing the eddy current generated in the metallic substrate 10.

Furthermore, in the inductance device 4 to which the magnetic metal substrate 2 according to the second embodiment is applied, as shown in Figs. 30(a) and 30(b), the metallic substrate 10 may be divided into a plurality of regions in order to reduce the eddy current generated in the metallic substrate 10.

As shown in Figs. 30(a) and 30(b), between the metallic substrate 10 divided into the plurality of the regions may be filled up with the insulating separation layer 32.

The duplicated descriptions are omitted since other operations are the same as that of the inductance device 4 to which the magnetic metal substrate 2 according to the second embodiment is applied.

Fig. 31(a) shows a schematic bird's-eye view configuration illustrating an aspect that the eddy current is generated on the metallic substrate 10, and Fig. 31(b) shows a schematic bird's-eye view configuration illustrating an aspect that the eddy current generated on the metallic substrate 10 on which a plurality of the slit SL are formed.

In the bulk state where the slits SL are not formed, the eddy current loop $L_{eddy}$ generated on the metallic substrate 10 having the magnetism is formed in large loop shape, as shown in Fig. 31(a). On the other hand, the eddy current loop $L_{eddy}$ generated on the metallic substrate 10 having the magnetism in which a plurality of the slit SL are formed is formed in small loop shape for every small-sized metallic substrate 10 divided into the plurality of the slit SL, as shown in Fig. 31(b).

Fig. 32 shows a schematic bird's-eye view configuration of the metallic wiring layer 22 disposed in the trench formed on the metallic substrate 10 on which the slits SL are formed, in the inductance device 4 to which the magnetic metal substrate 2 according to the second embodiment is applied.

Moreover, Fig. 33(a) shows a schematic cross-sectional structure taken in the line VIII-VIII of Fig. 32, and Fig. 33(b) shows a schematic cross-sectional structure taken in the IX-IX of Fig. 32.

**(Modified Example 1)**

Fig. 32 shows a schematic bird's-eye view configuration of the metallic wiring layer 22 disposed in the trench formed on the metallic substrate 10 on which the slits SL are formed, in the inductance device 4 to which the magnetic metal substrate 2 according to a modified example 1 of the second embodiment is applied.

Moreover, Fig. 33(a) shows a schematic cross-sectional structure taken in the line VIII-VIII of Fig. 32, and Fig. 33(b) shows a schematic cross-sectional structure taken in the IX-IX of Fig. 32.

In the inductance device 4 according to the modified example 1 of the second embodiment, the metallic substrate 2 is divided into a plurality of regions by forming the slit SL at a cross shape on the metallic substrate 2, without the metallic substrate 2 being thin-layered. Furthermore, the slits SL are filled up with the insulating separation layer 32. In the present embodiment, the insulating separation layer 32 can be formed of $SiO_2$, SiN, or an $Al_2O_3$, for example.

In the inductance device 4 to which the magnetic metal substrate 2 according to the modified example 1 of the second embodiment is applied, as shown in Figs. 32, 33(a) and 33(b), the metallic substrate 2 is divided into the plurality of the regions, thereby reducing the eddy current generated in the metallic substrate 10.

In the inductance device 4 to which the magnetic metal substrate 2 according to the modified example 1 of the second embodiment is applied, although particularly the first magnetic flux generation layer 26 is not divided as shown in Figs. 32, 33(a) and 33(b), the first magnetic flux generation layer 26 may be divided into a plurality of regions in the same manner as the second embodiment.

The duplicated descriptions are omitted since other configurations are the same as that of the inductance device 4 according to the second embodiment.

**(Slit Shape)**

In the inductance device 4 to which the magnetic metal substrate 2 according to the second embodiment is applied, Fig. 34(a) shows a bird's-eye view configuration showing the slits SL formed in a cross shape on the metallic substrate 10; Fig. 34(b) shows a bird's-eye view configuration of the slit SL formed in a lattice-like shape on the metallic substrate 10; Fig. 34(c) shows a bird's-eye view configuration of the slit SL in a cross shape and a lattice-like shape on the metallic substrate 10; and Fig. 34(d) shows a bird's-eye view configuration of four slits SL respectively formed in a lattice-like shape on the metallic substrate 10.

Furthermore, Fig. 35 shows a relationship between the number of the slit SL, and the inductance and the value of Q, in the inductance device 4 to which the magnetic metal substrate 2 according to the second embodiment is applied. As shown in Fig. 35, tendency to rise of the Q factor due to the reduction of the eddy current is observed, as the number of the slit SL is increased. On the other hand, as shown in Fig. 35, as the number of the slit SL is increased, tendency to reduction of the inductance value due to the magnetic flux leak.

Fig. 36(a) shows an electromagnetic field simulation result showing a state of the magnetic flux leakage $\Phi_L$ in the case where the number of the slit SL is one, and Fig. 36(b) shows an electromagnetic field simulation result showing a state of the magnetic flux leakage $\Phi_L$ in the case where the number of the slit SL is four. As clearly from the comparison result of Figs. 36(a) and 36(b), the magnetic flux leakage $\Phi_L$ is increased in the case of the number of the slit SL is four. In the present embodiment, the case where the number of the slit SL is one corresponds to the structure in which the metallic substrate 10 is provided with the slit SL in the cross shape, in the actual shape, as shown in Fig. 34(a). Moreover, the case where the number of the slit SL is four corresponds to the structure in which the metallic substrate 10 is provided with the four slits SL respectively formed in the lattice-like, in the actual shape, as shown in Fig. 34(c).

In the constructional example of Fig. 36(a), the inductance is 0.472 $\mu$H, and the Q factor is 4.98, as an example. On the other hand, in the constructional example of Fig. 36(b), the inductance is 0.136 $\mu$H, and the Q factor is 2.57, for example, and therefore reduction of the inductance due to the magnetic flux leak is observed.

**(Modified Example 2)**

- **Aspect of Eddy Current Loop $L_{eddy}$** -

In the inductance device 4 according to the first embodiment, Fig. 37(a) shows a schematic bird's-eye view configuration showing an aspect of the eddy current loop $L_{eddy}$, and Fig. 37(b) shows a schematic cross-sectional structure taken in the line X-X of Fig. 37(a). In the inductance device 4 according to the first embodiment, there is shown an example that the metallic substrate 10 is not divided.

On the other hand, Fig. 38(a) shows a schematic bird's-eye view configuration showing an aspect of the eddy current loop $L_{eddy}$, in thee inductance device 4 according to the second embodiment, and Fig. 38(b) shows a schematic cross-sectional structure taken in the line XI-XI of Fig. 38(a). In the inductance device 4 according to the second embodiment, there is shown an example that the metallic substrate 10 is divided into a cross shape, and between the metallic substrates 10 divided into each other are filled up with the insulating separation layer 32.

Fig. 39(a) shows a schematic bird's-eye view configuration showing an aspect of the eddy current loop $L_{eddy}$, in the inductance device 4 according to the modified example of the second embodiment, and Fig. 39(b) shows a schematic cross-sectional structure taken in the line XII-XII of Fig. 39(a). In the inductance device 4 according to the modified example of the second embodiment, there is shown an example that the metallic substrate 10 is divided into a cross shape and a swirl shape, and between the metallic substrates 10 divided into each other are filled up with the insulating separation layer 32.

In the inductance device 4 according to the modified example 2 of the second embodiment, the degree of division of the metallic substrate 10 is miniaturized as compared with the first embodiment or second embodiment. Accordingly, the micro eddy current loop $L_{eddy}$ is formed on each miniaturized metallic substrate 10, and the magnetic flux $\Phi$ is generated around the metallic wiring layers 22, 23.

**(Modified Example 3)**

In an inductance device 4 according to a modified example 3 of the second embodiment, Fig. 40 shows a schematic cross-sectional structure taken in the line XII-XII of Fig. 39(a), and Fig. 41 shows a detailed schematic cross-sectional structure shown in Fig. 40.

In the inductance device 4 according to the modified example 3 of the second embodiment, as shown in Fig. 40, a gap layer 24S is disposed on the front side surface of the magnetic metal substrate 2, a first magnetic flux generation layer 26S disposed on the gap layer 24S is laminated in two layers (26S1, 26S2) via the gap layer 241. In the present embodiment, the first magnetic flux generation layer 26S may be laminated in further a plurality of the layers via the gap layer 241.

Similarly, in the inductance device 4 according to the modified example 3 of the second embodiment, as shown in Fig. 40, a gap layer 24B is disposed on the back side surface of the magnetic metal substrate 2, and a second magnetic flux generation layer 26B may be disposed on the gap layer 24B. The second magnetic flux generation layer 26B may be laminated in two layers (26B1, 26B2) via the gap layer 241, as shown in Fig. 40. In the present embodiment, the second magnetic flux generation layer 26B may be laminated in further a plurality of the layers via the gap layer 241.

The gap layer 241 may be formed between the first magnetic flux generation layers 26S1, 26S2 laminated in the plurality of the layers.

Similarly, the gap layer 241 may be formed between the second magnetic flux generation layers 26B1, 26B2 laminated in the plurality of the layers.

Moreover, the first permeability of the metallic substrate 10 is larger than the third permeability of the gap layers 24S, 24B, 241. The fourth permeability of the magnetic flux generation layers 26S1, 26S2, 26B1, 26B2 is larger than the third permeability of the gap layers 24S, 24B, 241.

Moreover, the gap layer 241 may be formed of paramagnetic materials or diamagnetic materials.

Furthermore, the first magnetic flux generation layers 26S1, 26S2 may be divided into a plurality of regions in a planar view.

Similarly, the second magnetic flux generation layers 26B1, 26B2 may be divided into a plurality of regions in a planar view.

Moreover, between the first magnetic flux generation layers 26S1, 26S2 divided into the plurality of the regions may fill up with the insulating separation layer 32.

Similarly, between the second magnetic flux generation layers 26B1, 26B2 divided into the plurality of the regions may fill up with the insulating separation layer 32.

In the inductance device 4 according to the modified example 3 of the second embodiment, the degree of division of the metallic substrate 10 is miniaturized as compared with the first embodiment or second embodiment. Accordingly, the micro eddy current loop $L_{eddy}$ is formed on each miniaturized metallic substrate 10, and the magnetic

flux $\Phi$ is generated around the metallic wiring layers 22, 23.

According to the inductance device 4 according to the modified example 3 of the second embodiment, the magnetic flux leakage $\Phi_L$ can be controlled by providing the first magnetic flux generation layer 26S and the second magnetic flux generation layer 26B.

According to the inductance device 4 according to the modified example 3 of the second embodiment, the magnetic flux leakage $\Phi_L$ can be further controlled by composing the first magnetic flux generation layer 26S and the second magnetic flux generation layer 26B as a laminated configuration.

**(Simulation Result Showing Aspect of Eddy Current)**

In a simulation result showing an aspect of the eddy current of the inductance device to which the magnetic metal substrate according to the first embodiment is applied, Fig. 42(a) shows a planar pattern diagram showing the density of current flowing into the metallic substrate 10, and Fig. 42(b) shows a schematic bird's-eye view showing an aspect of the current flowing into the metallic substrate 10 shown in Fig. 42(a).

On the other hand, in a simulation result showing an aspect of the eddy current in the inductance device to which the magnetic metal substrate according to a modified example 3 of the second embodiment is applied, Fig. 43(a) shows a planar pattern diagram showing the density of current flowing into the metallic substrates $10_1$, $10_2$, $10_3$, $10_4$, and Fig. 43(b) shows a schematic bird's-eye view showing an aspect of the current flowing into the metallic substrates $10_1$, $10_2$, $10_3$, $10_4$ shown in Fig. 43(a).

In the example of the device structure of the electromagnetic field simulation result shown in Fig. 42, only one layer of the magnetic flux generation layer 26 is disposed, and the slit SL is not formed on the metallic substrate 10, as shown in particularly Figs. 3 and 4. On the other hand, in the example of the device structure of the electromagnetic field simulation result shown in Fig. 43, the first magnetic flux generation layers 26S1, 26S2 and the second magnetic field generation layers 26B1, 26B2 are provided, and the slits SL divided into the cross shape and swirl shape are disposed on the metallic substrate 10, as shown in particular in Figs. 39(a), 40 and 41. Thus, the metallic substrates $10_1$, $10_2$, $10_3$, $10_4$ are divided, and thereby each resistance value of the divided metallic substrate is increased. As the result, the eddy current is difficult to flow therethrough.

In the example of the device structure which obtained the electromagnetic field simulation result shown in Fig. 42, the inductance is 0.463 $\mu$H, and Q factor is 2.79. On the other hand, in the example of the device structure which obtained the electromagnetic field simulation result shown in Fig. 43, the inductance is 0.461 $\mu$H, Q factor is 10.05, and thereby the Q factor can be increased, controlling reduction of the inductance.

According to the inductance device to which the magnetic metal substrate according to the modified example 3 of the second embodiment is applied, the magnetic flux leak can be controlled by the magnetic flux generation layers 26S1, 26S2, 26B1, 26B2 formed on the back and front surfaces of the metallic substrate 10, and thereby the magnetic flux can be effectively confined in the metallic substrate 10, while controlling generation of the eddy current by forming the slits on the metallic substrate 10.

**(Skin Effect)**

Fig. 44 shows a relationship between the skin depth d and the frequency f adapting the materials of the metallic substrate 10 as a parameter. The skin depth d is expressed with the equation (1), where $\rho$ is the electric conductivity of the metallic substrate 10, $\mu$ is the permeability, and f is the operational frequency. The relationship between the skin depth d and the frequency f is shown in Fig. 44 with respect to the examples of Cu, CoTaZr, and PC permalloy. For example, at the frequency f=1 MHz, the skin depth d is approximately 3.7 $\mu$m in the example of PC permalloy.

**(Fabrication Method)**

A fabrication method of the inductance device 4 according to the modified example 3 of the second embodiment is expressed as shown in Figs. 45-53. Figs. 45(a) to 53(a) show a schematic bird's-eye view configuration in a side of the front side surface thereof. Figs. 45(b) to 53(b) show a schematic bird's-eye view configuration in a side of the back side surface thereof.

Fig. 45(c) shows a schematic cross-sectional structure taken in the line XIII-XIII of Fig. 45(a);

Fig. 45(c) shows a schematic cross-sectional structure taken in the line XIV-XIV of Fig. 46(a); Fig. 47(c) shows a schematic cross-sectional structure taken in the line XV-XV of Fig. 47(a); Fig. 48(c) shows a schematic cross-sectional structure taken in the line XVI-XVI of Fig. 48(a); Fig. 49(c) shows a schematic cross-sectional structure taken in the line XVII-XVII of Fig. 49(a); Fig. 50(c) shows a schematic cross-sectional structure taken in the line XVIII-XVIII of Fig. 50(a); Fig. 51(c) shows a schematic cross-sectional structure taken in the line XIX-XIX of Fig. 51(a); Fig. 52(c) shows a schematic cross-sectional structure taken in the line XX-XX of Fig. 52(a); and Fig. 53(c) shows a schematic cross-sectional structure taken in the line XXI-XXI of Fig. 53(a), respectively

(a) Firstly, a magnetic metal film used as the metallic substrate 10 is washed and then chemically polished. In the present embodiment, PC permalloy (NiFeMoCu) is applicable to such a magnetic metal film, for example. The thickness of the magnetic metal film chemically polished is approximately 80 μm to approximately 100 ¡lm, for example.
(b) Next, as shown in Fig. 45, the trench 12 having rectangle structure is formed on the front side surface of the metallic substrate 10. The trench 12 can be formed with wet etching (using an etchant including phosphoric acid), laser processing, or press processing, after resist patterning, for example.
(c) Next, as shown in Fig. 46, an insulating layer 16a is formed on the entire surface of the metallic substrate 10. The silicon oxide film is formed so as to have a thickness of ranging from approximately 1 to 2 μm, for example, using the PCVD technology.
(d) Next, as shown in Fig. 46, the metallic wiring layer 22 composed of Cu is formed.

The thickness of the metallic wiring layer 22 is approximately 30 μm, for example.

(e) Next, as shown in Fig. 47, the insulating layer 16a in the side of the front side surface is removed by polish and etching.
(f) Next, as shown in Fig. 48, the trench 12 having U-shaped structure is formed in a cross shape in planar view on the front side surface of the metallic substrate 10 except for the metallic wiring layer 22 portion.
(g) Next, as shown in Fig. 49, the back side surface of the metallic substrate 10 is etched back, and thereby the insulating layer 16a is exposed. At this time, the through hole passing through from the front side surface to the back side surface in the metallic substrate 10 is formed in a portion in which the trench 12 having U-shaped structure is formed in the cross shape and the center portion of the metallic substrate 10. The order of the processing step of the above-mentioned fabricating process (f) and the fabricating process (g) may be reversed.
(h) Next, as shown in Fig. 50, the portion in which the trench 12 having U-shaped structure is formed in the cross shape and the center portion of the metallic substrate 10 is filled up with the insulating separation layer 32.
(i) Next, as shown in Fig. 51, the gap layer 24B is formed on the front side surface of the metallic substrate 10, and the gap layer 24S is formed on the back side surface of the metallic substrate 10, after removing the insulating layer 16a disposed on the back side surface of the metallic substrate 10. The gap layers 24B, 24S can be formed of a silicon nitride film deposited by the PCVD technology, or can be formed of a silicon oxide film, or a laminated film composed of a silicon nitride film/silicon oxide film deposited one after another, for example. The thickness of the gap layers 24B, 24S is approximately 1 ¡lm, for example.
(j) Next, as shown in Fig. 51, the magnetic flux generation layer 26S2, the gap layer 241, and the magnetic flux generation layer 26S1 are laminated one after another on the gap layer 24S on the front side surface side of the metallic substrate 10. Similarly, the magnetic flux generation layer 26B2, the gap layer 241, and the magnetic flux generation layer 26B1 are laminated one after another on the gap layer 24B on the back side surface side of the metallic substrate 10. The gap layers 241 can be formed of a silicon nitride film deposited by the PCVD technology, or can be formed of a silicon oxide film, or a laminated film composed of a silicon nitride film/silicon oxide film deposited one after another, for example.

The thickness of the gap layer 241 is approximately 1 μm, for example. The magnetic flux generation layers 26S2, 26S1, 26B2, 26B1 can be formed of a CoTaZr amorphous film, for example, using the sputtering technology. The thickness of the magnetic flux generation layer 26S2, 26S1, 26B2, 26B1 is approximately 6 μm, for example.

(k) Next, as shown in Fig. 52, the slit SL1 is formed in a cross shape on the gap layer 24S, the magnetic flux generation layer 26S2, the gap layer 241, and the magnetic flux generation layer 26S1 on the front side surface side of the metallic substrate 10. the slit SL2 is formed in a cross shape on the gap layer 24, the magnetic flux generation layer 26B2, the gap layer 241, and the magnetic flux generation layer 26B1 on the back side surface side of the metallic substrate 10B, and the slit SLS2 is formed on the center portion and the corner portion.
(1) Next, as shown in Fig. 53, the slits SLS1, SLS2 are filled up with the insulating separation layer 32.
(m) Next, as shown in Fig. 53, the passivation films 16S, 16B are formed on the front side surface side and the back side surface side of the device, and then the back surface electrode 23a is formed by the Lift-off process method. A silicon oxide film deposited by the PCVD technology can be used, for example, as the passivation films 16S, 16B. An Ag/Ni/Ti laminated metal layer can be used for the back surface electrode 23a, for example.

The inductance device 4 according to the modified example 3 of the second embodiment is completed through the above-mentioned processing steps.

In the inductance device to which the magnetic metal substrate according to the second embodiment is applied, the larger magnetic field H can be generated for the same current value since the metallic substrate 10 has larger permeability, and thereby the inductance value can be increased.

According to the inductance device according to the second embodiment, the slit is formed on the metallic substrate, thereby reducing the eddy current, and increasing the Q factor.

According to the inductance device according to the second embodiment, the generated magnetic field H is concentrated on the magnetic metal substrate by disposing the magnetic flux generation layer on the back and front surfaces of the metallic substrate. Accordingly, the Q factor can be increased, controlling the reduction of the inductance value.

According to the inductance device according to the second embodiment, the generated magnetic field H is concentrated on the magnetic metal substrate by disposing the magnetic flux generation layer on the back and front surfaces of the metallic substrate. Accordingly, the effect of noise on the surroundings can be reduced.

According to the inductance device according to the second embodiment, the generation of the eddy current in the magnetic flux generation layer further reduced by disposing the slit and the gap layer on the magnetic flux generation layer, and the inductance with high Q factor can be provided, controlling the reduction of inductance value. Moreover, the Q factor can be increased.

According to second embodiment, there can be provided the inductance with high Q factor to control the reduction of inductance value, by reducing the eddy current, and controlling the magnetic flux leak.

As explained above, according to the present invention, there can be provided the inductance device adaptable to smaller mounting area, larger inductance values, and large current use and advantageous in high frequency characteristics by applying the thin magnetic metal substrate adaptable to the large current use and advantageous in the high frequency characteristics and the above-mentioned magnetic metal substrate.

**(Other Embodiments)**

As explained above, the present invention has been described with the embodiments, as a disclosure including associated description and drawings to be construed as illustrative, not restrictive. This disclosure makes clear a variety of alternative embodiments, working examples, and operational techniques for those skilled in the art.

Such being the case, the present invention covers a variety of embodiments, within the scope of the claims. Therefore, the technical scope of the present invention is determined from the invention specifying items related to the claims reasonable from the above description.

**INDUSTRIAL APPLICABILITY**

The magnetic metal substrate and the inductance device to which such a magnetic metal substrate of the present invention is applied are applicable to: whole electronic components using inductances, e.g. inductors, transformers, noise filters, isolators; sensor parts, e.g. magnetic sensors, position sensors;
other coils used for wireless power delivery; and in particular electronic apparatus, e.g. power inductors for mobile devices, DC-DC converters including such power inductors.

**Reference Signs List**

2: Magnetic metal substrate;
4: Inductance device;
10, $10_1$, $10_2$, $10_3$, $10_4$: Metallic substrate;
12, 14: Trench;
16, 16a, 16b: Insulating layer;
16S, 16B:. Passivation film;
17: Ti barrier layer;
18: Seed layer;
19: Cu layer;
20: Photoresist layer;
21: Thick film resist layer;
22, 23: Metallic wiring layer;
23a: Back surface electrode;
24, 24B, 24S, 241: Gap layer;

26, $26_1$, $26_2$, $26_3$, $26_4$, 26S1, 26S2, 26B1, 26B2: Magnetic flux generation layer;
28: $SiO_2$ film;
30: Silicon (Si) substrate;
32 32b: Insulating separation layer;
d: Skin depth;
f: Frequency;
J: Current;
B: Magnetic flux density;
H: Magnetic field;
D1, D2: Width;
SL1, SL2, SLS1, SLS2: Slit;
$L_{eddy}$: Eddy current loop;
$\Phi_L$: Magnetic flux leakage; and
$\Phi$: Magnetic flux.

## Claims

**1.** A magnetic metal substrate (2) comprising:

a metallic substrate (10) having first permeability;
a trench formed (12, 14) on a front side surface of the metallic substrate;
a first insulating layer (16, 16a) disposed on a surface of the trench; and
a first metallic wiring layer (22, 23) having second permeability, the first metallic wiring layer disposed on the first insulating layer, wherein the first permeability is larger than the second permeability.

**2.** The magnetic metal substrate according to claim 1, wherein the first insulating layer is formed so that surfaces of the first metallic wiring layer except for an upper surface of the first metal wiring layer are enclosed.

**3.** The magnetic metal substrate according to claim 1 further comprising:

a second insulating layer (16, 16b) disposed in a through hole passing through the metallic substrate; and
a second metallic wiring layer disposed on the second insulating layer, the second metallic wiring layer filling up the through hole, wherein
the second insulation layer is formed so that surfaces of the second metallic wiring layer except for top and bottom surfaces of the second metallic wiring layer are enclosed.

**4.** The magnetic metal substrate according to claim 1 or 3, wherein the metallic substrate is thin-layered, thereby reducing an eddy current generated in the metallic substrate.

**5.** The magnetic metal substrate according to claim 4, wherein a distance between a back side surface of the substrate and a bottom of the trench is equal to or lower than a skin depth.

**6.** The magnetic metal substrate according to any one of claims 1-5, wherein the metallic substrate is divided into a plurality of regions.

**7.** An inductance device (4) comprising:

a magnetic metal substrate (2) comprising a metallic substrate (10) having first permeability, a trench formed (12, 14) on a front side surface of the metallic substrate, a first insulating layer (16) disposed on a surface of the trench, and a first metallic wiring layer (22, 23) having second permeability, the first metallic wiring layer disposed on the first insulating layer;
a first gap layer (24) having third permeability, the first gap layer disposed on the front side surface of the magnetic metal substrate and on a surface of the first metallic wiring layer; and
a first magnetic flux generation layer (26) having fourth permeability, the first magnetic flux generation layer disposed on the first gap layer, wherein
each of the metallic substrate and the first magnetic flux generation layer is ferromagnetic material, and the first gap layer is paramagnetic material or diamagnetic material.

**8.** The inductance device according to claim 7 further comprising:

a second gap layer having third permeability, the second gap layer disposed on a back side surface of the magnetic metal substrate; and
a second magnetic flux generation layer having fourth permeability, the second magnetic flux generation layer disposed on the second gap layer.

**9.** The inductance device according to claim 7, wherein the first insulating layer is formed so that surfaces of the first metallic wiring layer except for an upper surface of the first metallic wiring layer are enclosed.

**10.** The inductance device according to claim 7, wherein the metallic substrate and the first magnetic flux generation layer are formed of materials different from each other.

**11.** The inductance device according to claim 7 or 8, wherein the first metallic wiring layer has a coil shape.

**12.** The inductance device according to claim 7, wherein the metallic substrate is composed of soft magnetic material having high saturation magnetic flux density, and the first magnetic flux generation layer is composed of soft magnetic material operatable at high frequency of equal to or larger than 100 kHz.

**13.** The inductance device according to claim 7 or 8 further comprising:

a second insulating layer disposed in a through hole passing through the metallic substrate; and
a second metal wiring layer disposed on the second insulating layer, the second metal wiring layer filling the through hole, wherein
the second insulation layer is formed so that surfaces of the second metallic wiring layer except for top and bottom surfaces of the second metallic wiring layer are enclosed.

**Patentansprüche**

**1.** Magnetisches Metallsubstrat (2), umfassend:

ein metallisches Substrat (10), das eine erste Permeabilität aufweist;
einen Graben (12, 14), der an einer Vorderseitenfläche des metallischen Substrats ausgebildet ist;
eine erste Isolierschicht (16, 16a), die an einer Fläche des Grabens angeordnet ist; und
eine erste metallische Verdrahtungsschicht (22, 23), die eine zweite Permeabilität aufweist, wobei die erste metallische Verdrahtungsschicht auf der ersten Isolierschicht angeordnet ist, wobei die erste Permeabilität größer als die zweite Permeabilität ist.

**2.** Magnetisches Metallsubstrat nach Anspruch 1, wobei die erste Isolierschicht so ausgebildet ist, dass Flächen der ersten metallischen Verdrahtungsschicht, mit Ausnahme einer Oberseite der ersten metallischen Verdrahtungsschicht, umschlossen sind.

**3.** Magnetisches Metallsubstrat nach Anspruch 1, des Weiteren umfassend:

eine zweite Isolierschicht (16, 16b), die in einem Durchgangsloch angeordnet ist, das durch das metallische Substrat verläuft; und
eine zweite metallische Verdrahtungsschicht, die auf der zweiten Isolierschicht angeordnet ist, wobei die zweite metallische Verdrahtungsschicht das Durchgangsloch ausfüllt, wobei
die zweite Isolierschicht so ausgebildet ist, dass Flächen der zweiten metallischen Verdrahtungsschicht, mit Ausnahme der Ober- und der Unterseite der zweiten metallischen Verdrahtungsschicht, umschlossen sind.

**4.** Magnetisches Metallsubstrat nach Anspruch 1 oder 3, wobei das metallische Substrat dünnschichtig ist, wodurch ein in dem metallischen Substrat erzeugter Wirbelstrom reduziert wird.

**5.** Magnetisches Metallsubstrat nach Anspruch 4, wobei eine Distanz zwischen einer Rückseitenfläche des Substrats und einem Boden des Grabens maximal so groß wie eine Hauttiefe ist.

6. Magnetisches Metallsubstrat nach einem der Ansprüche 1-5, wobei das metallische Substrat in mehrere Regionen unterteilt ist.

7. Induktivitätsvorrichtung (4), umfassend:

   ein magnetisches Metallsubstrat (2), umfassend: ein metallisches Substrat (10), das eine erste Permeabilität aufweist, einen Graben (12, 14), der an einer Vorderseitenfläche des metallischen Substrats ausgebildet ist, eine erste Isolierschicht (16), die an einer Fläche des Grabens angeordnet ist, und eine erste metallische Verdrahtungsschicht (22, 23), die eine zweite Permeabilität aufweist, wobei die erste metallische Verdrahtungsschicht auf der ersten Isolierschicht angeordnet ist;
   eine erste Spaltschicht (24), die eine dritte Permeabilität aufweist, wobei die erste Spaltschicht auf der Vorderseitenfläche des magnetischen Metallsubstrats und auf einer Fläche der ersten metallischen Verdrahtungsschicht angeordnet ist; und
   eine erste Magnetflussgenerierungsschicht (26), die eine vierte Permeabilität aufweist, wobei die erste Magnetflussgenerierungsschicht auf der ersten Spaltschicht angeordnet ist, wobei sowohl das metallische Substrat als auch die erste Magnetflussgenerierungsschicht ferromagnetisches Material sind und die erste Spaltschicht paramagnetisches Material oder diamagnetisches Material ist.

8. Induktivitätsvorrichtung nach Anspruch 7, des Weiteren umfassend:

   eine zweite Spaltschicht, die eine dritte Permeabilität aufweist, wobei die zweite Spaltschicht auf einer Rückseitenfläche des magnetischen Metallsubstrats angeordnet ist; und
   eine zweite Magnetflussgenerierungsschicht, die eine vierte Permeabilität aufweist, wobei die zweite Magnetflussgenerierungsschicht auf der zweiten Spaltschicht angeordnet ist.

9. Induktivitätsvorrichtung nach Anspruch 7, wobei die erste Isolierschicht so ausgebildet ist, dass Flächen der ersten metallischen Verdrahtungsschicht, mit Ausnahme einer Oberseite der ersten metallischen Verdrahtungsschicht, umschlossen sind.

10. Induktivitätsvorrichtung nach Anspruch 7, wobei das metallische Substrat und die erste Magnetflussgenerierungsschicht aus voneinander verschiedenen Materialien gebildet sind.

11. Induktivitätsvorrichtung nach Anspruch 7 oder 8, wobei die erste metallische Verdrahtungsschicht eine Spulenform aufweist.

12. Induktivitätsvorrichtung nach Anspruch 7, wobei das metallische Substrat aus weichmagnetischem Material besteht, das eine hohe magnetische Sättigungsflussdichte aufweist, und die erste Magnetflussgenerierungsschicht aus weichmagnetischem Material besteht, das bei einer hohen Frequenz von mindestens 100 kHz betrieben werden kann.

13. Induktivitätsvorrichtung nach Anspruch 7 oder 8, des Weiteren umfassend:

   eine zweite Isolierschicht, die in einem Durchgangsloch angeordnet ist, das durch das metallische Substrat verläuft; und
   eine zweite metallische Verdrahtungsschicht, die auf der zweiten Isolierschicht angeordnet ist, wobei die zweite metallische Verdrahtungsschicht das Durchgangsloch ausfüllt, wobei
   die zweite Isolierschicht so ausgebildet ist, dass Flächen der zweiten metallischen Verdrahtungsschicht, mit Ausnahme der Ober- und der Unterseite der zweiten metallischen Verdrahtungsschicht, umschlossen sind.

**Revendications**

1. Substrat de métal magnétique (2) comprenant :

   un substrat métallique (10) possédant une première perméabilité ;
   une tranchée (12, 14) formée sur une surface latérale avant du substrat métallique ;
   une première couche isolante (16, 16a) disposée sur une surface de la tranchée ; et
   une première couche de câblage métallique (22, 23) possédant une deuxième perméabilité, la première couche de câblage métallique étant disposée sur la première couche isolante, dans lequel la première perméabilité est supérieure à la deuxième perméabilité.

**2.** Substrat de métal magnétique selon la revendication 1, dans lequel la première couche isolante est formée de manière que les surfaces de la première couche de câblage métallique, à l'exception d'une surface supérieure de la première couche de câblage métallique, soient ceintes.

**3.** Substrat de métal magnétique selon la revendication 1 comprenant en outre :
une seconde couche isolante (16, 16b) disposée dans un trou traversant passant à travers le substrat métallique ; et une seconde couche de câblage métallique disposée sur la seconde couche isolante, la seconde couche de câblage métallique comblant le trou traversant, dans lequel :
la seconde couche isolante est formée de manière que les surfaces de la seconde couche de câblage métallique, à l'exception des surfaces supérieure et inférieure de la seconde couche de câblage métallique, soient ceintes.

**4.** Substrat de métal magnétique selon la revendication 1 ou 3, dans lequel le substrat métallique est à couche mince, ce qui permet de réduire un courant de Foucault engendré dans le substrat métallique.

**5.** Substrat de métal magnétique selon la revendication 4, dans lequel une distance entre une surface arrière du substrat et un fond de la tranchée est inférieure ou égale à une profondeur de pénétration.

**6.** Substrat de métal magnétique selon l'une quelconque des revendications 1 à 5, dans lequel le substrat métallique est divisé en une pluralité de régions.

**7.** Dispositif inductif (4) comprenant :

un substrat de métal magnétique (2) comprenant un substrat métallique (10) possédant une première perméabilité, une tranchée (12, 14) formée sur une surface latérale avant du substrat métallique, une première couche isolante (16) disposée sur une surface de la tranchée, et une première couche de câblage métallique (22, 23) possédant une deuxième perméabilité, la première couche de câblage métallique étant disposée sur la première couche isolante ;
une première couche d'entrefer (24) possédant une troisième perméabilité, la première couche d'entrefer étant disposée sur la surface latérale avant du substrat de métal magnétique et sur une surface de la première couche de câblage métallique ; et
une première couche de génération de flux magnétique (26) possédant une quatrième perméabilité, la première couche de génération de flux magnétique étant disposée sur la première couche d'entrefer, dans lequel :
le substrat métallique et la première couche de génération de flux magnétique sont chacun un matériau ferromagnétique, et la première couche d'entrefer est un matériau paramagnétique ou un matériau diamagnétique.

**8.** Dispositif inductif selon la revendication 7 comprenant en outre :

une seconde couche d'entrefer possédant une troisième perméabilité, la seconde couche d'entrefer étant disposée sur une surface arrière du substrat de métal magnétique ; et
une seconde couche de génération de flux magnétique possédant une quatrième perméabilité, la seconde couche de génération de flux magnétique étant disposée sur la seconde couche d'entrefer.

**9.** Dispositif inductif selon la revendication 7, dans lequel la première couche isolante est formée de manière que les surfaces de la première couche de câblage métallique, à l'exception d'une surface supérieure de la première couche de câblage métallique, soient ceintes.

**10.** Dispositif inductif selon la revendication 7, dans lequel le substrat métallique et la première couche de génération de flux magnétique sont constitués de matériaux différents l'un de l'autre.

**11.** Dispositif inductif selon la revendication 7 ou 8, dans lequel la première couche de câblage métallique a une forme de bobine.

**12.** Dispositif inductif selon la revendication 7, dans lequel le substrat métallique est composé d'un matériau magnétique doux ayant une induction magnétique de saturation élevée, et la première couche de génération de flux magnétique est composée d'un matériau magnétique doux utilisable à une haute fréquence, supérieure ou égale à 100 kHz.

**13.** Dispositif inductif selon la revendication 7 ou 8, comprenant en outre :

une seconde couche isolante disposée dans un trou traversant passant à travers le substrat métallique ; et une seconde couche de câblage métallique disposée sur la seconde couche isolante, la seconde couche de câblage métallique comblant le trou traversant, dans lequel : la seconde couche isolante est formée de manière que les surfaces de la seconde couche de câblage métallique, à l'exception des surfaces supérieure et inférieure de la seconde couche de câblage métallique, soient ceintes.

[ 1]

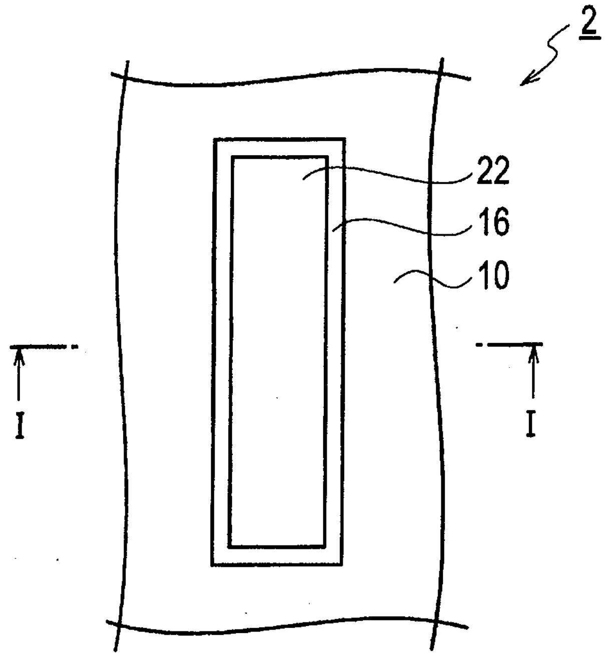


(a)

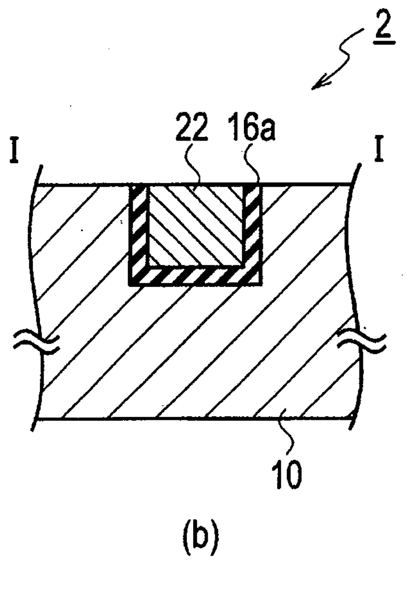


(b)

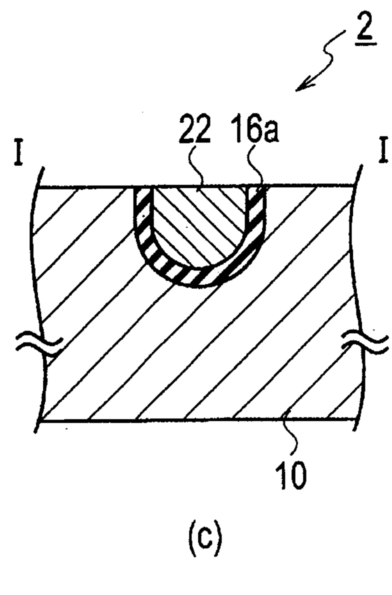


(c)

[ 2]

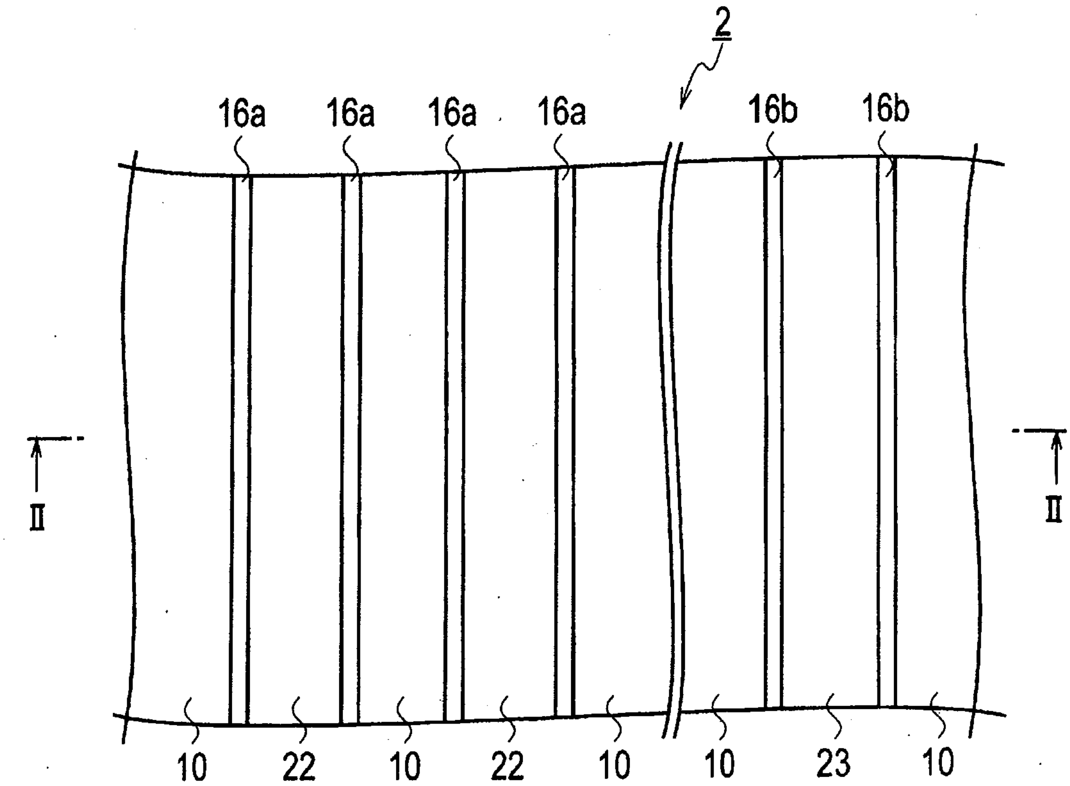
2
16a
16a
16a
16a
16b
16b
II
II
10
22
10
22
10
10
23
10

(a)

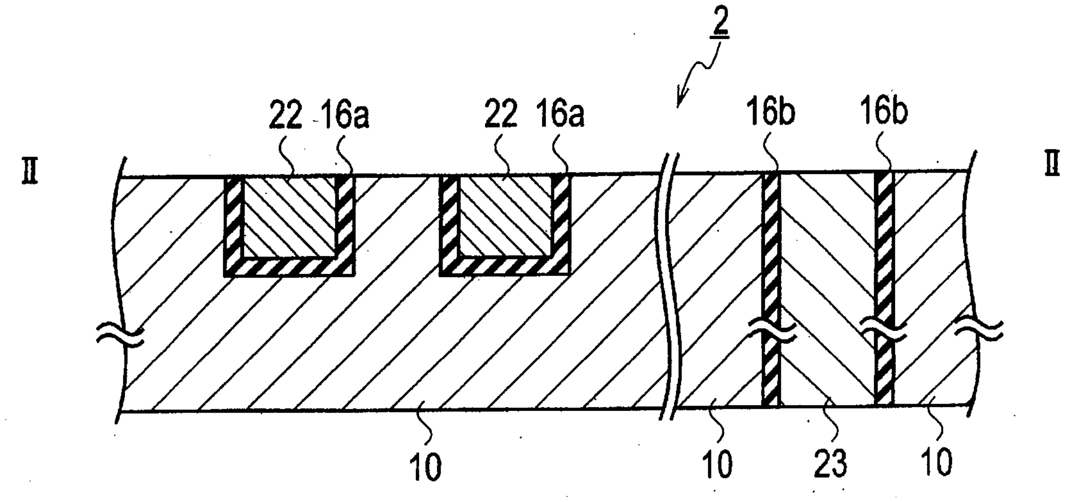
2
22 16a
22 16a
16b
16b
II
II
10
10
23
10

(b)

[ 3]

(a)
(b)
(c)

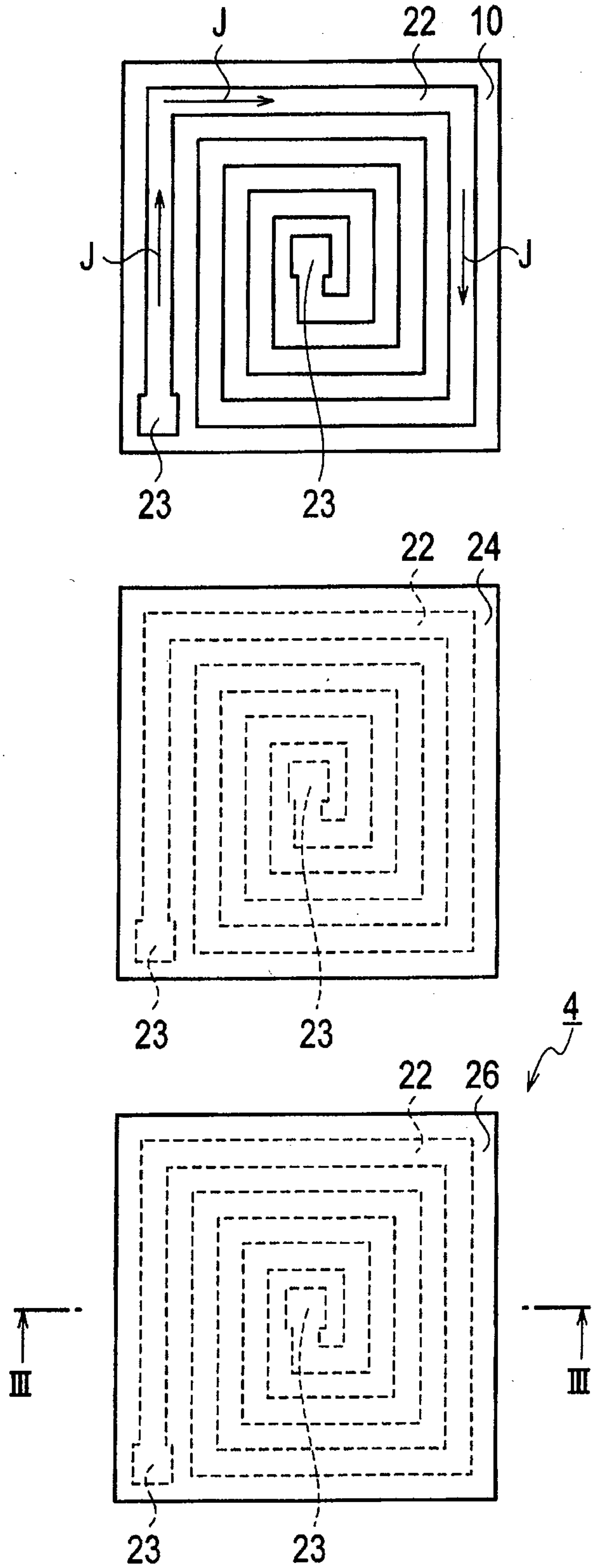

[ 4]

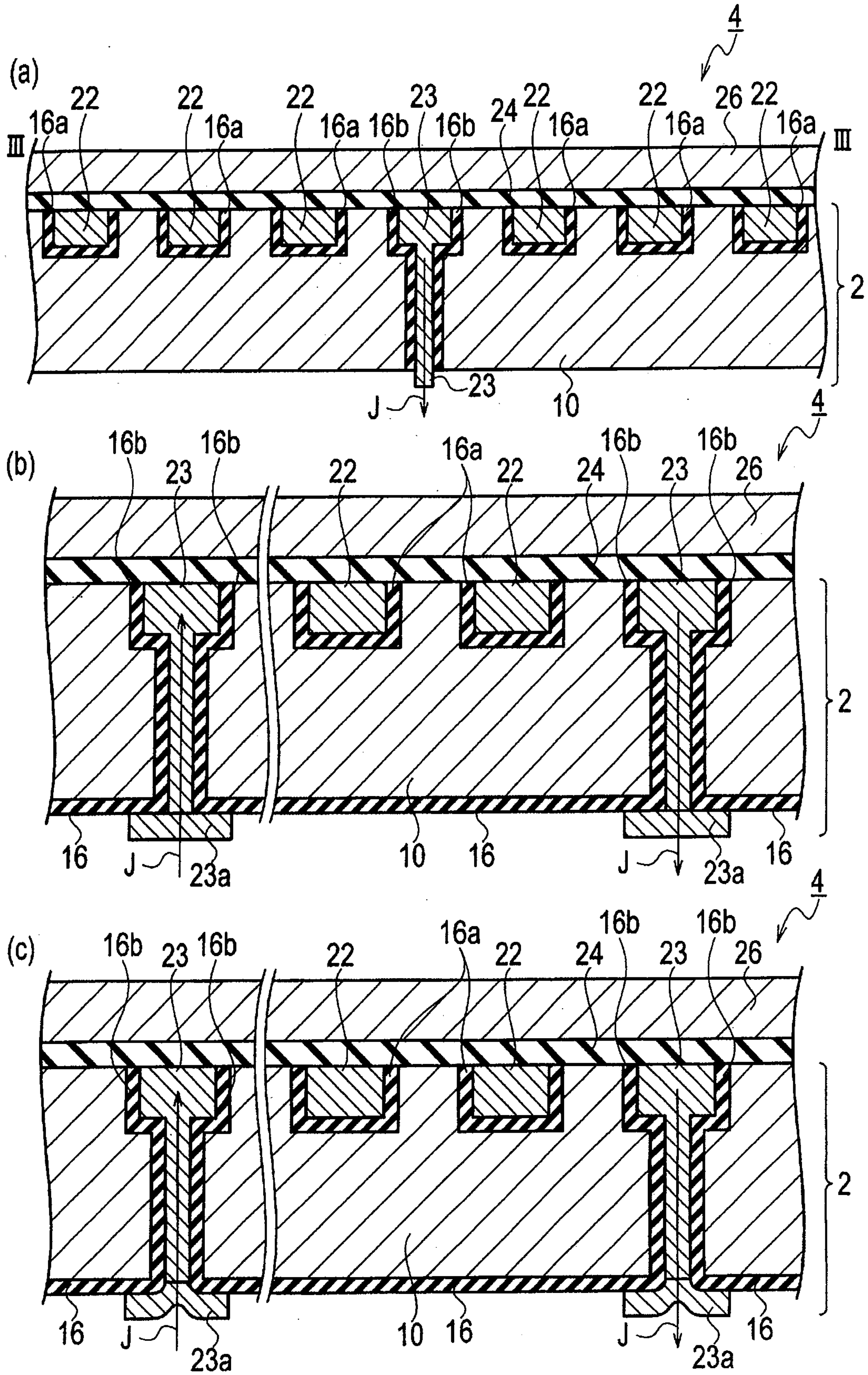

[ 5]

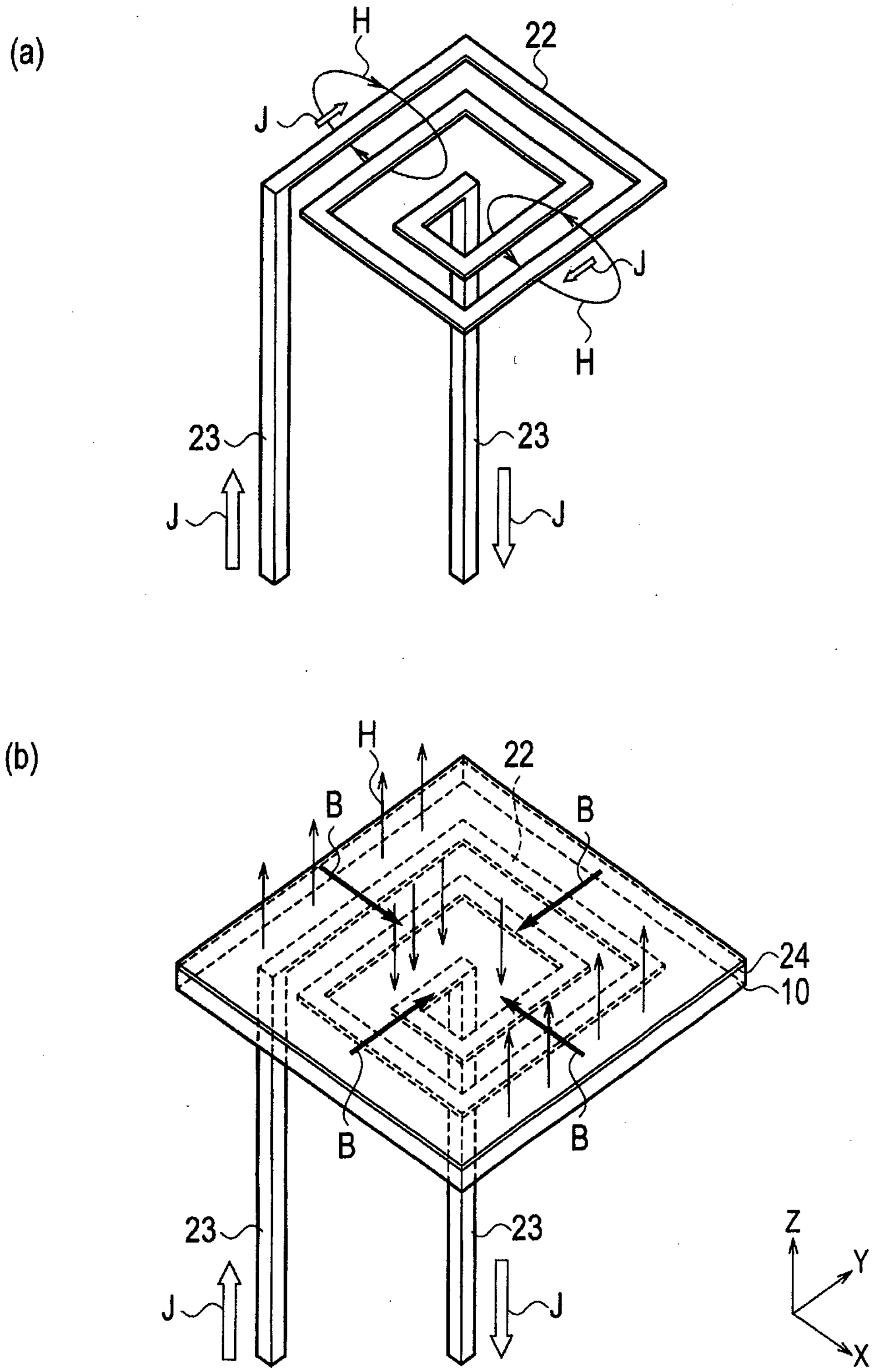

[ 6]

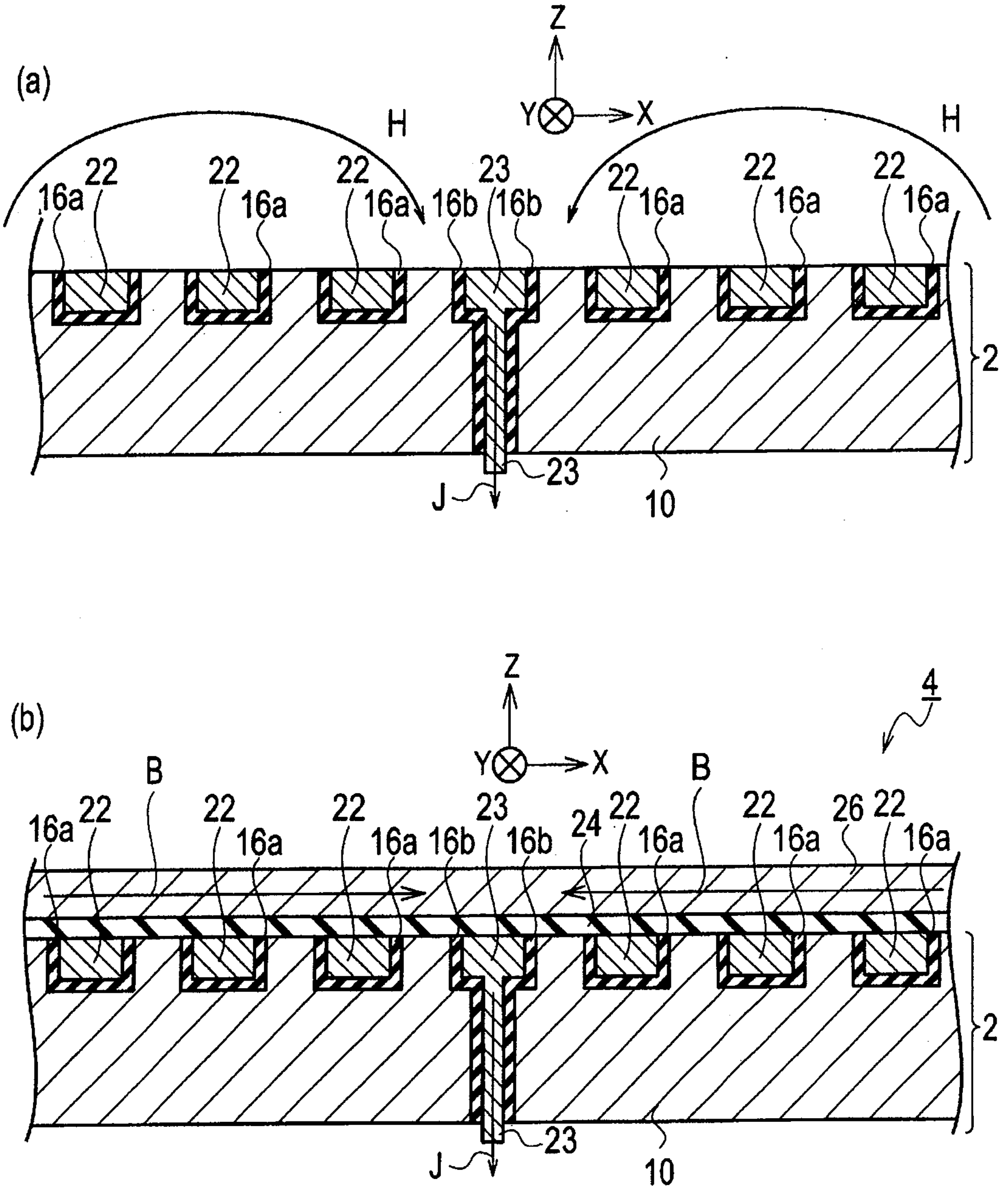

[ 7]

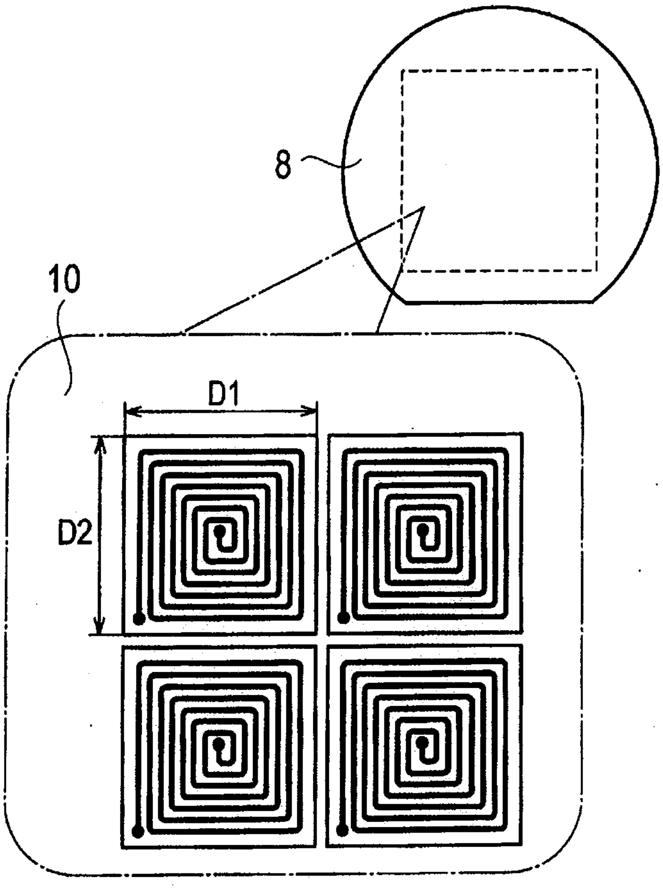
8
10
D1
D2

[図8]

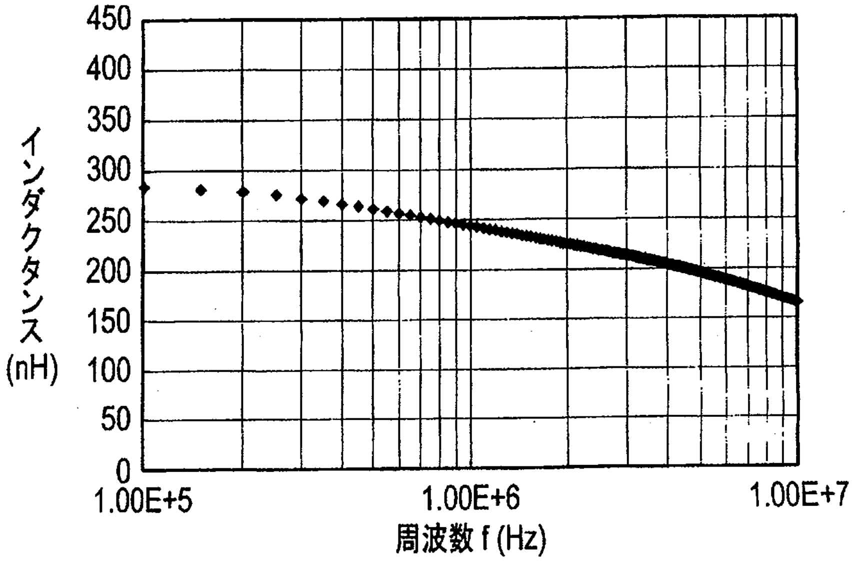
450
400
350
300
250
200
150
100
50
0
インダクタンス
(nH)
1.00E+5
1.00E+6
1.00E+7
周波数 f (Hz)

[ 9]

(a)

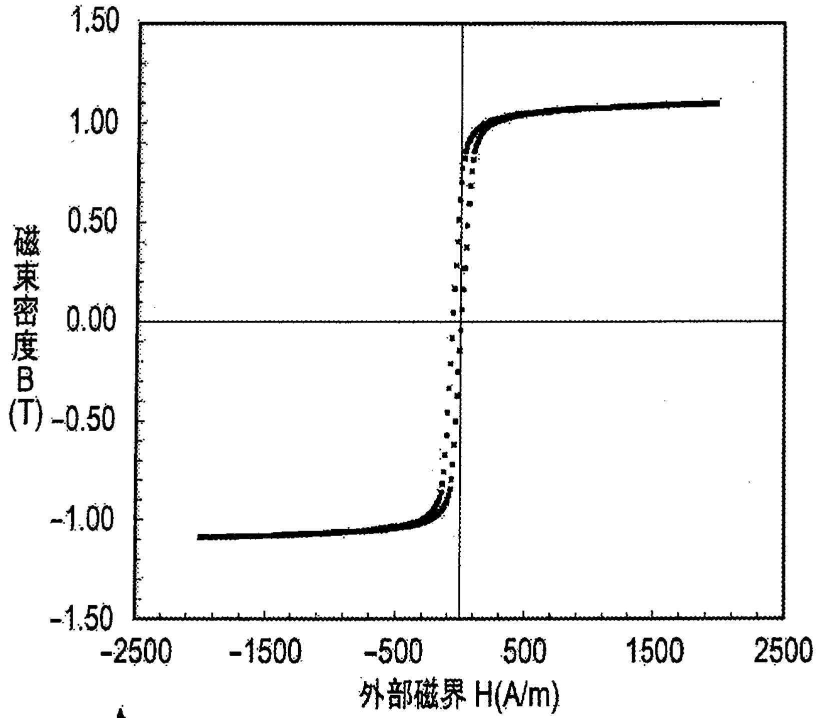
1.50
1.00
0.50
0.00
-0.50
-1.00
-1.50
磁束密度B (T)
-2500
-1500
-500
500
1500
2500
外部磁界 H(A/m)

(b)

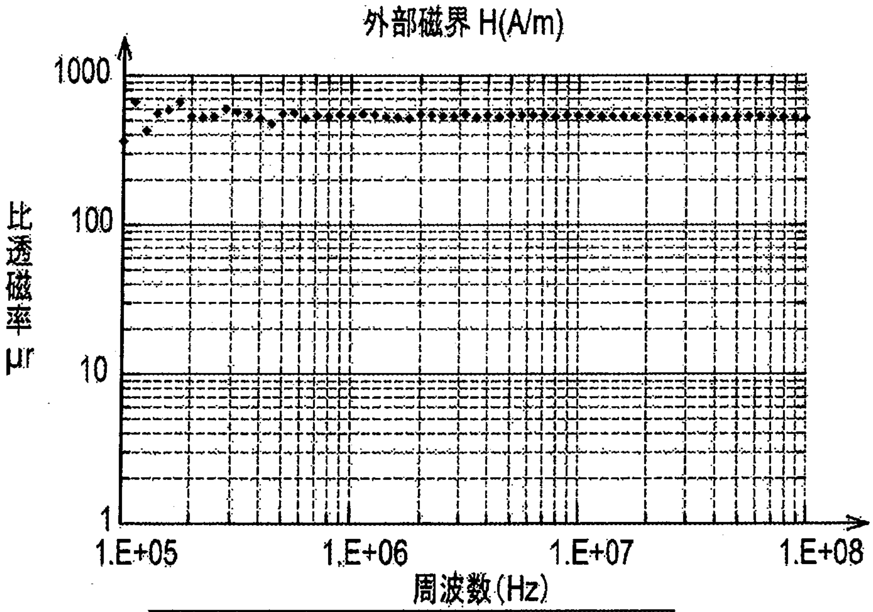
1000
100
10
1
比透磁率 μr
1.E+05
1.E+06
1.E+07
1.E+08
周波数(Hz)

(c)

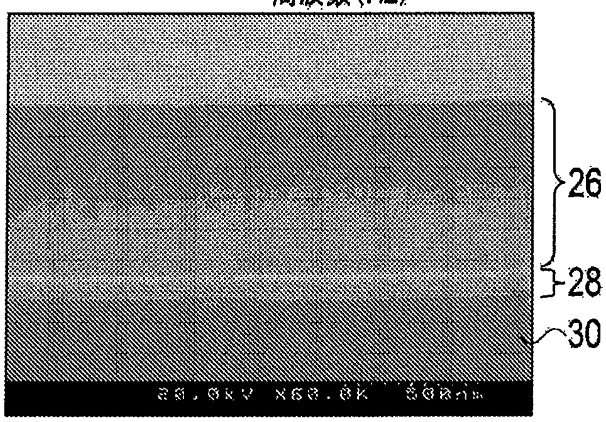
26
28
30

[ 10]

(a)

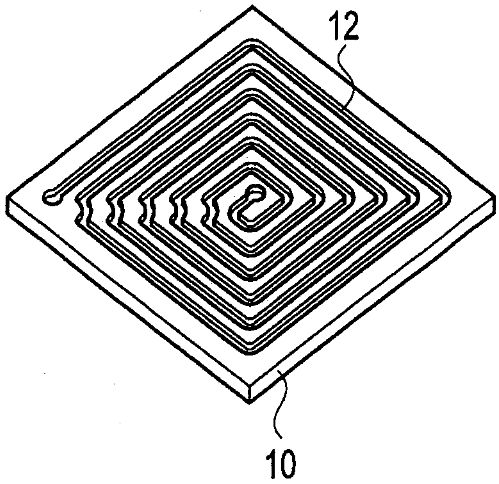


(b)

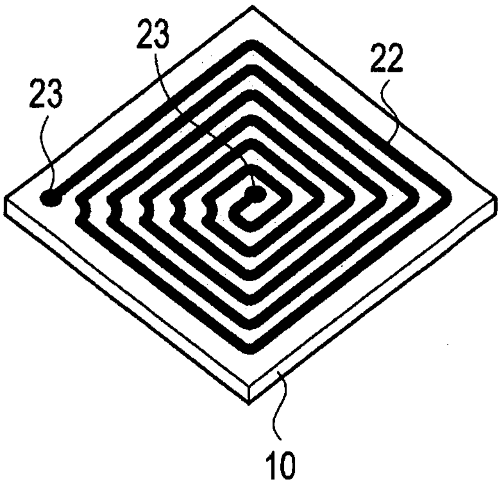

[ 11]

(a)

(b)

(c)

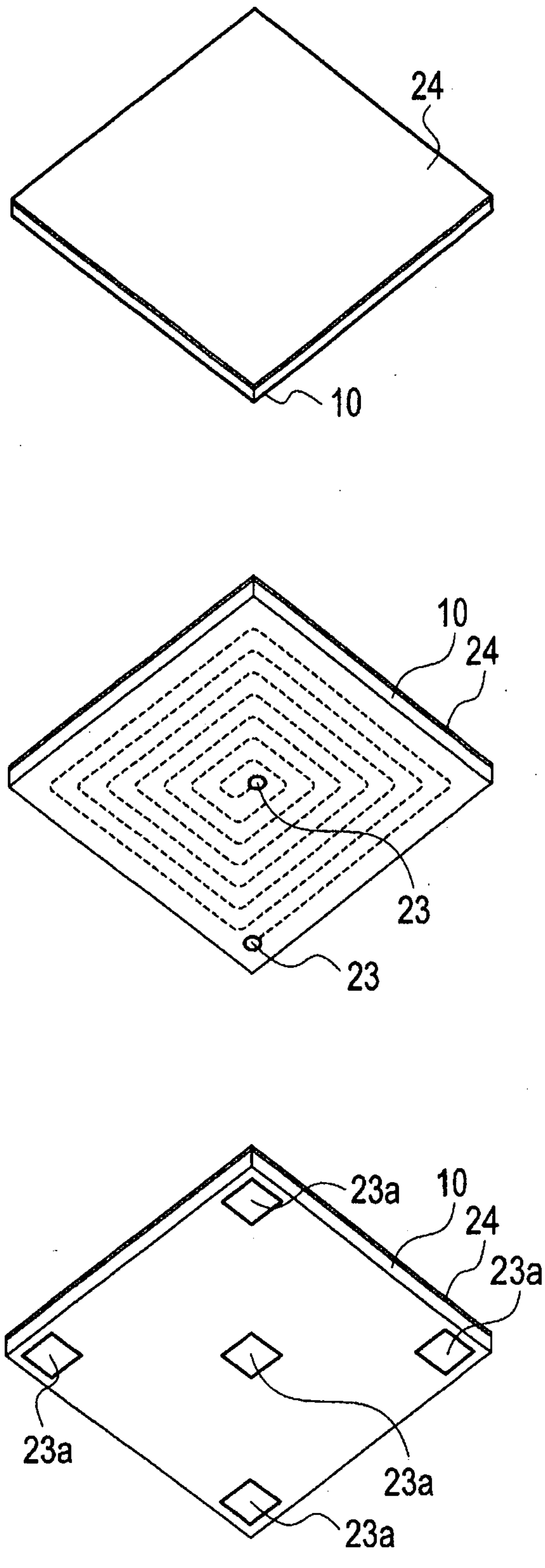

[ 12]

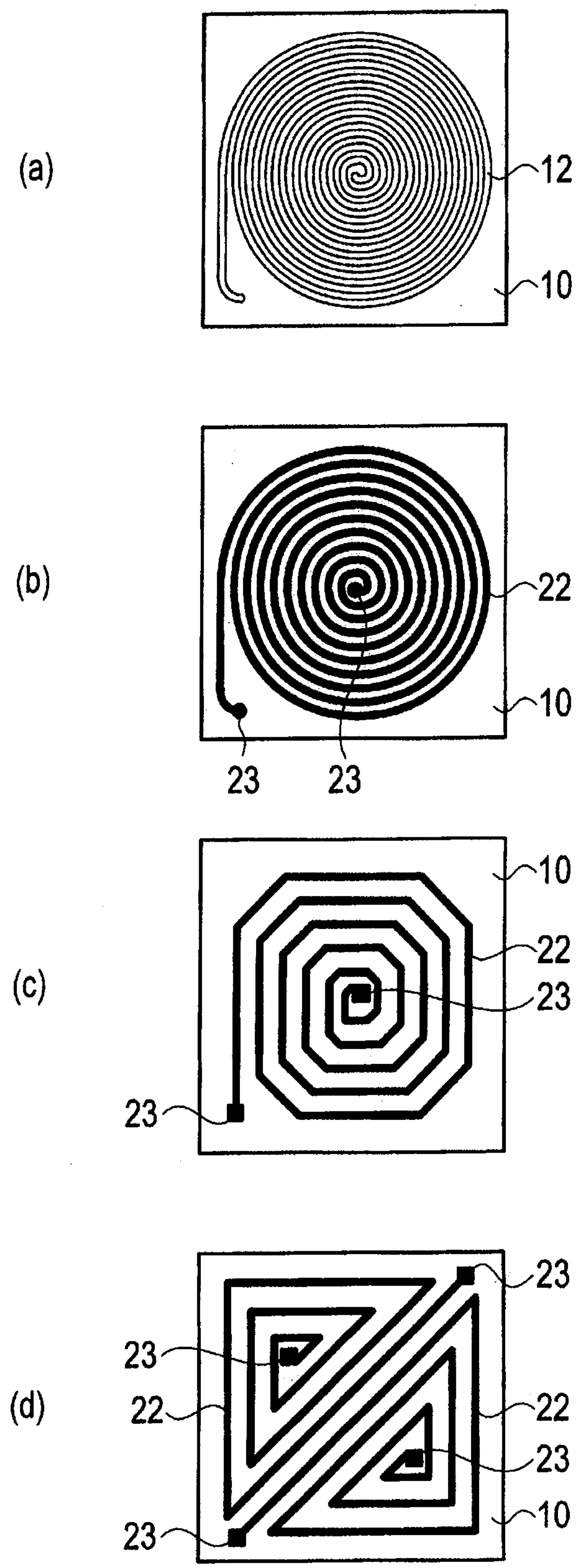

[ 13]

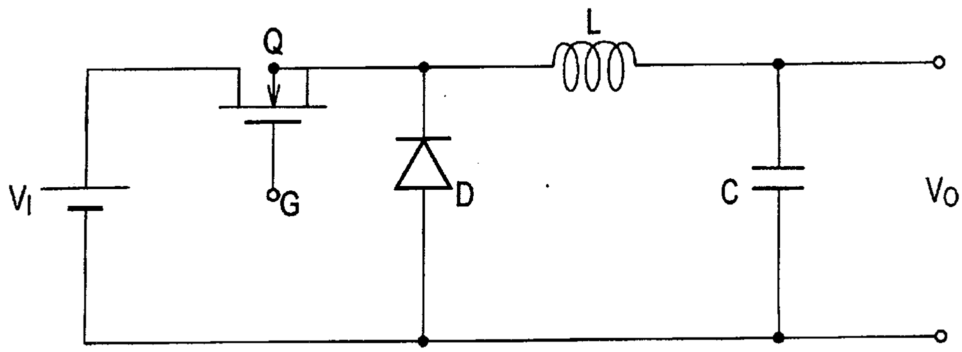

[ 14]

(a)

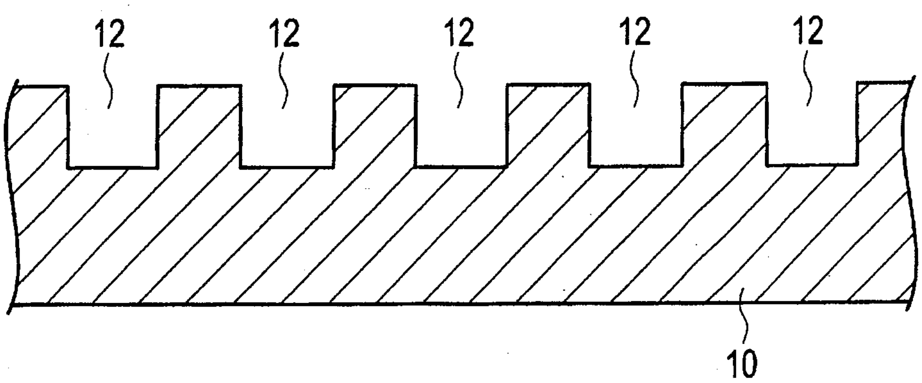


(b)

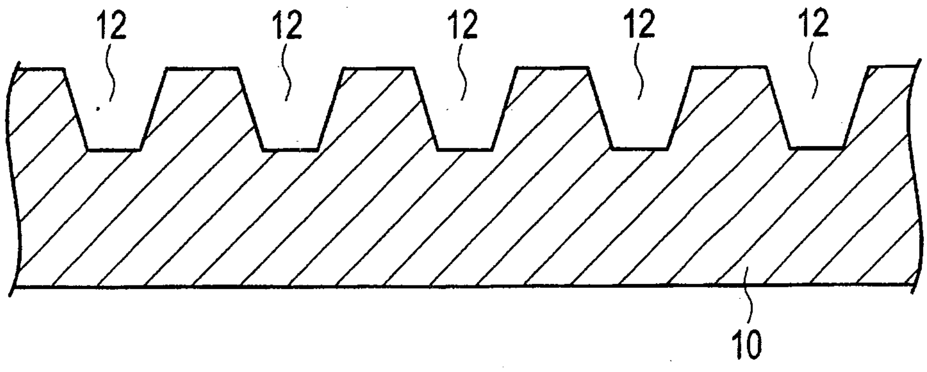


(c)

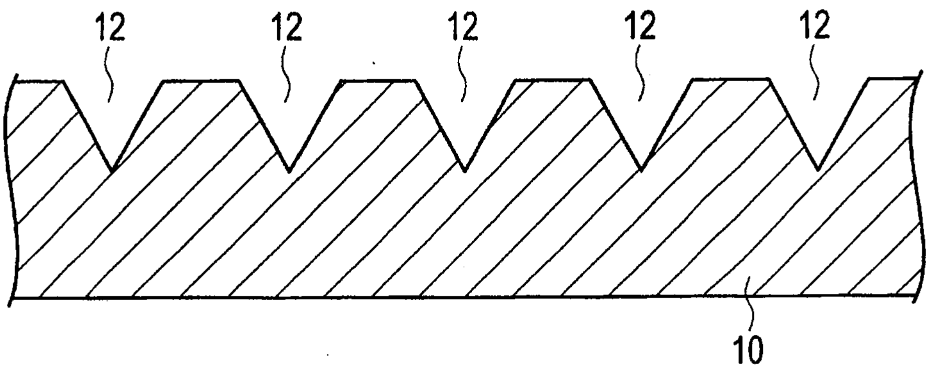

[ 15]

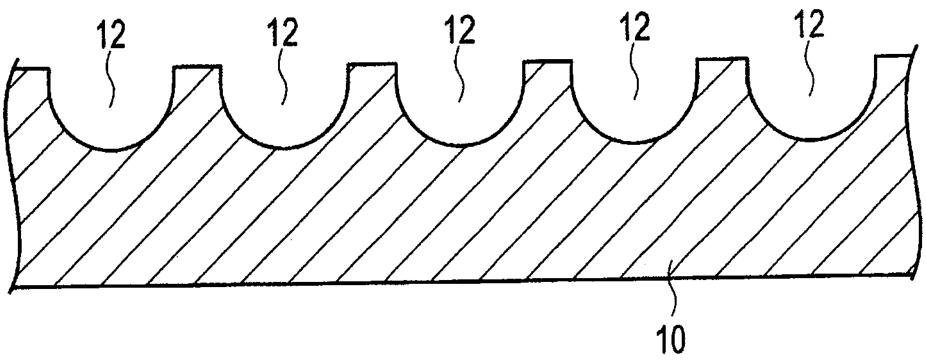


[ 16]

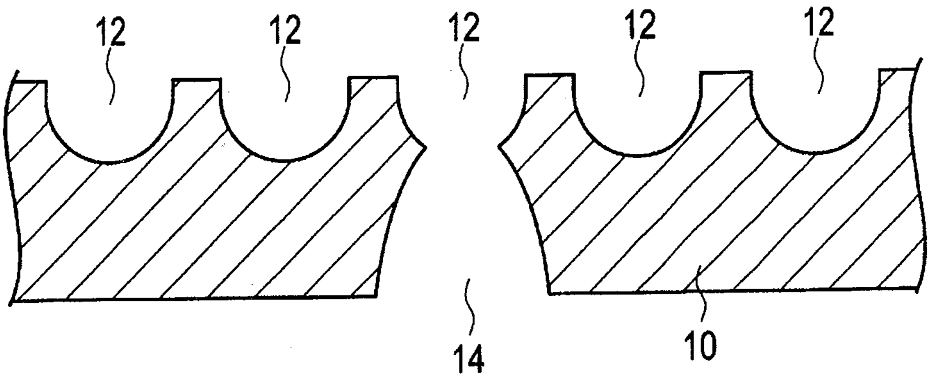

[ 17]

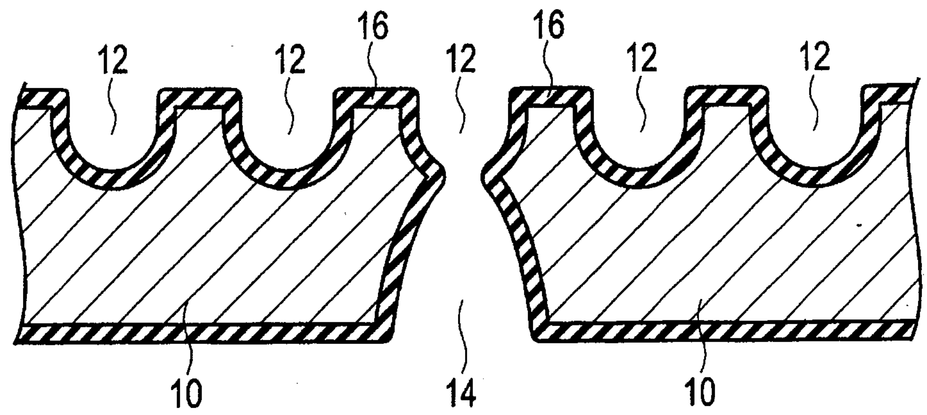
12
12
16
12
16
12
12
10
14
10

[ 18]

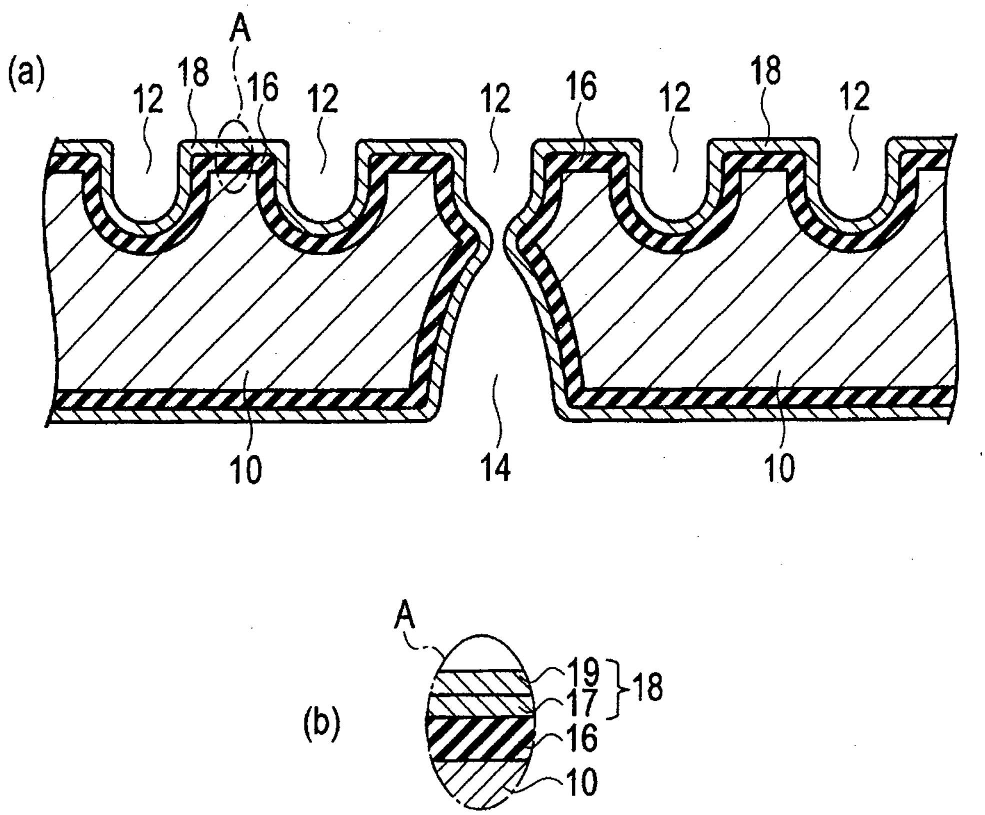
(a)
A
12
18
16
12
12
16
12
18
12
10
14
10
(b)
A
19
17
18
16
10

[ 19]

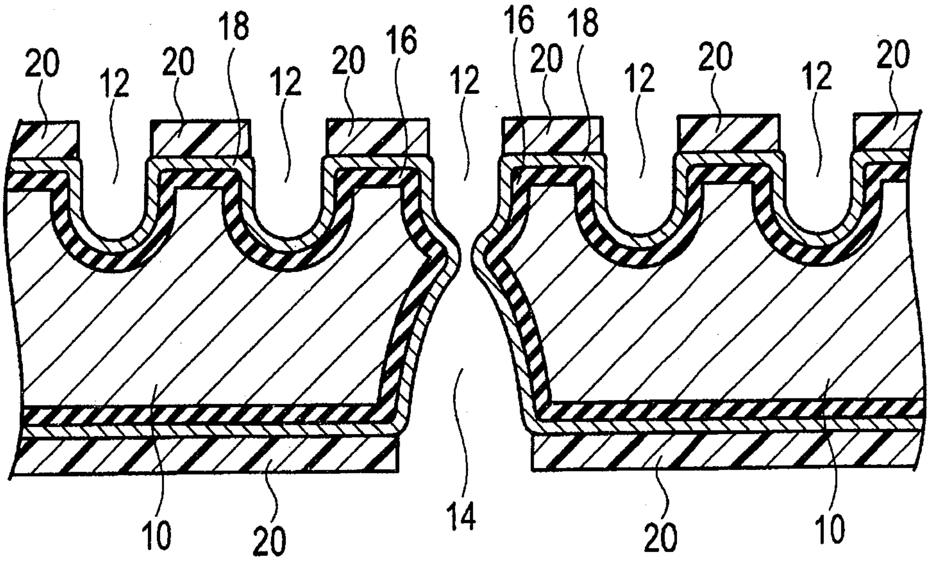

[ '20]

(a)

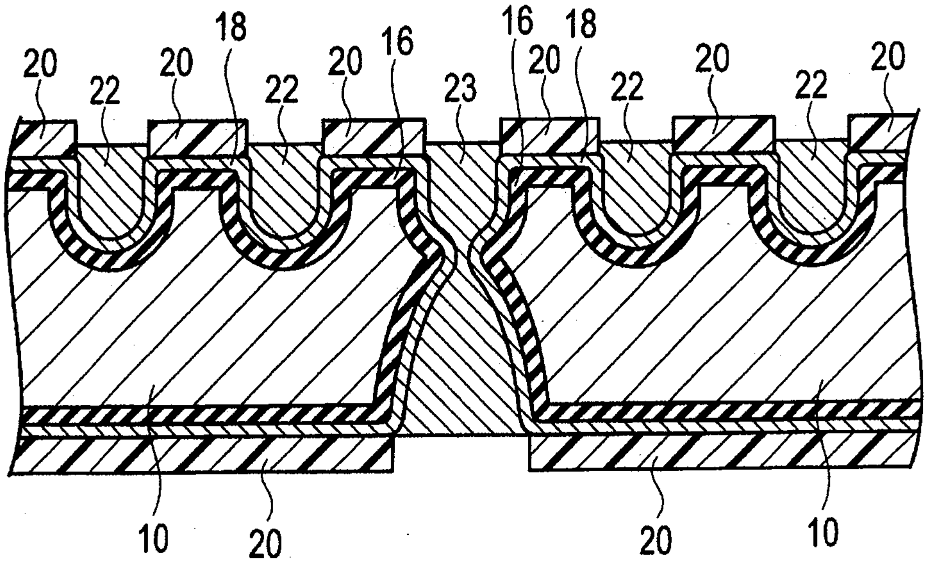
20
22
20
18
22
20
16
23
16
18
20
22
20
22
20
10
20
20
10

(b)

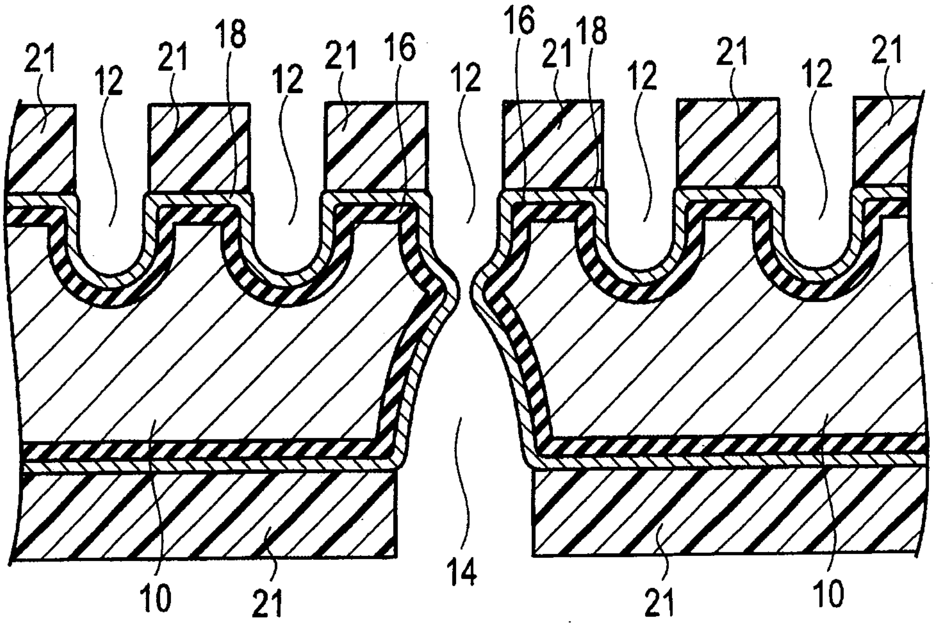
21
12
21
18
12
21
16
12
16
21
18
12
21
12
21
10
21
14
21
10

[ 21]

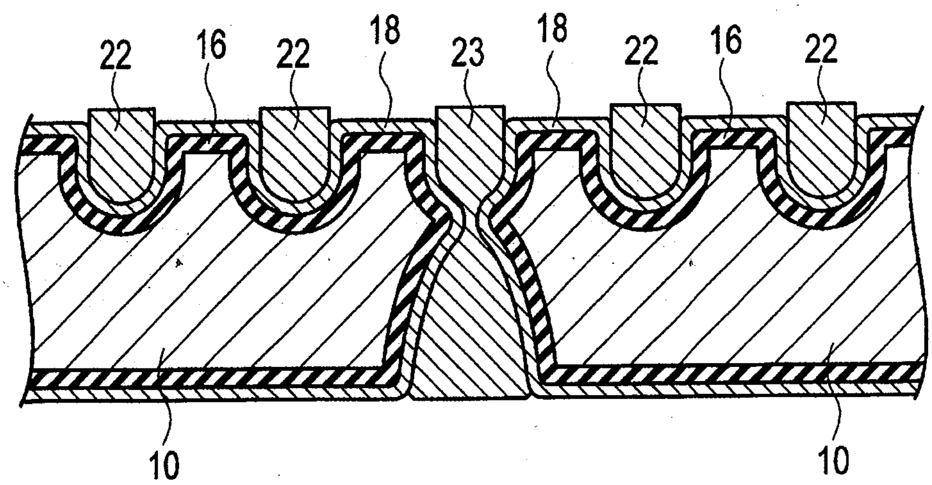
22
16
22
18
23
18
22
16
22
10
10

[ 22]

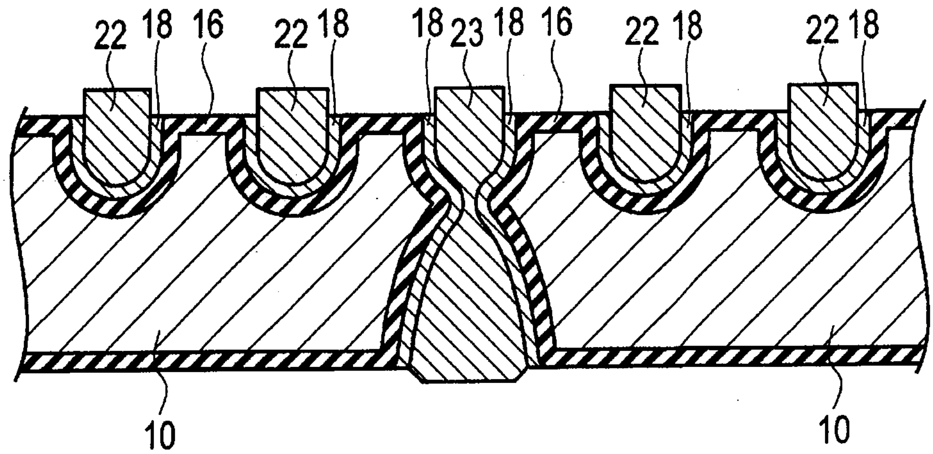
22
18
16
22
18
18
23
18
16
22
18
22
18
10
10

[ 23]

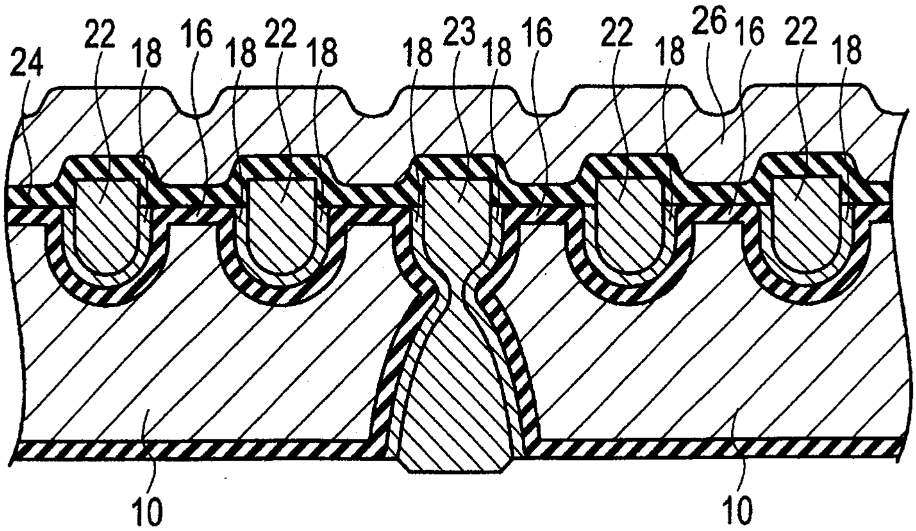
24
22
18
16
18
22
18
18
23
18
16
22
18
26
16
22
18
10
10

[ 24]

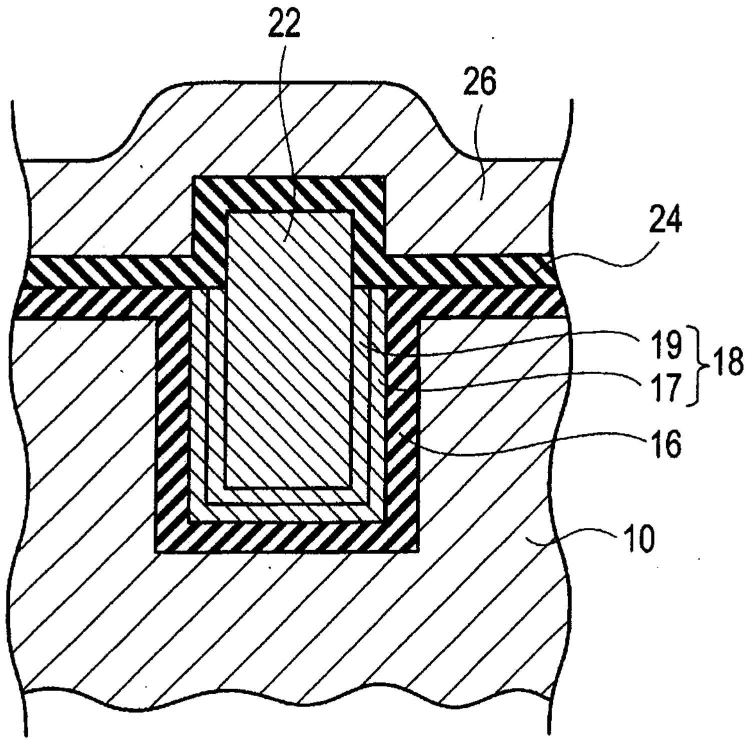
22
26
24
19
17
18
16
10

[ 25]

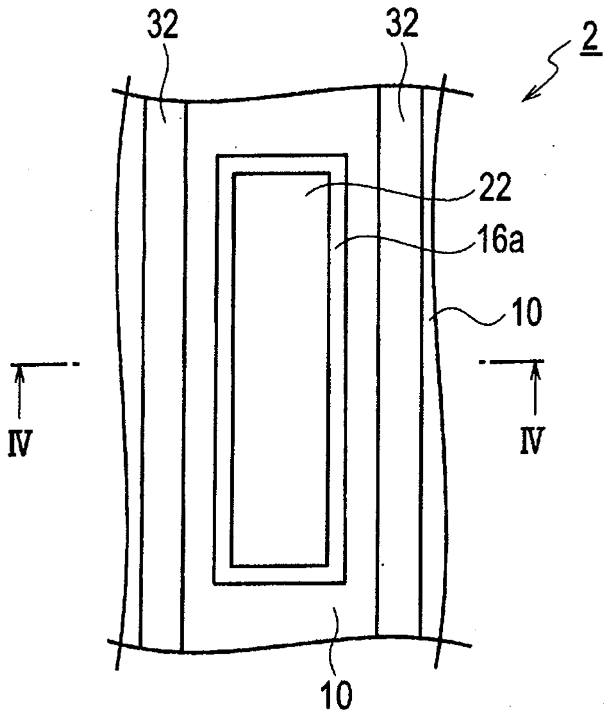
32
32
2
22
16a
10
IV
IV
10

(a)

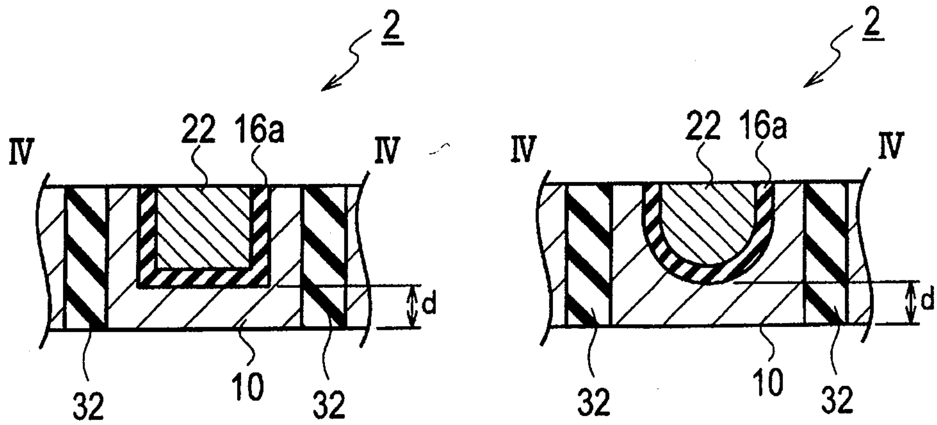
2
IV
22 16a
IV
d
32
10
32
2
IV
22 16a
IV
d
32
10
32

(b) (c)

[ 26]

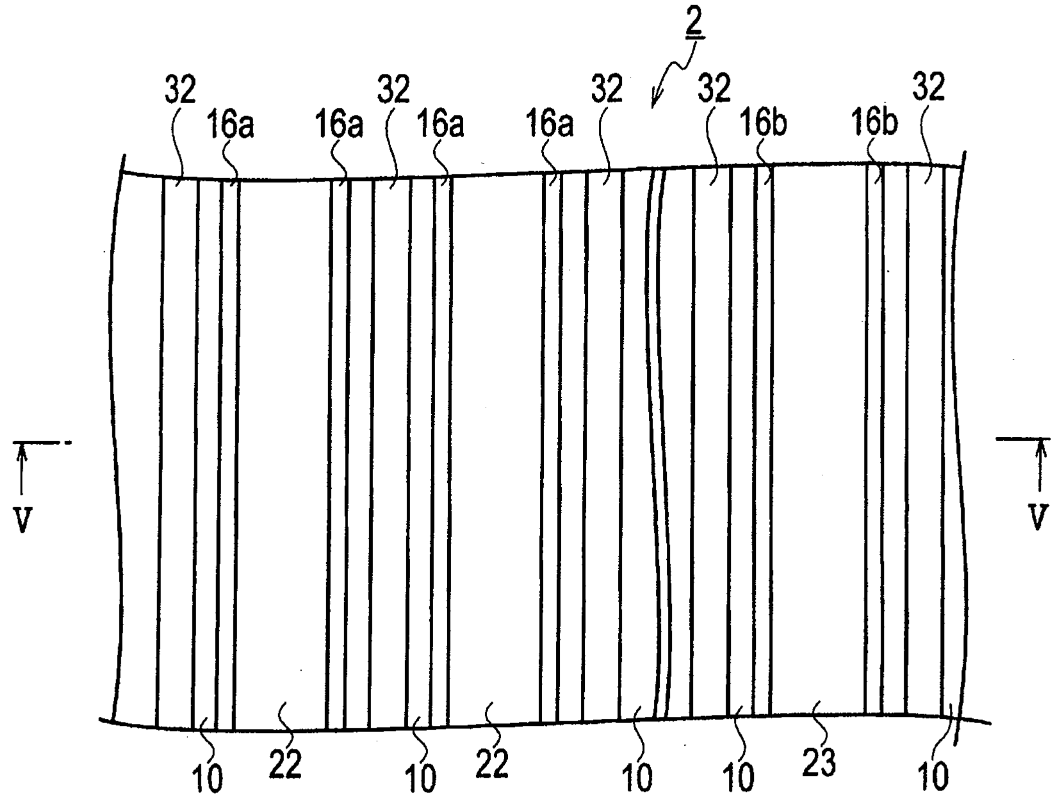
2
32
16a
16a
32
16a
16a
32
32
16b
16b
32
V
V
10
22
10
22
10
10
23
10

(a)

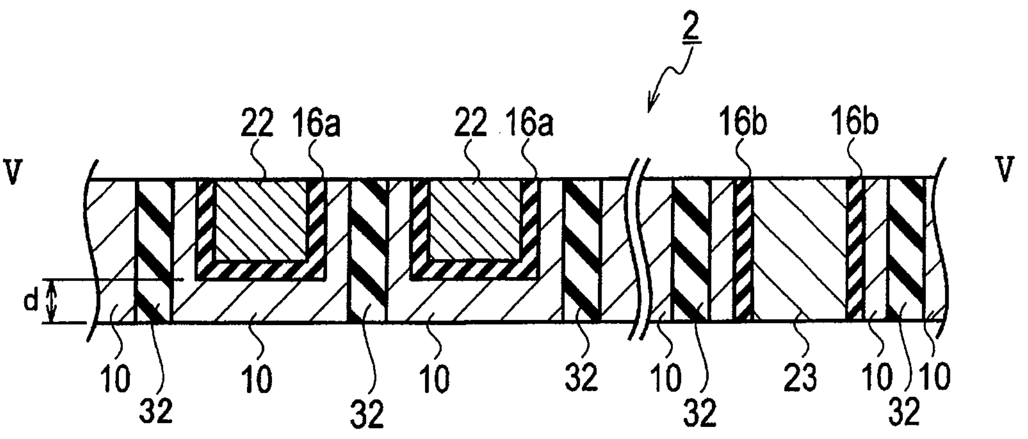
2
22
16a
22
16a
16b
16b
V
V
d
10
32
10
32
10
32
10
32
23
10
32
10

(b)

[図27]

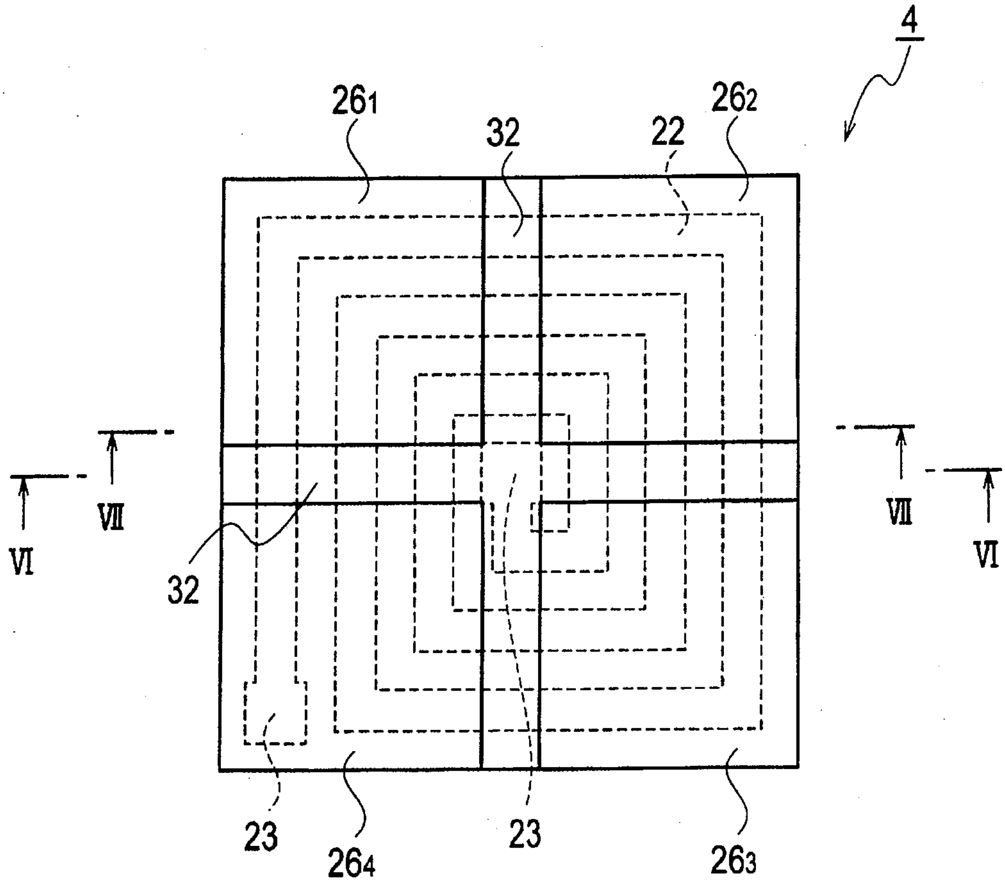

[ 28]

(a)

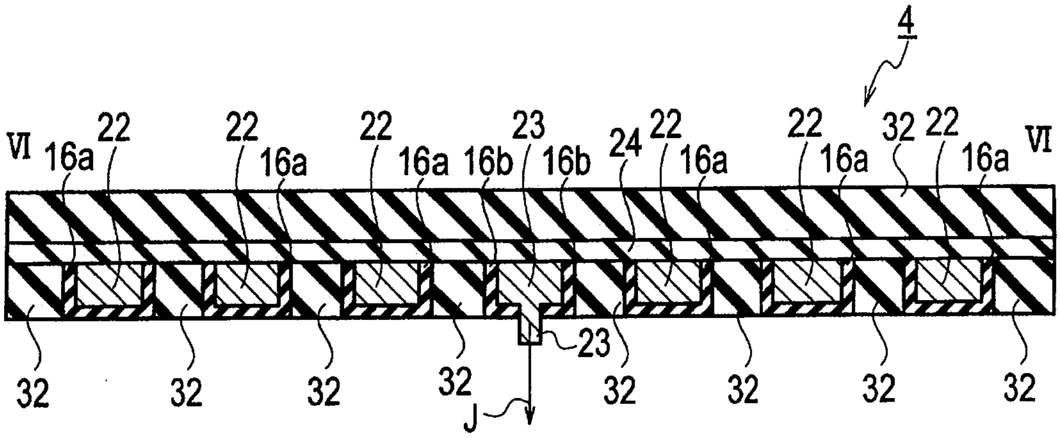
4
VI
16a
22
22
16a
22
16a
16b
23
16b
24
22
16a
22
16a
32
22
16a
VI
32
32
32
32
23
J
32
32
32
32

(b)

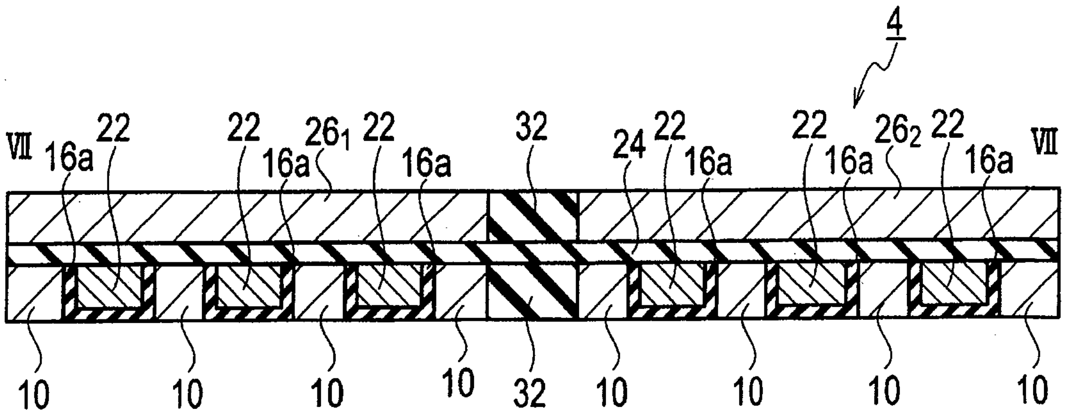
4
VII
16a
22
22
16a
$26_1$
22
16a
32
24
22
16a
22
16a
$26_2$
22
16a
VII
10
10
10
10
32
10
10
10
10

[  29]

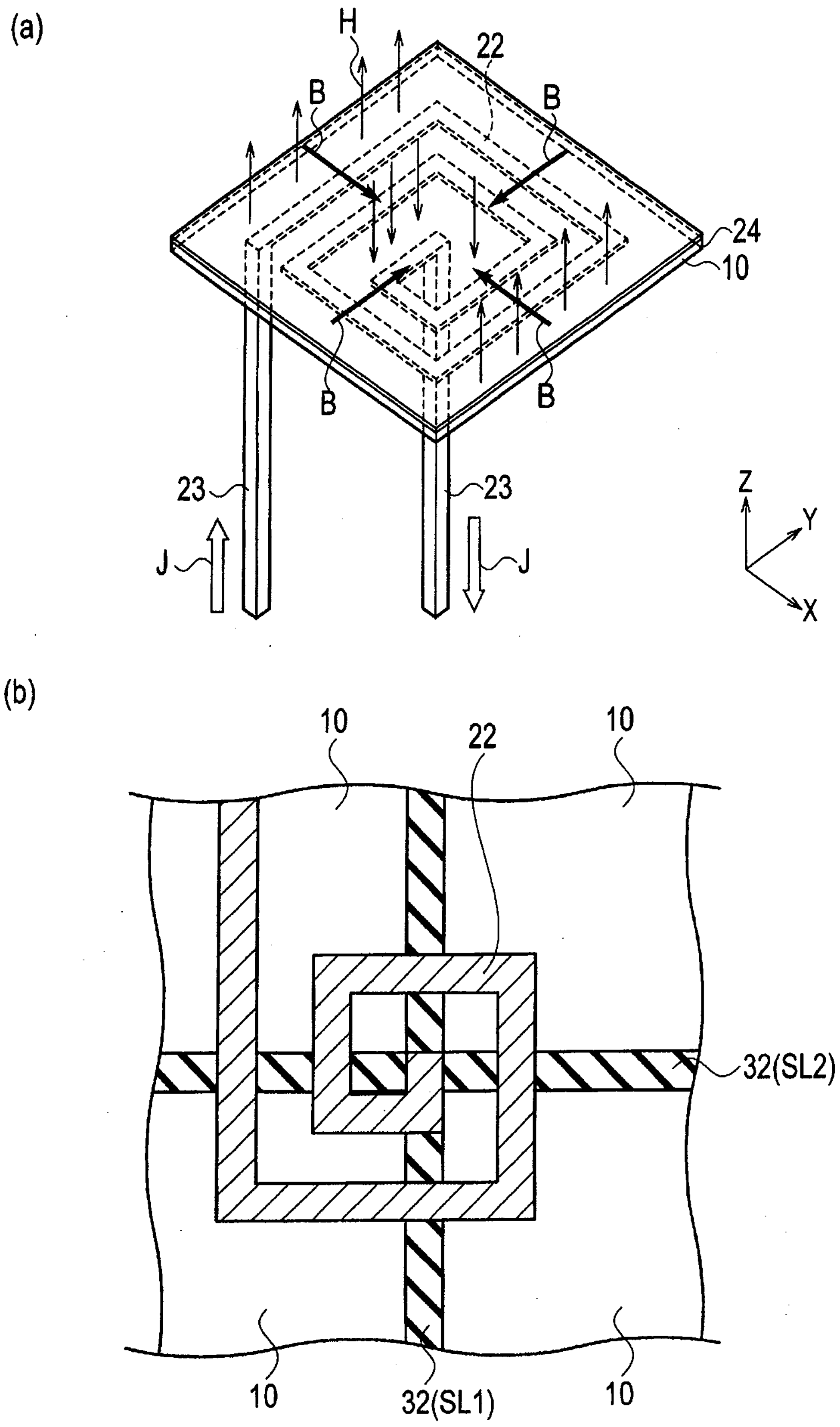

[ 30]

(a)

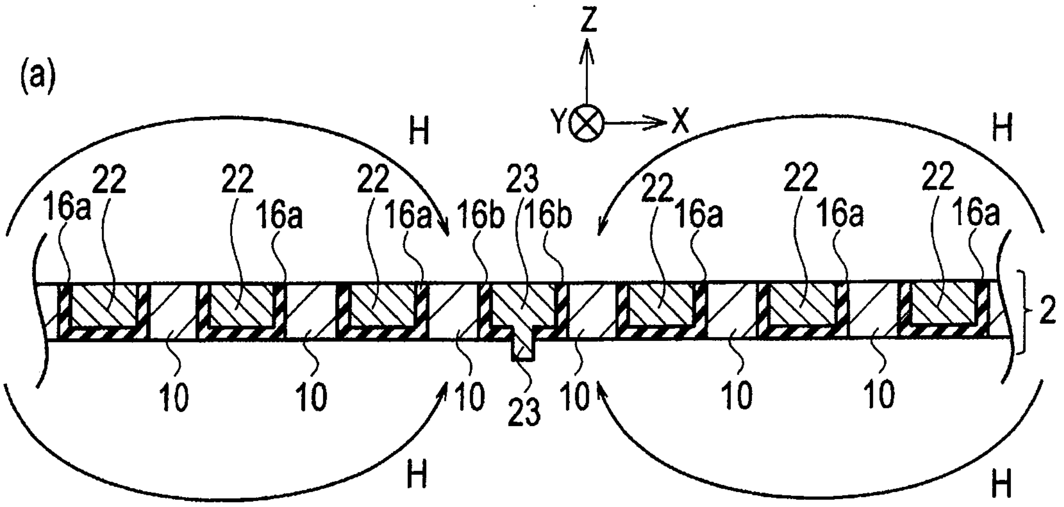


(b)

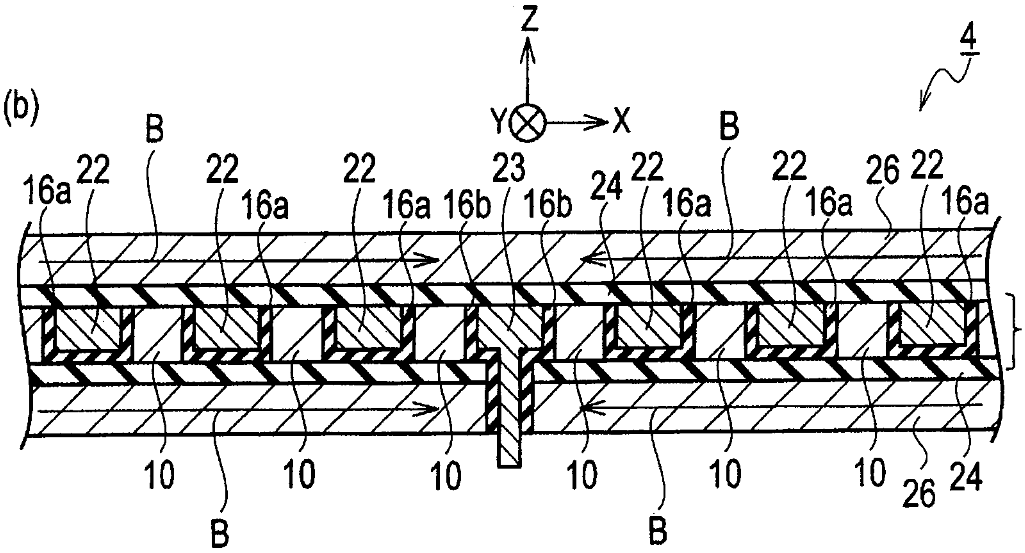

[ 31]

(a)

(b)

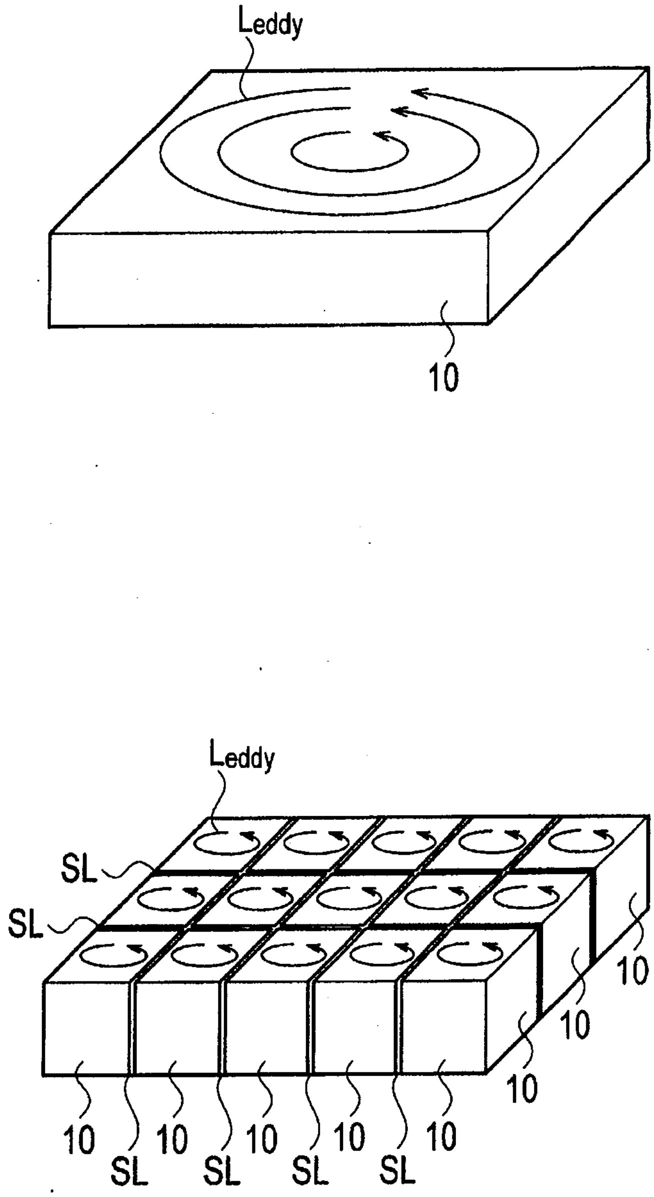

[ 32]

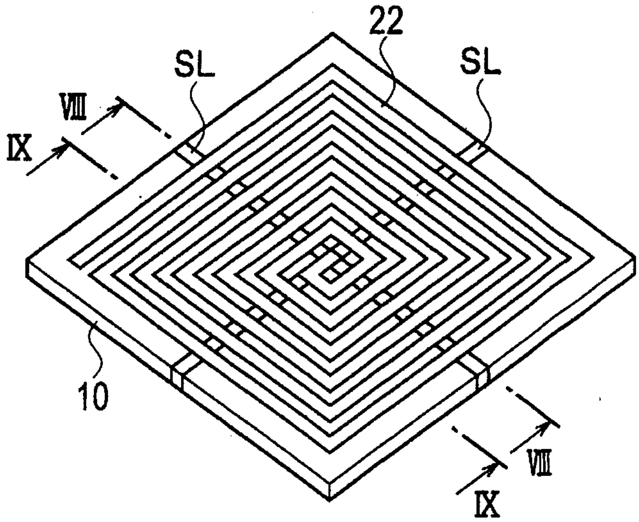

[ 33]

(a)

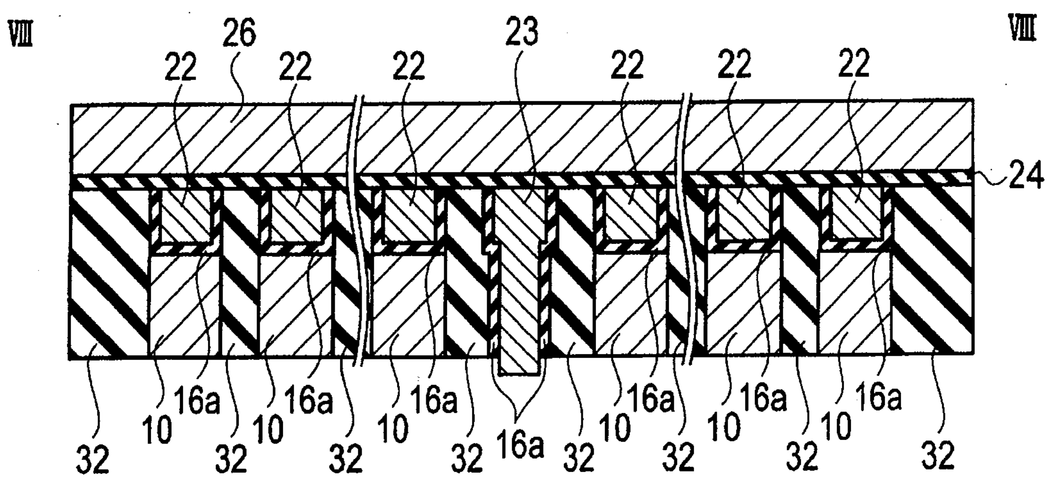
VIII
26
22
22
22
23
22
22
22
VIII
24
32
10
16a
32
10
16a
32
10
16a
32
16a
32
10
16a
32
10
16a
32
10
16a
32

(b)

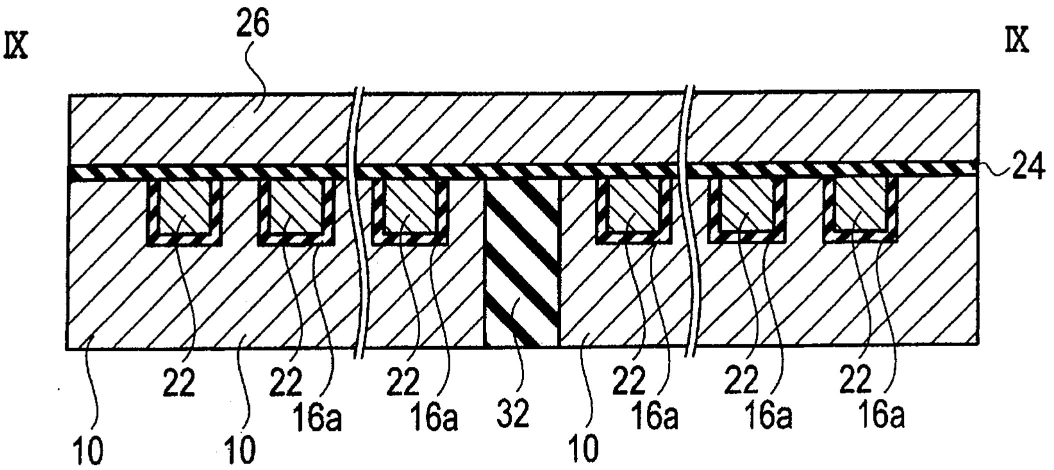
IX
26
IX
24
22
10
22
16a
10
22
16a
32
10
22
16a
22
16a
22
16a

[ 34]

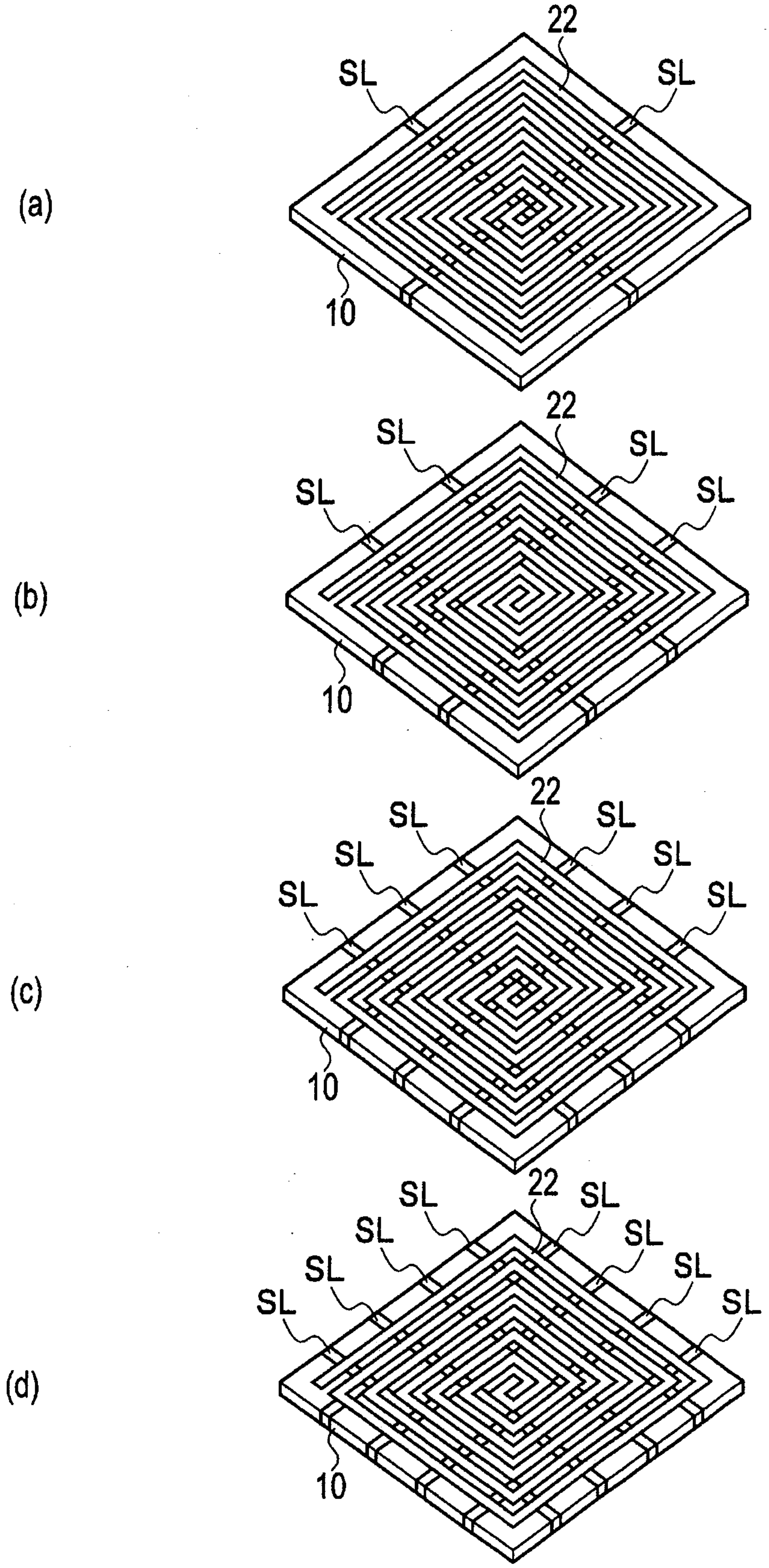
(a)
22
SL
SL
10
(b)
22
SL
SL
SL
SL
10
(c)
22
SL
SL
SL
SL
SL
SL
10
(d)
22
SL
SL
SL
SL
SL
SL
SL
SL
10

[ 35]

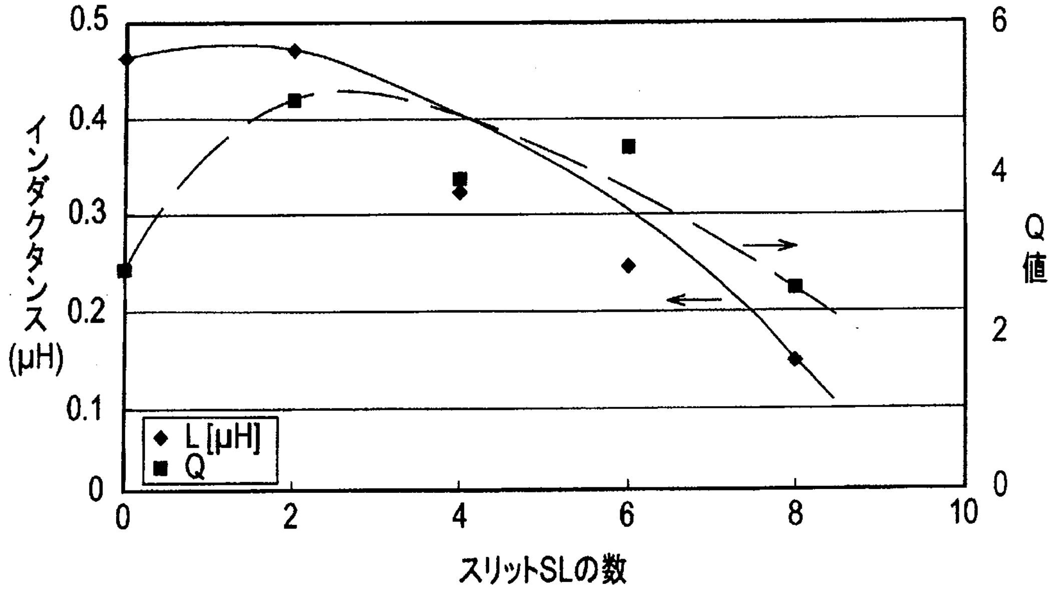

[ 36]

(a)

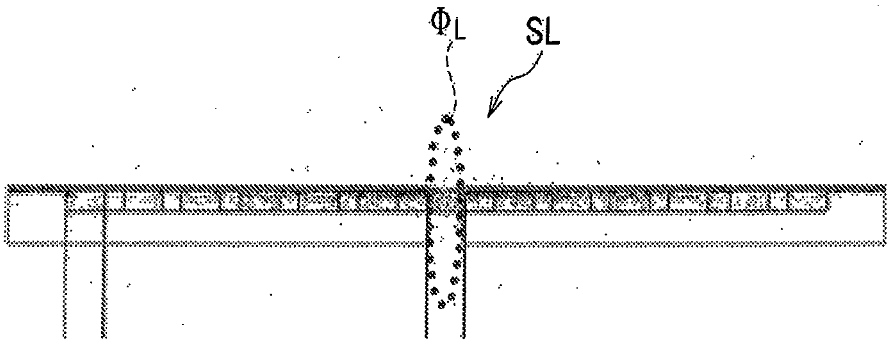


(b)

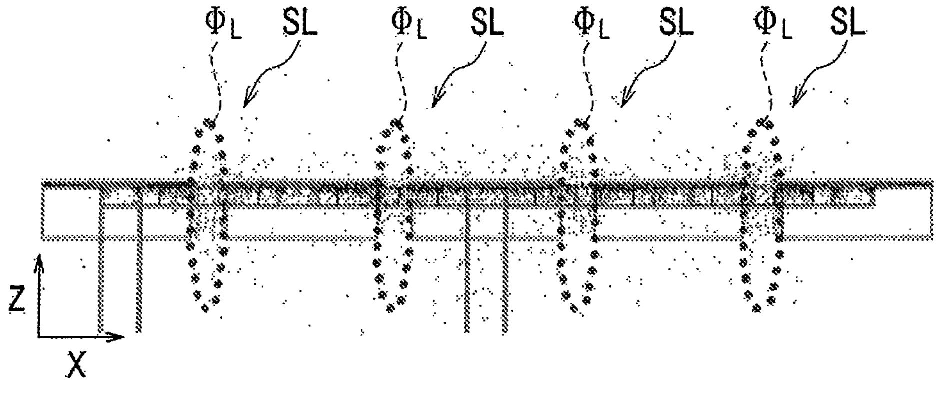

[ 37]

(a)

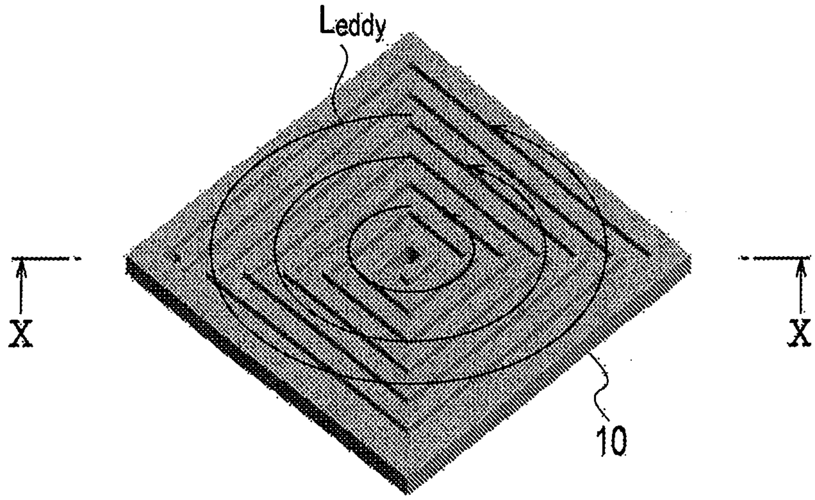
Leddy
X
X
10

(b)

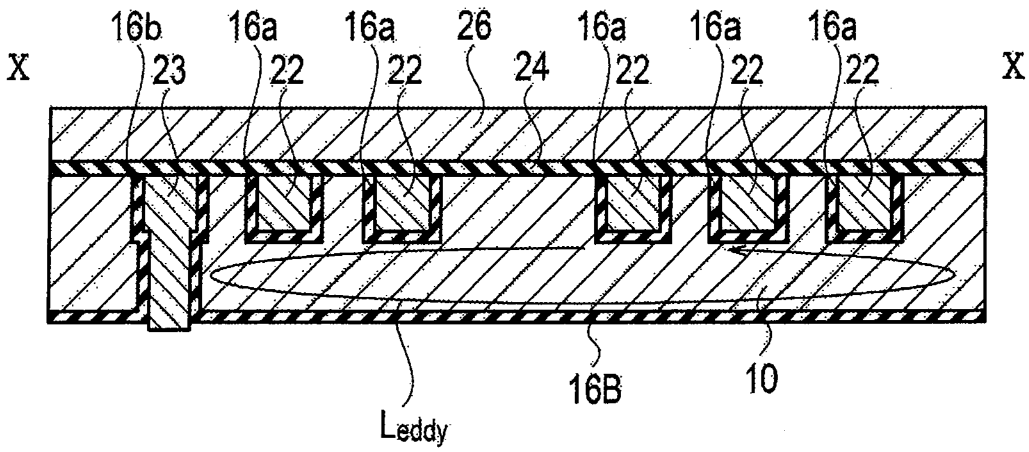
16b
16a
16a
26
16a
16a
16a
X
23
22
22
24
22
22
22
X
16B
10
Leddy

[ 38]

(a)

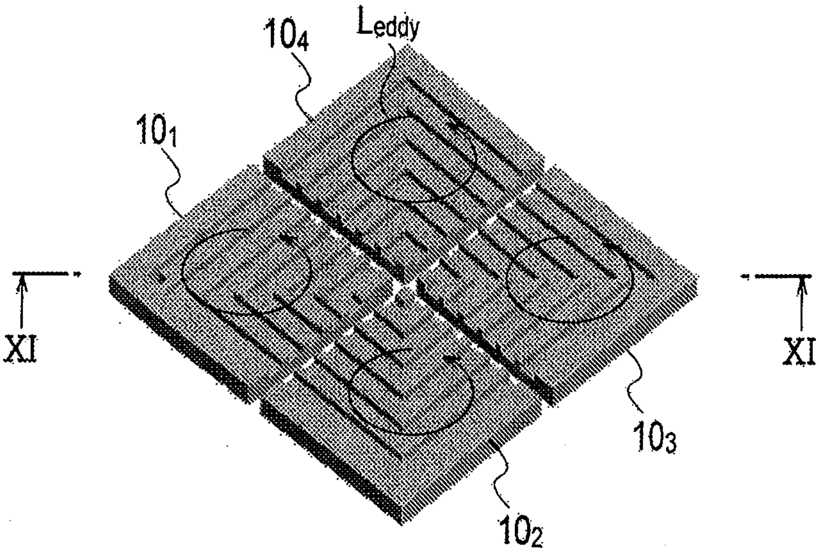
10₄
Leddy
10₁
XI
XI
10₃
10₂

(b)

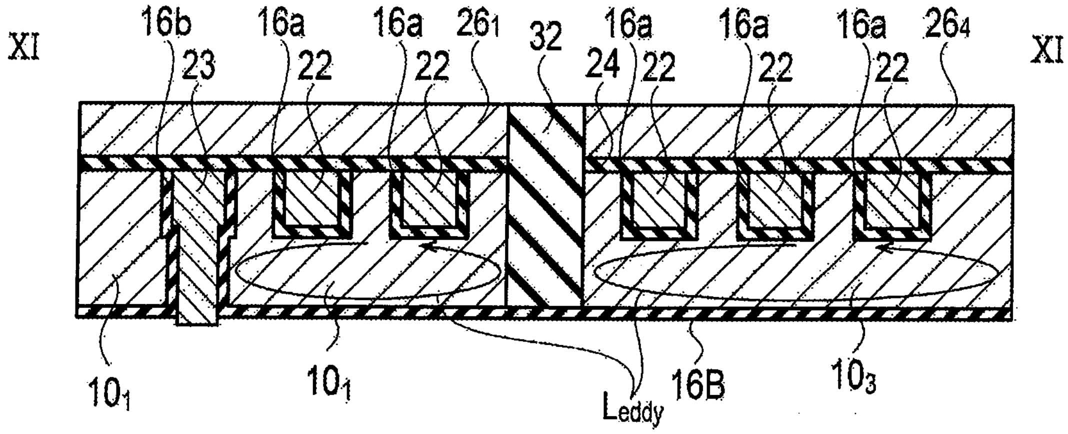
XI
16b
23
16a
22
16a
22
26₁
32
24
16a
22
16a
22
16a
22
26₄
XI
10₁
10₁
Leddy
16B
10₃

[ 39]

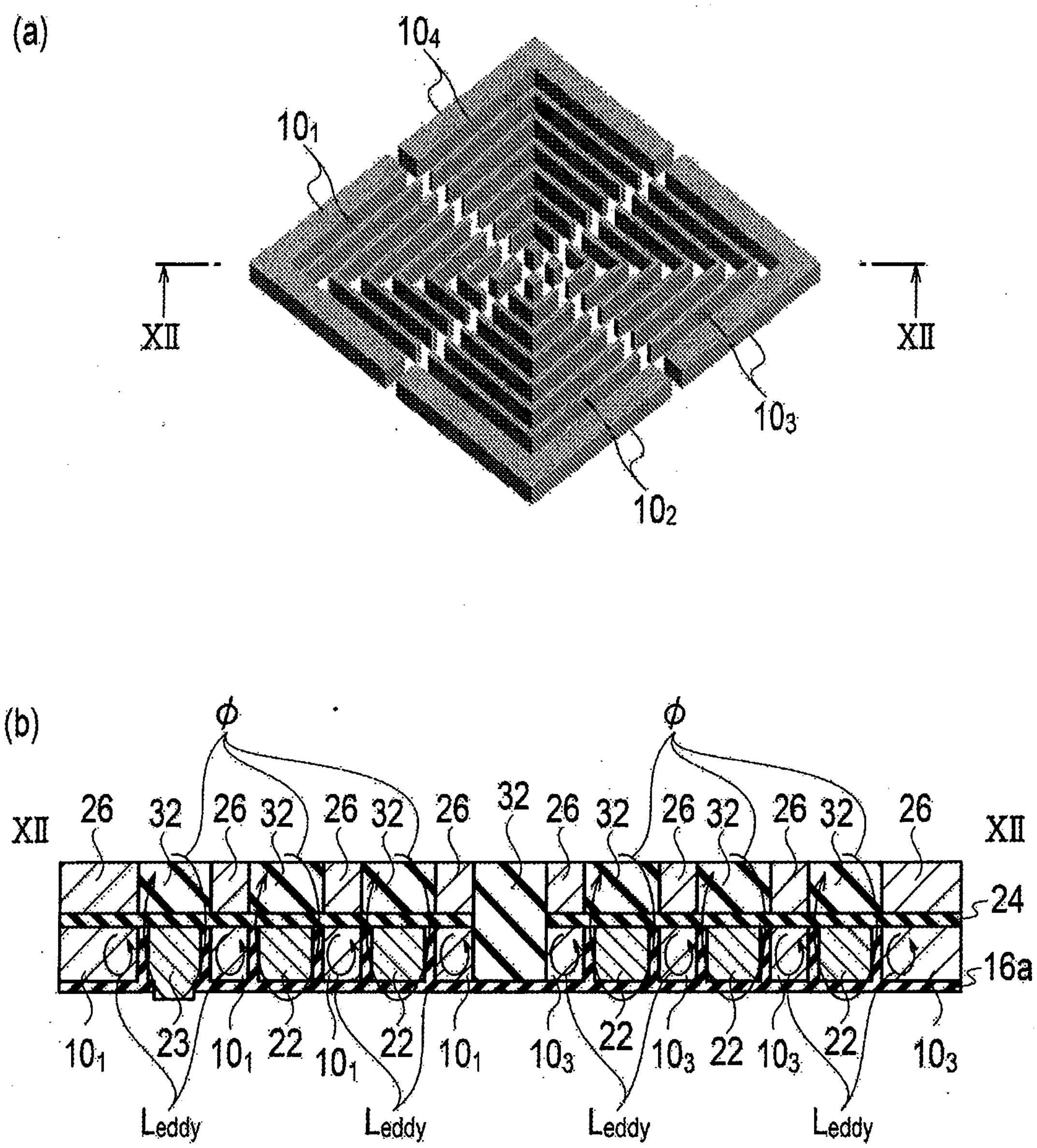
(a)
10₄
10₁
XII
XII
10₃
10₂
(b)
φ
φ
XII
26 32 26 32 26 32 26 32 26 32 26 32 26 32 26
XII
24
16a
10₁ 23 10₁ 22 10₁ 22 10₁ 10₃ 22 10₃ 22 10₃ 22 10₃
Leddy
Leddy
Leddy
Leddy

[ 40]

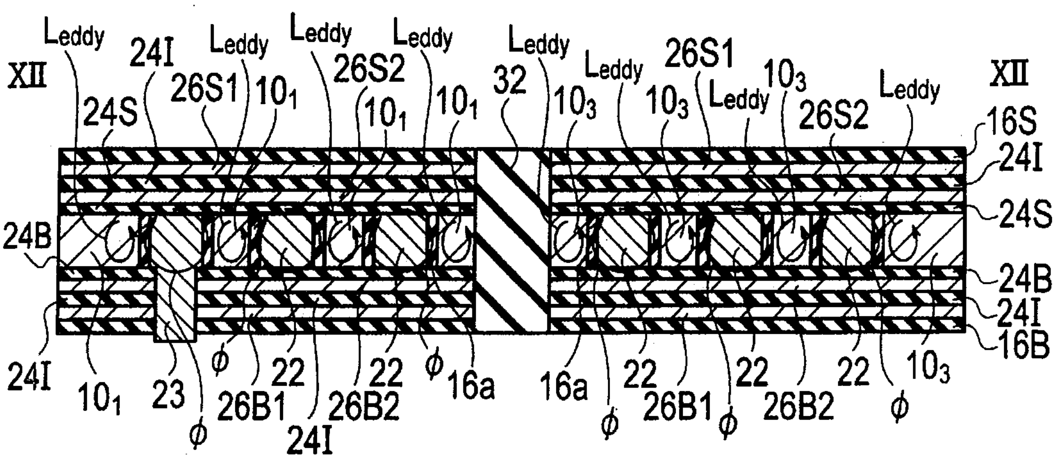
XII
XII
Leddy
24I
24S
26S1
10₁
26S2
32
10₃
26S1
Leddy
26S2
16S
24I
24S
24B
24B
24I
16B
24I
10₁
23
26B1
26B2
22
16a
26B1
26B2
10₃

[ 41]

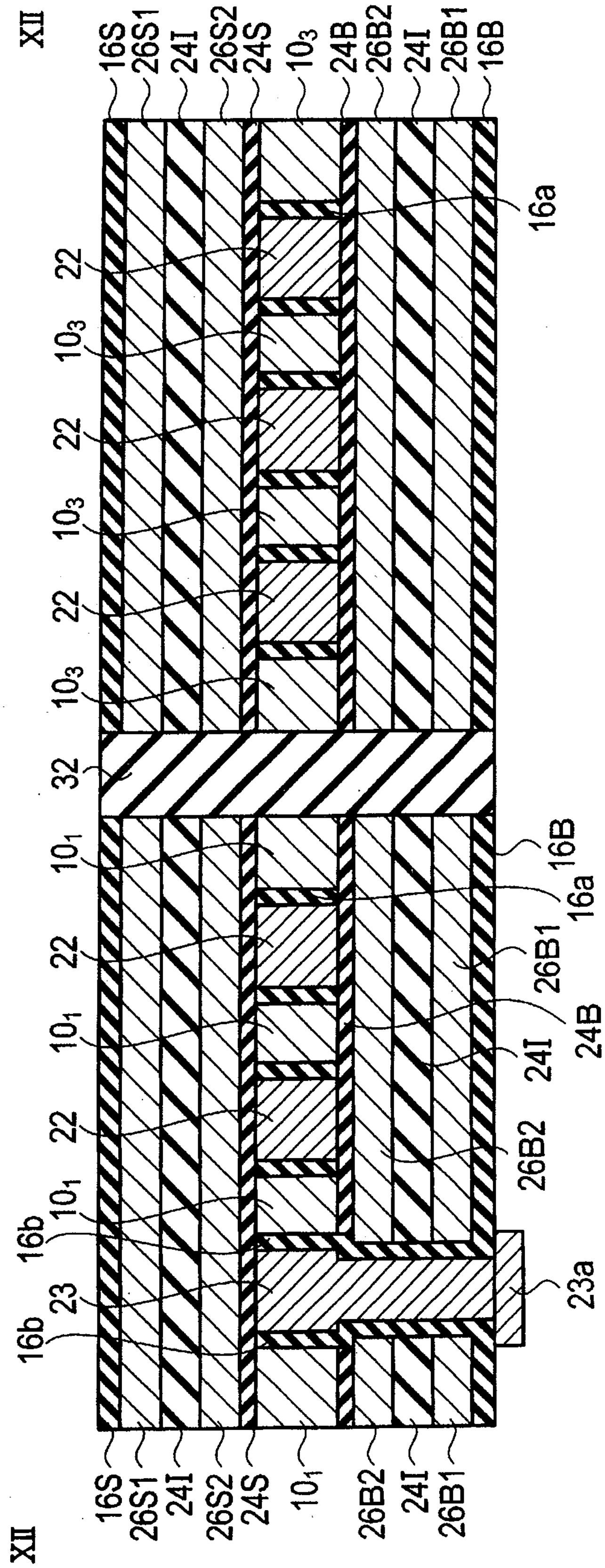
XII
16S
26S1
24I
26S2
24S
$10_3$
24B
26B2
24I
26B1
16B
16a
22
$10_3$
22
$10_3$
22
$10_3$
32
$10_1$
22
$10_1$
22
$10_1$
16b
23
16b
16B
16a
26B1
24B
24I
26B2
23a
16S
26S1
24I
26S2
24S
$10_1$
26B2
24I
26B1
XII

[ 42]

(a) (b)

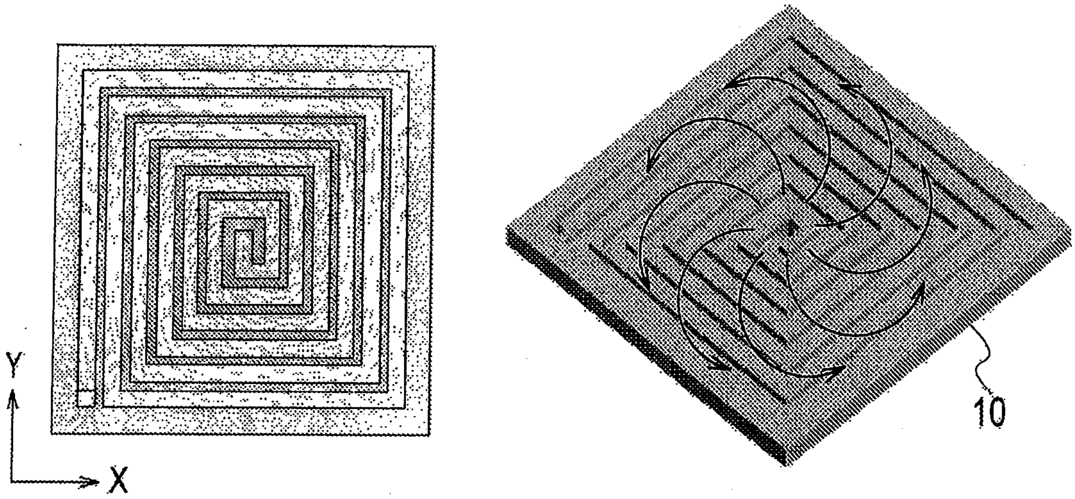


[ 43]

(a) (b)

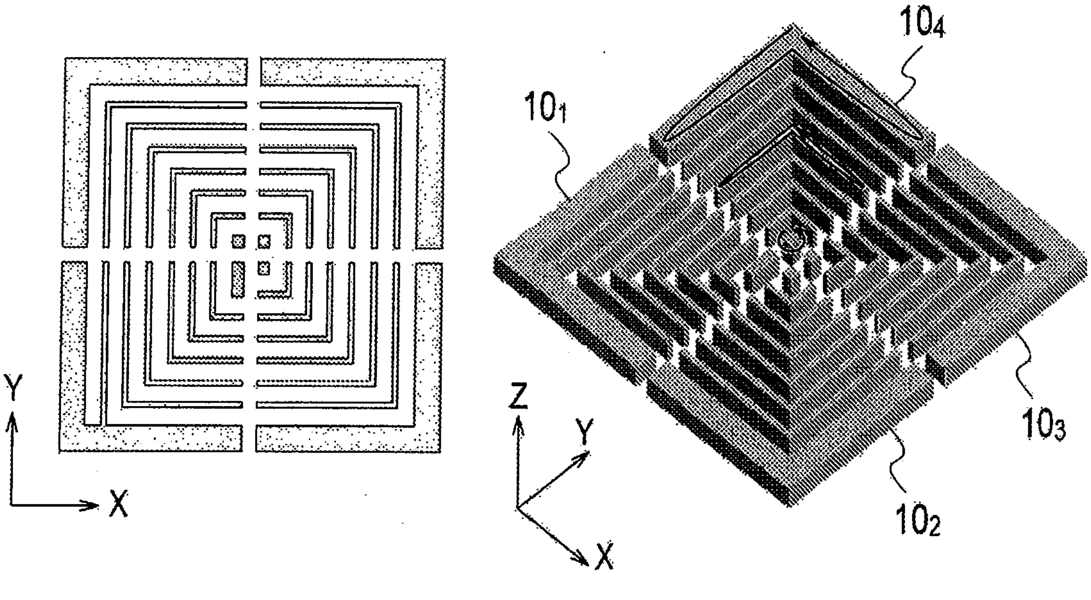

[ 44]

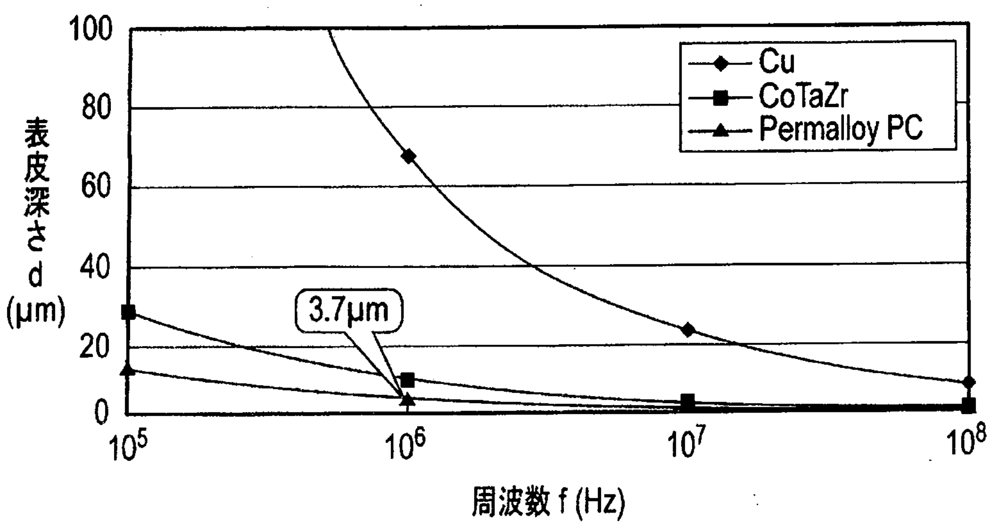
100
80
60
40
20
0
表皮深さ d (µm)
Cu
CoTaZr
Permalloy PC
3.7µm
10^5
10^6
10^7
10^8
周波数 f (Hz)

[ 45]

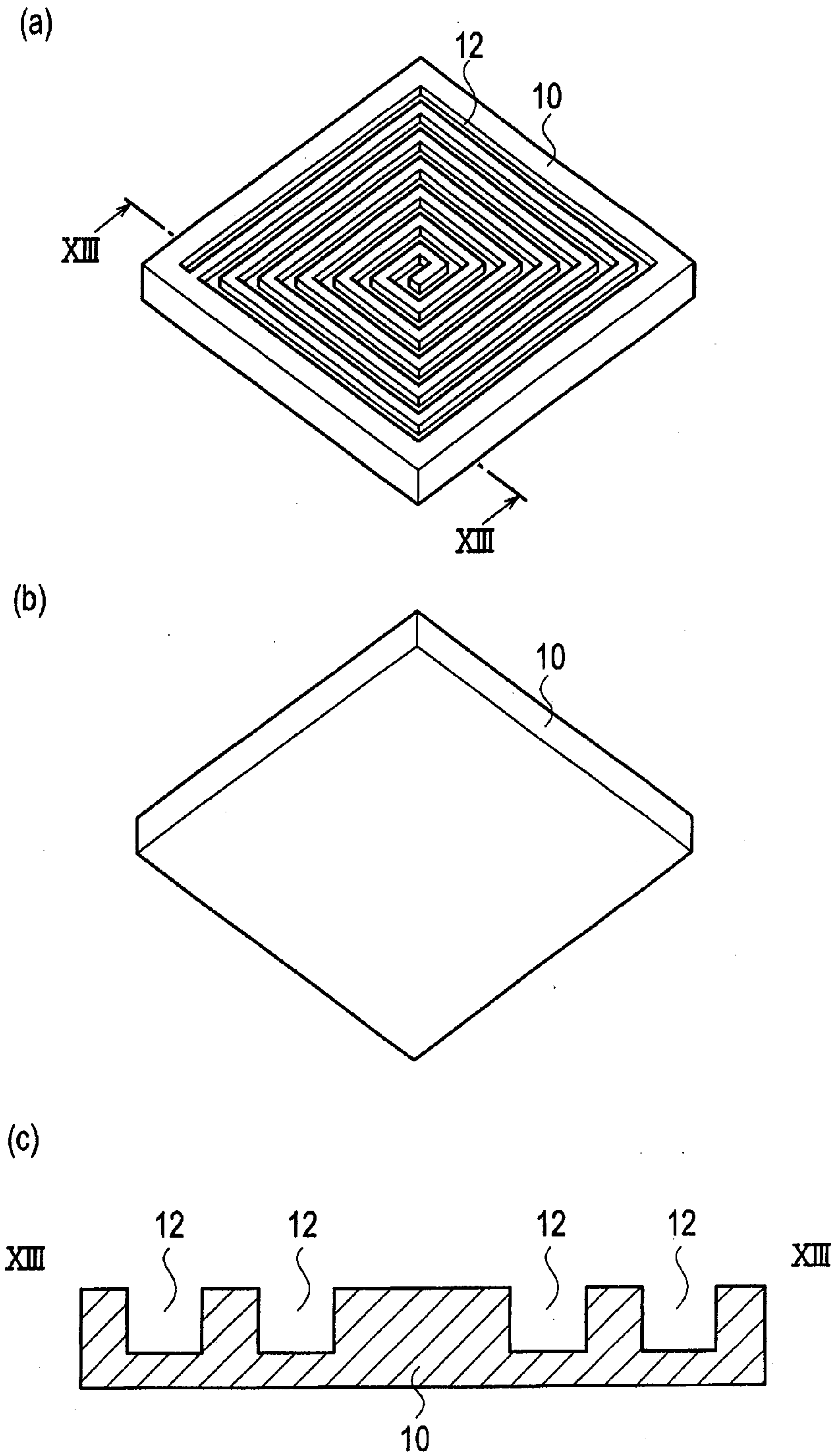

[ 46]

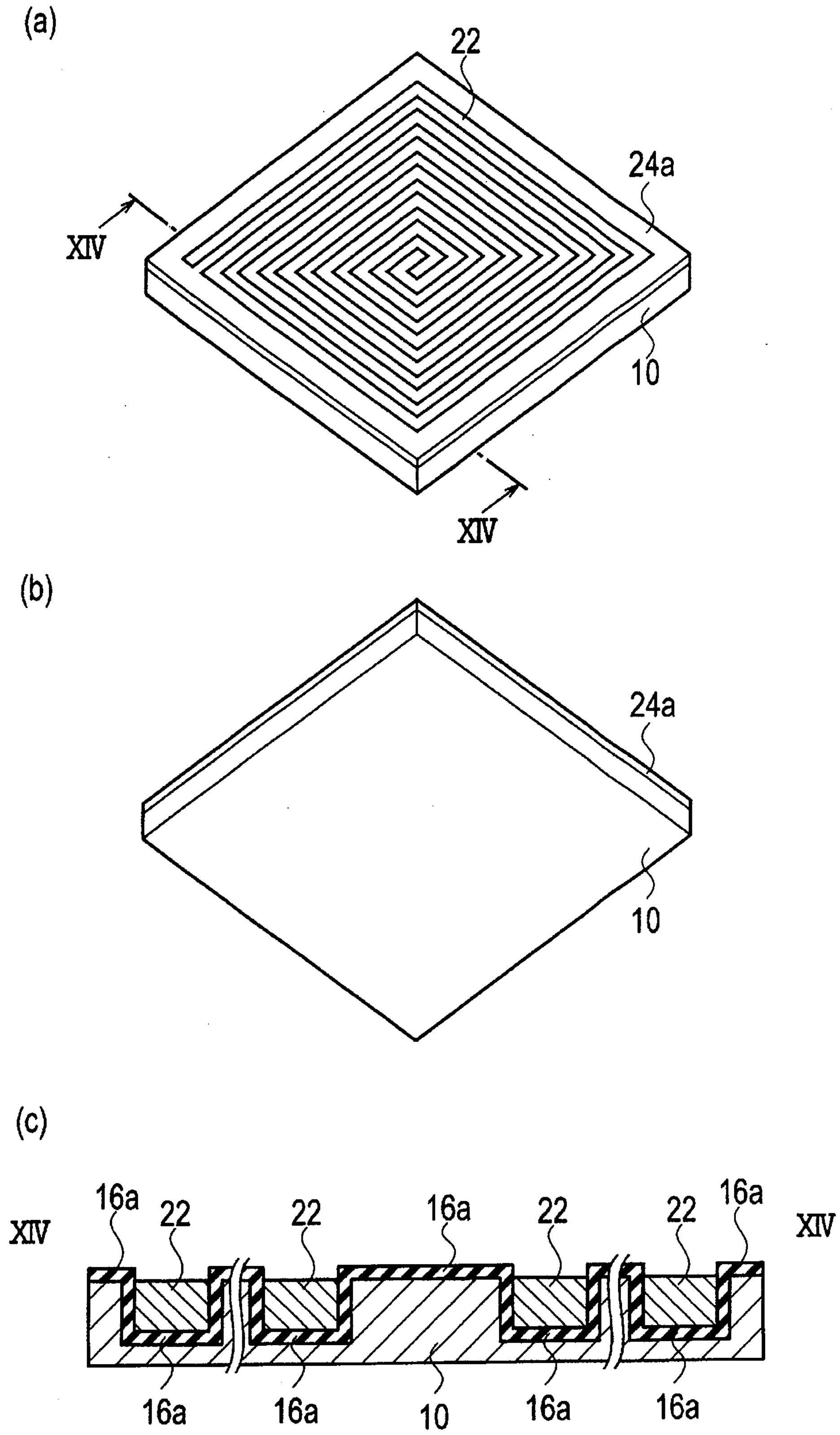
(a)
22
24a
XIV
10
XIV
(b)
24a
10
(c)
XIV
16a
22
22
16a
22
22
16a
XIV
16a
16a
10
16a
16a

[ 47]

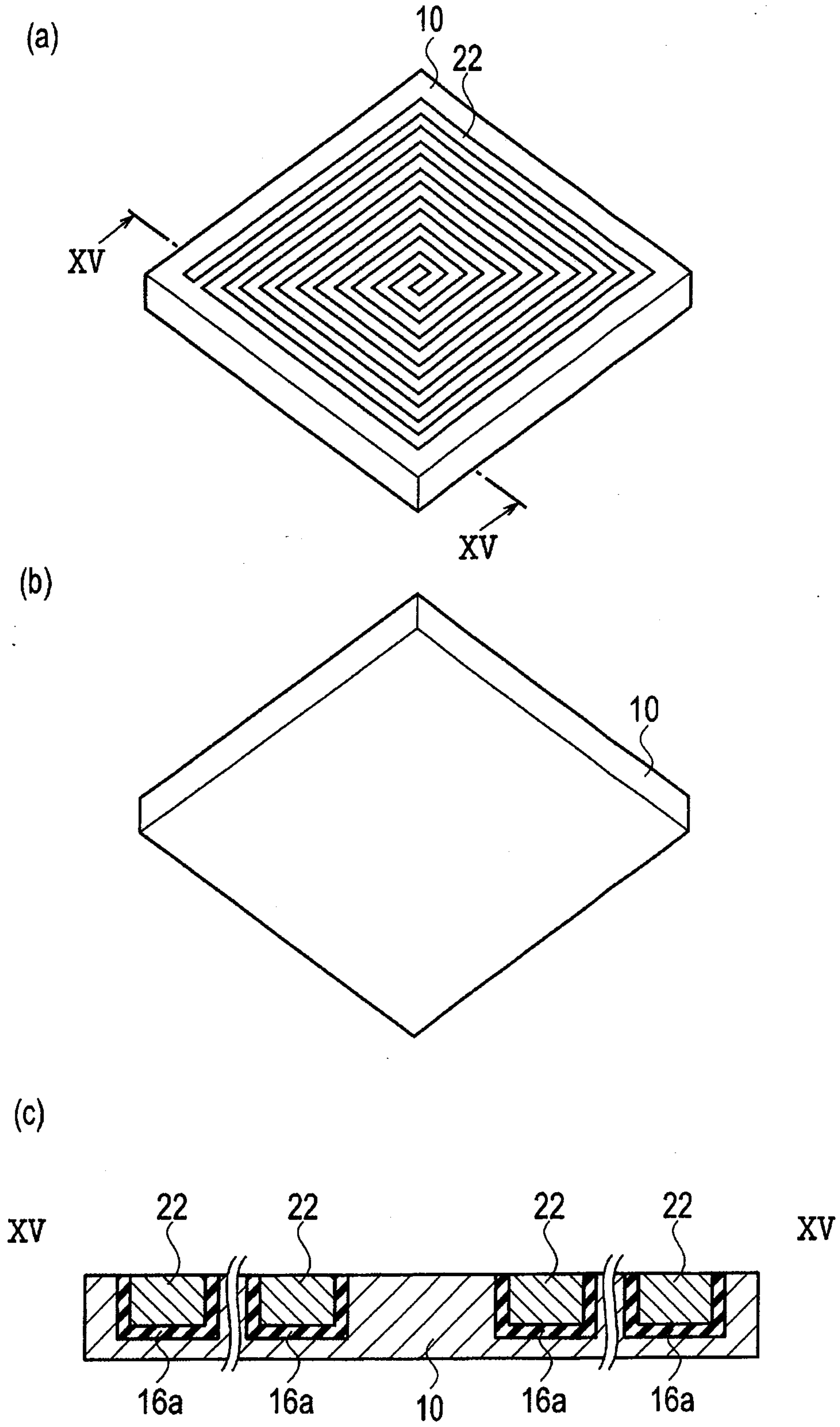

[ 48]

(a)

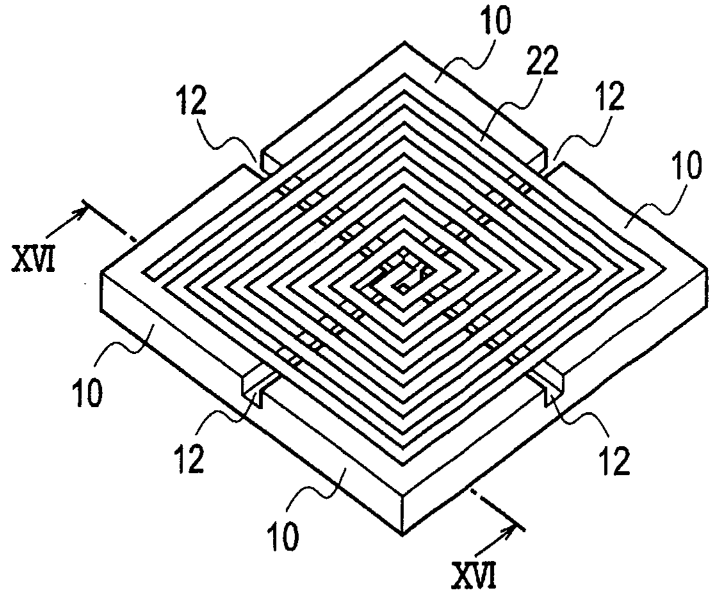
10
22
12
12
10
XVI
10
12
12
10
XVI

(b)

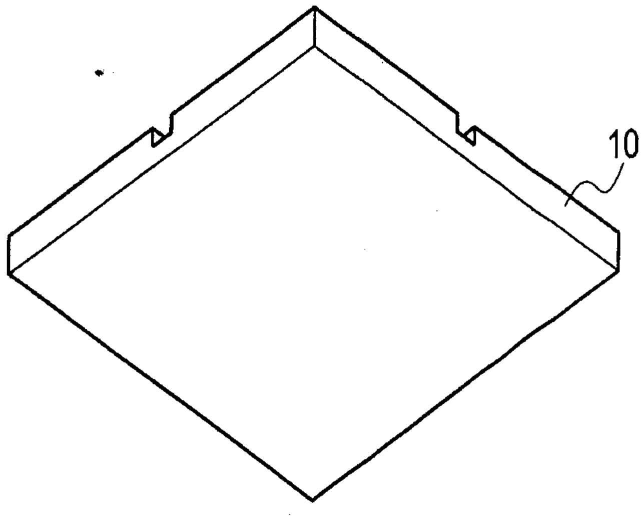
10

(c)

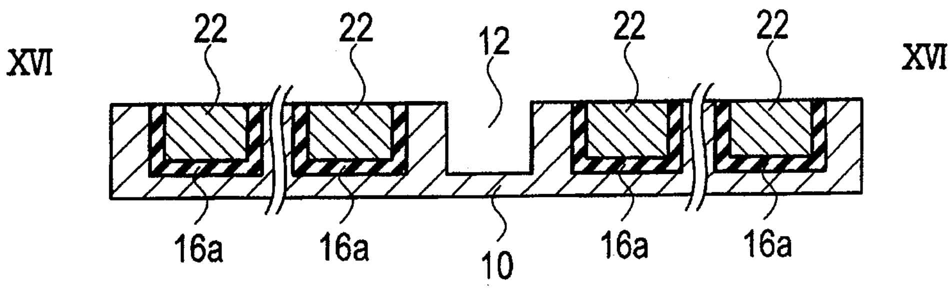
XVI
22
22
12
22
22
XVI
16a
16a
10
16a
16a

[ 49]

(a)

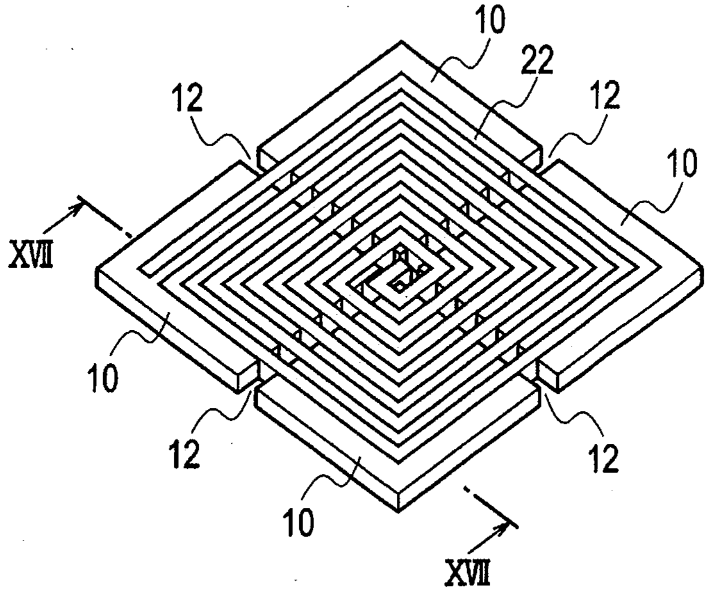
10
22
12
12
10
XVII
10
12
12
10
XVII

(b)

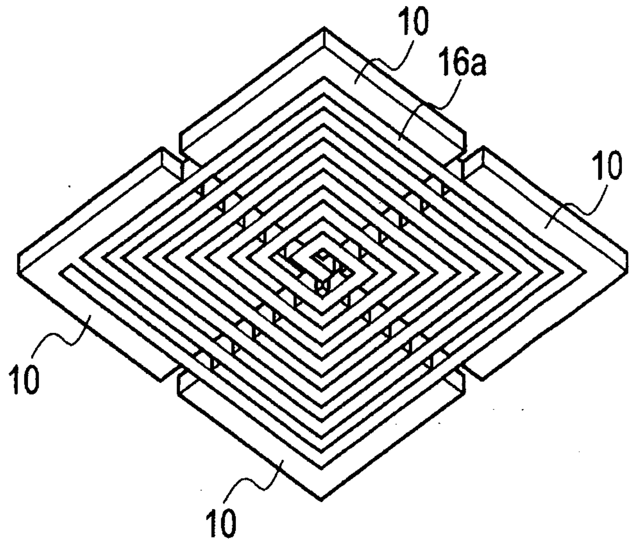
10
16a
10
10
10

(c)

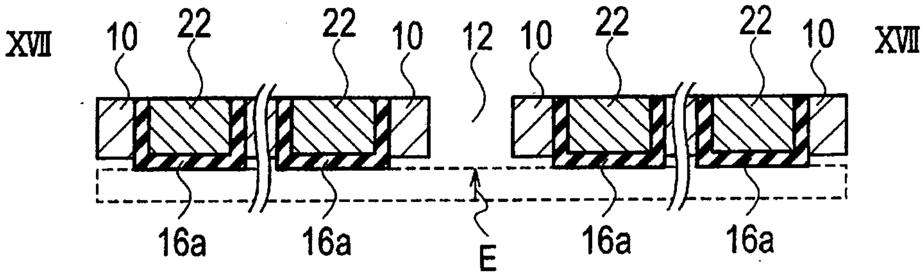
XVII
10
22
22
10
12
10
22
22
10
XVII
16a
16a
E
16a
16a

[ 50]

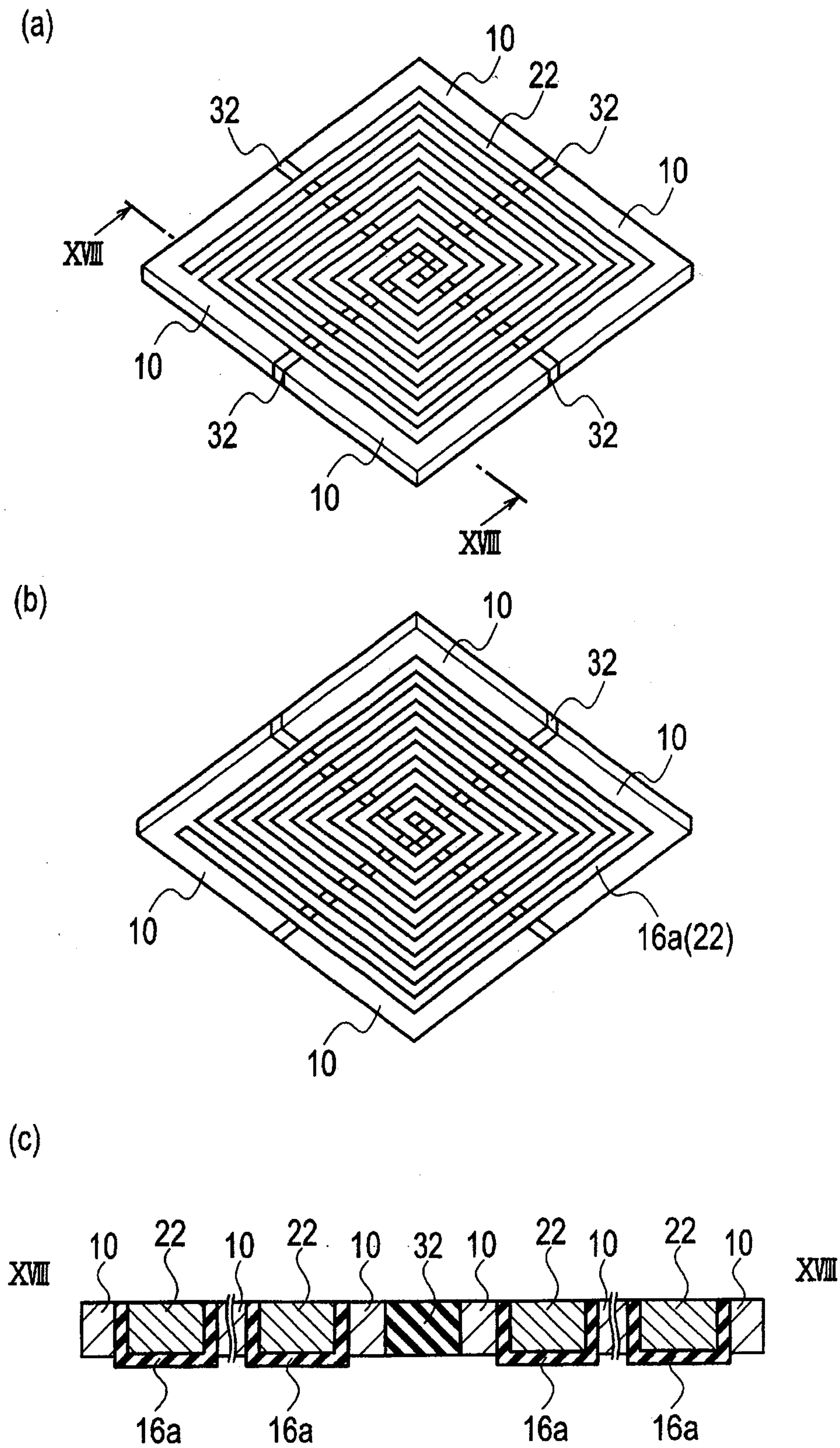
(a)
10
22
32
32
10
XVIII
10
32
32
10
XVIII
(b)
10
32
10
10
16a(22)
10
(c)
XVIII
10
22
10
22
10
32
10
22
10
22
10
XVIII
16a
16a
16a
16a

[ 51]

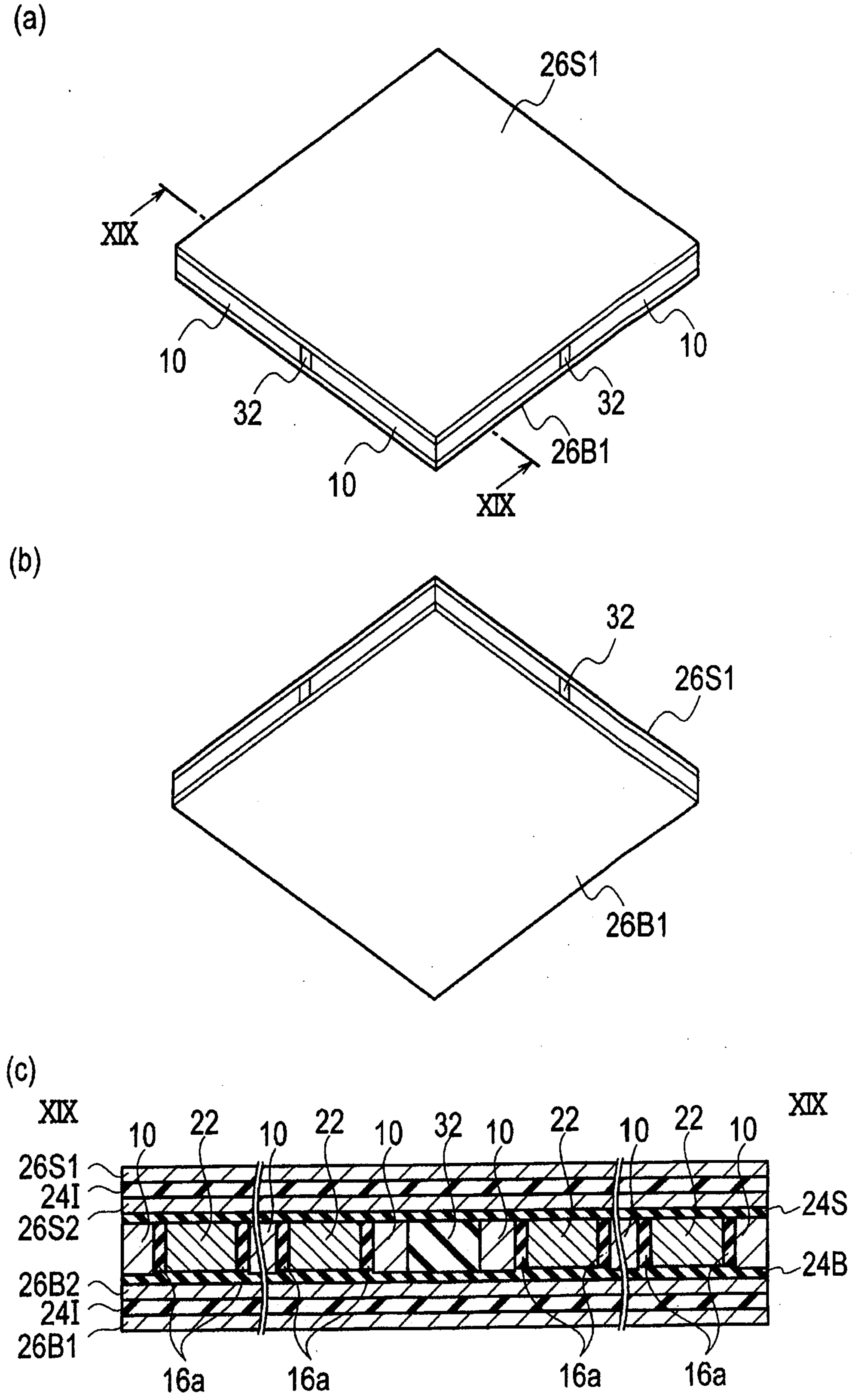
(a)
26S1
XIX
10
10
32
32
26B1
10
XIX
(b)
32
26S1
26B1
(c)
XIX
XIX
10
22
10
22
10
32
10
22
10
22
10
26S1
24I
26S2
24S
24B
26B2
24I
26B1
16a
16a
16a
16a

[ 52]

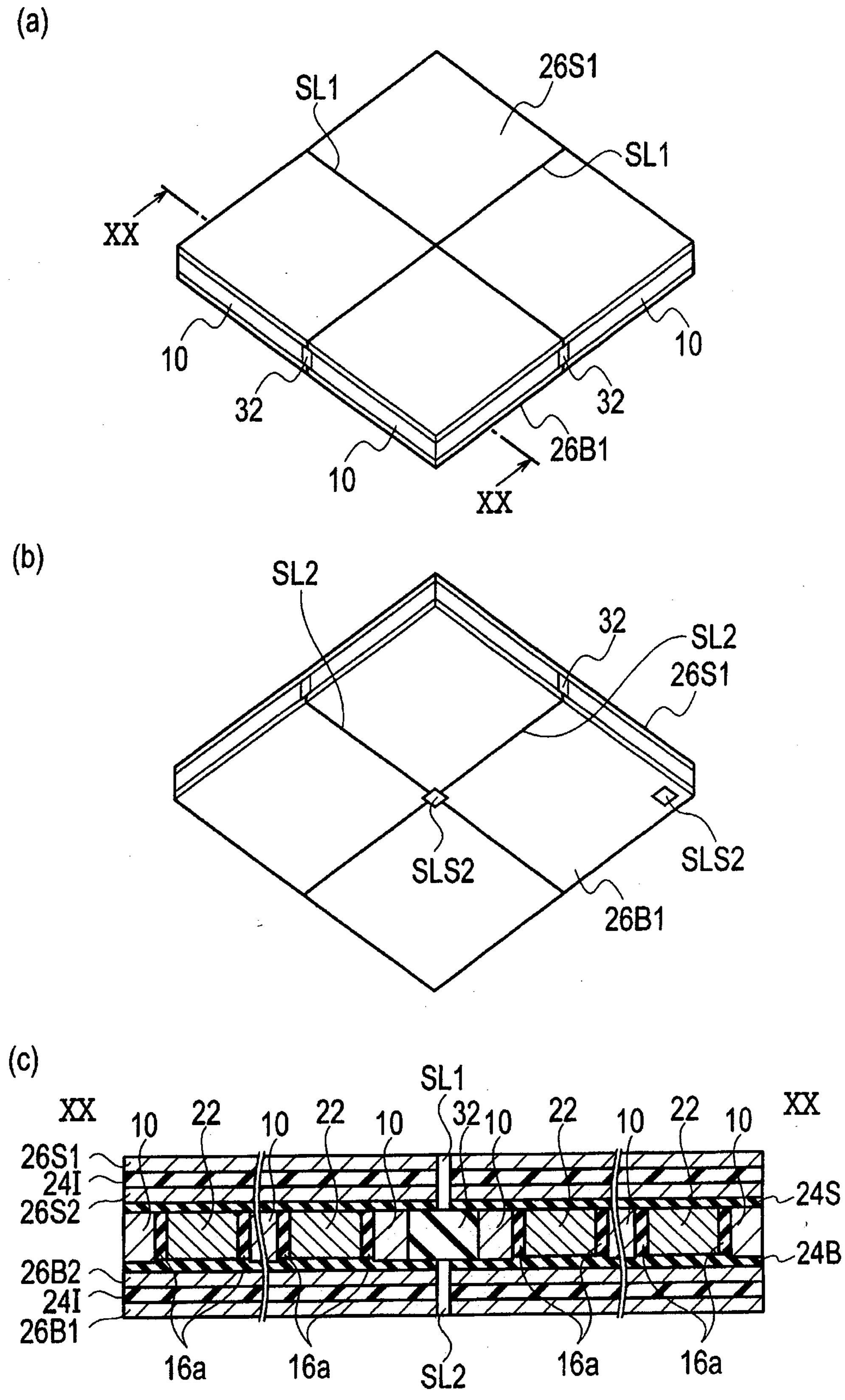
(a)
SL1
26S1
SL1
XX
10
10
32
32
26B1
10
XX
(b)
SL2
32
SL2
26S1
SLS2
SLS2
26B1
(c)
SL1
XX
10
22
10
22
10
32
10
22
10
22
10
XX
26S1
24I
26S2
24S
24B
26B2
24I
26B1
16a
16a
SL2
16a
16a

[ 53]

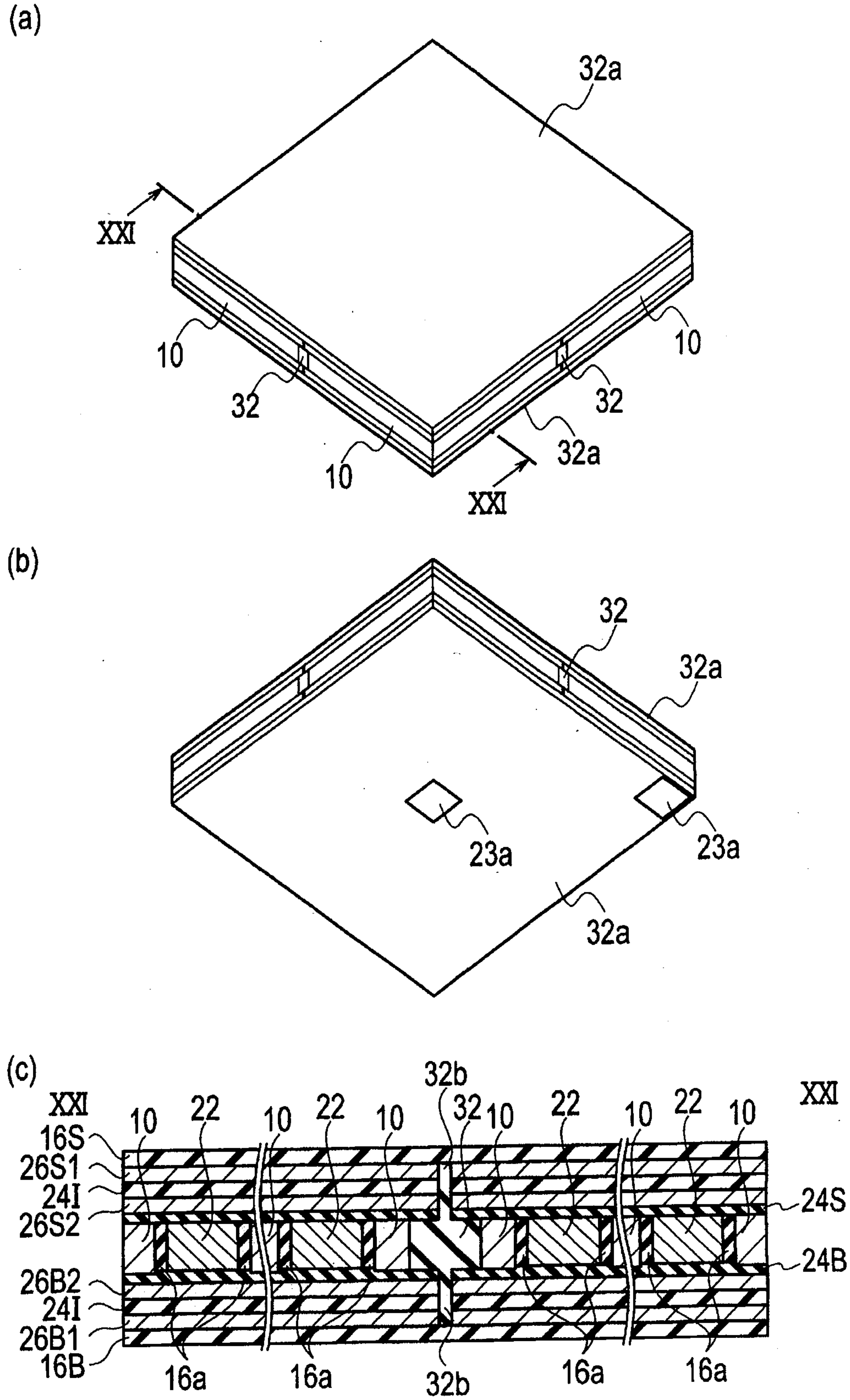
(a)
32a
XXI
10
10
32
32
32a
10
XXI
(b)
32
32a
23a
23a
32a
(c)
XXI
32b
XXI
10
22
10
22
10
32
10
22
10
22
10
16S
26S1
24I
26S2
24S
24B
26B2
24I
26B1
16B
16a
16a
32b
16a
16a

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2004172396 A
- JP 2007214424 A
- JP H09139313 B
- JP H0888119 B
- JP 2009049335 A
- DE 19857849 A1
- EP 1816658 A1
- EP 1942574 A1
- US 2003076211 A1
- EP 0310396 A1
- JP 2008205353 A
- JP 2005150168 A